# EUROPEAN PATENT SPECIFICATION

(11) **EP 4 135 500 B1**
(45) Date of publication and mention of the grant of the patent: **25.11.2026**
(21) Application number: 21796351.1
(22) Date of filing: 12.03.2021
(51) Int. Cl.: H05K 9/00, H04B 1/3888, H04M 1/02

(54) **SHIELDING COVER AND ELECTRONIC DEVICE**
ABSCHIRMABDECKUNG UND ELEKTRONISCHE VORRICHTUNG
COUVERCLE DE BLINDAGE ET DISPOSITIF ÉLECTRONIQUE

(30) Priority: 30.04.2020 CN 202010369019
(43) Date of publication of application: 15.02.2023
(73) Proprietor: Huawei Technologies Co., Ltd., Shenzhen, Guangdong 518129 (CN)
(72) Inventor: XIONG, Lizhi, Shenzhen, Guangdong 518129 (CN); HUANG, Lizhong, Shenzhen, Guangdong 518129 (CN)
(74) Representative: MERH-IP Matias Erny Reichl Hoffmann Patentanwälte PartG mbB
(86) International application number: PCT/CN2021/080419
(87) International publication number: WO 2021/218441

(56) References cited:
- EP-A2- 1 061 789
- WO-A1-2012/105394
- CN-A- 106 102 430
- CN-U- 201 774 795
- CN-U- 202 121 925
- CN-U- 207 531 264
- CN-U- 207 531 264
- CN-Y- 201 336 797
- US-A1- 2008 080 160
- US-A1- 2012 008 302
- US-A1- 2013 250 540
- US-A1- 2017 034 963
- US-A1- 2017 055 340
- US-A1- 2017 181 265
- US-A1- 2018 019 780
- US-A1- 2018 110 164

## Description

### TECHNICAL FIELD

This application relates to the field of electronic devices, and more specifically, to a shielding case and an electronic device.

### BACKGROUND

A relatively large quantity of electronic elements are usually disposed inside an electronic device. To protect the electronic element from interference from an external electromagnetic wave signal, a shielding member may be disposed beside the electronic element, and the shielding member may shield an external interference signal. However, during disposing of the shielding member, a short circuit between the shielding member and the electronic element needs to be avoided. If a short circuit occurs between the shielding member and the electronic element, normal working of the electronic element may be affected. In addition, attention needs to be paid to reducing scratches caused by the electronic element to the shielding member. If the electronic element scratches the shielding member, scraps may be generated. If the scraps fall on an electrical connection position, normal working of the electronic element may be affected.

US2012/008302A1 discloses a shielding assembly comprising a pair of opposite first sidewalls, a pair of opposite second sidewalls, a pair of opposite first covers, a pair of latching portions and a pair of opposite second covers.
CN207531264U discloses a shielding case including a screening cover and at least one partition wall, which is fixed and electrically connected with circuit board.
US2018/019780A1 discloses a mobile terminal comprising a rear case made of metal and forming an exterior of a rear surface of the mobile terminal. the rear case comprises a first slit, a reinforcing member made of a non-conductive material, coupled to a first region of the rear having the first slit.
WO2012/105394A1 discloses an electronic component module provided with a base substrate, electronic components, a conductive divider, and a shield film.
US2017/055340A1 discloses a shielding device for shielding the electromagnetic wave includes a metallic shielding shell mounted on a printed circuit board and at least a metallic bracket removably assembled to the shielding shell for supporting upwardly.
US2017/034963A1 discloses a shield device including a shield cover. The shield device may include a PCB including a solder line and the shield cover formed of a metal material and soldered to the solder line to shield at least one electronic component mounted on the PCB.
US2008/080160A1 discloses an EMI shielding assembly includes a lid or cover, a base member or frame to which the cover is attachable.
US2013/250540A1 discloses a shielding shell including a frame having a ring-shaped bracket with a receiving chamber therein.
US2018/110164A1 discloses a shield cap for protecting an electronic component including a cap member having a ceiling portion, a side wall portion and a partition wall portion, and a conductive film formed on the cap member such that the conductive film is formed to shield electromagnetic waves. Further prior art is disclosed in US 2017/181265A1.

### SUMMARY

The present invention is defined by the independent claims. In the following, parts of the description and drawings referring to examples which do not necessarily comprise all features of the invention as currently claimed are not represented as embodiments of the invention but as examples useful for understanding the embodiments of the invention. Embodiments of this application provides a shielding case and an electronic device, to improve performance of a shielding member.

According to a first aspect, a shielding case is provided, the shielding case is configured to be fastened on a circuit board, and the shielding case includes: a shielding cover, where the shielding cover is disposed in parallel to the circuit board, one or more deformation reinforcement structures are disposed on the shielding cover, and the one or more deformation reinforcement structures include at least one of the following: a semi-piercing deformation reinforcement structure, a drawing deformation reinforcement structure, and a squeezing deformation reinforcement structure; a shielding base, where the shielding base is configured to be fastened on the circuit board; and a shielding wall, where the shielding wall is connected between the shielding cover and the shielding base, the shielding wall surrounds the shielding cover, and the shielding wall is disposed perpendicularly to the shielding cover.

The shielding case may be considered as a housing. The housing may be a layered structure with thickness.

The deformation reinforcement structure may be obtained through plastic deformation in a partial area of the shielding case. A degree of the plastic deformation in the partial area is larger than a degree of plastic deformation in another area.

The semi-piercing deformation reinforcement structure may be obtained by using a semi-piercing deformation forming process.

The drawing deformation reinforcement structure may be obtained by using a drawing deformation forming process.

The squeezing deformation reinforcement structure may be obtained by using a squeezing deformation forming process.

In this application, the deformation reinforcement structure is obtained after plastic deformation of a material. As a deformation amount increases, strength and hardness of the material can be improved. Compared with a common shielding case, a shielding case including the deformation reinforcement structure is generally more difficult to deform. In terms of shielding performance, when the shielding case shields a signal for an electronic element, greater difficulty in deforming the shielding case leads to greater difficulty in coming into contact with the electronic element. Therefore, disposing the deformation reinforcement structure on the shielding case helps improve shielding performance of a shielding member. Disposing one or more deformation reinforcement structures on the shielding cover is not conducive to deformation of the shielding cover toward the circuit board, and helps improve shielding performance of the shielding case. In addition, the shielding wall surrounds the shielding cover, and this helps improve a shielding effect of the shielding case.

Optionally, the shielding wall includes two parallel first shielding edges and two parallel second shielding edges, the first shielding edge is disposed perpendicularly to the second shielding edge, a length of the first shielding edge is greater than a length of the second shielding edge, the one or more squeezing deformation reinforcement structures include a first squeezing deformation reinforcement structure, and the first squeezing deformation reinforcement structure is disposed in parallel to the first shielding edge.

Optionally, the shielding wall includes two parallel first shielding edges and two parallel second shielding edges, the first shielding edge is disposed perpendicularly to the second shielding edge, a length of the first shielding edge is greater than a length of the second shielding edge, the one or more squeezing deformation reinforcement structures include a second squeezing deformation reinforcement structure, and the second squeezing deformation reinforcement structure is disposed in parallel to the second shielding edge.

Optionally, the shielding wall includes two parallel first shielding edges and two parallel second shielding edges, the first shielding edge is disposed perpendicularly to the second shielding edge, a length of the first shielding edge is greater than a length of the second shielding edge, the one or more drawing deformation reinforcement structures include a first squeezing deformation reinforcement structure and a second squeezing deformation reinforcement structure that cross each other, the first squeezing deformation reinforcement structure is disposed in parallel to the first shielding edge, and the second squeezing deformation reinforcement structure is disposed in parallel to the second shielding edge.

Optionally, the shielding wall includes two parallel first shielding edges and two parallel second shielding edges, the first shielding edge is disposed perpendicularly to the second shielding edge, a length of the first shielding edge is greater than a length of the second shielding edge, the one or more squeezing deformation reinforcement structures include a third squeezing deformation reinforcement structure, and the third squeezing deformation reinforcement structure is disposed obliquely relative to the first shielding edge.

Optionally, the shielding wall includes two parallel first shielding edges and two parallel second shielding edges, the first shielding edge is disposed perpendicularly to the second shielding edge, a length of the first shielding edge is greater than a length of the second shielding edge, the one or more squeezing deformation reinforcement structures include a third squeezing deformation reinforcement structure and a fourth squeezing deformation reinforcement structure that cross each other, the third squeezing deformation reinforcement structure and the fourth squeezing deformation reinforcement structure are disposed obliquely relative to the first shielding edge, and an inclination degree of the third squeezing deformation reinforcement structure relative to the first shielding edge is different from an inclination degree of the fourth squeezing deformation reinforcement structure relative to the first shielding edge.

Optionally, the shielding wall includes an annular deformation reinforcement structure.

The annular deformation reinforcement structure may include, for example, an annular semi-piercing deformation reinforcement structure, an annular drawing deformation reinforcement structure, and an annular squeezing deformation reinforcement structure.

The annular semi-piercing deformation reinforcement structure may include a first annular protrusion and a first annular groove corresponding to the first annular protrusion, a maximum cross-sectional width of the first annular protrusion is greater than a minimum cross-sectional width of the first annular groove, and a difference between the maximum cross-sectional width of the first annular protrusion and the minimum cross-sectional width of the first annular groove is less than or equal to twice thickness of the shielding cover.

The annular drawing deformation reinforcement structure may include a second annular protrusion and a second annular groove corresponding to the second annular protrusion, a maximum cross-sectional width of the second annular protrusion is greater than a minimum cross-sectional width of the second annular groove, and a difference between the maximum cross-sectional width of the second annular protrusion and the minimum cross-sectional width of the second annular groove is less than or equal to twice the thickness of the shielding cover.

A shape of the annular squeezing deformation reinforcement structure may be an annular groove, and thickness of the shielding cover at the squeezing deformation reinforcement structure may be less than average thickness of the shielding cover.

With reference to the first aspect, the semi-piercing deformation reinforcement structure includes a first protrusion and a first groove corresponding to the first protrusion, a maximum cross-sectional width of the first protrusion is greater than a minimum cross-sectional width of the first groove, and a difference between the maximum cross-sectional width of the first protrusion and the minimum cross-sectional width of the first groove is less than twice the thickness of the shielding cover. A center surface of the first groove is aligned with a center surface of the first protrusion, wherein the first protrusion is formed on the side of the shielding case substrate that is away from the circuit board and the first groove is formed on the side of the shielding case substrate that is close to the circuit board.

Optionally, the first protrusion is further away from the circuit board than the first groove.

Optionally, the first protrusion is further away from the circuit board than the first groove.

In this application, in the semi-piercing deformation forming process, a gap between a lower forming block and a forming punch is relatively small, so that a material is deformed under relatively large action force. Therefore, a deformation resistance capability of the shielding case is improved, and further, shielding performance of the shielding case is improved.

With reference to the first aspect, the drawing deformation reinforcement structure includes a second protrusion and a second groove corresponding to the second protrusion, a maximum cross-sectional width of the second protrusion is greater than a minimum cross-sectional width of the second groove, and a difference between the maximum cross-sectional width of the second protrusion and the minimum cross-sectional width of the second groove is greater than or equal to twice the thickness of the shielding cover. A center surface of the second groove is aligned with a center surface of the second protrusion, wherein the second protrusion is formed on the side of the shielding case substrate that is away from the circuit board and the second groove is formed on the side of the shielding case substrate that is close to the circuit board.

Optionally, the second protrusion is further away from the circuit board than the second groove.

Optionally, the second protrusion is closer to the circuit board than the second groove.

In this application, in the semi-piercing deformation forming process, a gap between a lower forming block and a forming punch is relatively large, so that it is easier to deform a material to a relatively large extent. When a deformation amount is relatively large, a deformation resistance capability of the shielding case is improved, and further, shielding performance of the shielding case is improved.

With reference to the first aspect, a shape of the squeezing deformation reinforcement structure is a groove, and wherein the groove is formed on the side of the shielding case substrate that is away from the circuit board or on the side of the shielding case substrate that is close to the circuit board resulting in the thickness of the shielding cover at the squeezing deformation reinforcement structure is less than average thickness of the shielding cover.

In this application, the squeezing deformation reinforcement structure generally does not affect a spacing between the shielding case and another component, and helps arrange the shielding case on a circuit board assembly.

With reference to the first aspect, in some implementations of the first aspect, the shielding case further includes: a shielding inner wall, where the shielding inner wall is located on a side that is of the shielding cover and that is close to the circuit board, the shielding inner wall is disposed perpendicularly to the shielding cover, one end of the shielding inner wall is fastened on the shielding case, and the other end of the shielding inner wall is used to be fastened on the circuit board.

In this application, the shielding inner wall is disposed on the shielding case, so that the shielding inner wall may have an effect of supporting the shielding cover, and this helps reduce a deformation amount of the shielding case under external force, and helps improve shielding performance of the shielding case.

With reference to the first aspect, in some implementations of the first aspect, a material of the shielding inner wall includes: a shielding inner wall substrate; a third nickel-plated layer, where the third nickel-plated layer wraps a side that is of the shielding inner wall substrate and that is close to the shielding case; a fourth nickel-plated layer, where the fourth nickel-plated layer wraps a side that is of the shielding inner wall substrate and that is away from the shielding case; a second soldering layer, where the second soldering layer wraps the third nickel-plated layer, the fourth nickel-plated layer, and a shielding case substrate, an area that is of the third nickel-plated layer and that is wrapped by the second soldering layer is a fourth partial area, an area that is of the fourth nickel-plated layer and that is wrapped by the second soldering layer is a fifth partial area, and an area that is of the shielding case substrate and that is wrapped by the first soldering layer is located between the fourth partial area and the fifth partial area; and a second insulation layer, where the second insulation layer is located on a side that is of the fourth nickel-plated layer and that is away from the shielding inner wall substrate, the second insulation layer is pasted on a sixth partial area of the fourth nickel-plated layer, and the sixth partial area is not connected to the fifth partial area.

In this application, if an insulation layer is placed on a soldering layer, there may be a problem that a surface bonding effect between the soldering layer and the insulation layer is relatively poor. In a possible scenario, the shielding case may be soldered on the circuit board by using a surface mounted technology (surface mounted technology, SMT). However, in the SMT, during soldering, heating temperature is relatively high, and a tin material may be melted, and is therefore gathered in the insulation layer. Finally, problems such as bulging and falling off may occur in the insulation layer. In this application, the insulation layer is not connected to or in contact with the soldering layer, and this helps reduce a possibility of failure of the insulation layer, and may further help improve shielding performance of the shielding inner wall. In addition, that the insulation layer is not connected to or in contact with the soldering layer further helps reduce a material of the soldering layer on the shielding inner wall.

With reference to the first aspect, the shielding case is configured to be fastened on the circuit board, and a material of the shielding case includes: a shielding case substrate; a first nickel-plated layer, where the first nickel-plated layer wraps a side that is of the shielding case substrate and that is close to the circuit board; a second nickel-plated layer, where the second nickel-plated layer wraps a side that is of the shielding case substrate and that is away from the circuit board; a first insulation layer, where the first insulation layer is located on a side that is of the first nickel-plated layer and that is away from the shielding case substrate, and the first insulation layer is pasted on a first partial area of the first nickel-plated layer; and a first soldering layer, where the first soldering layer is configured to fasten the shielding case on the circuit board through soldering, the first soldering layer is located on a side that is of the first nickel-plated layer and that is away from the shielding case substrate, the first soldering layer wraps a second partial area of the first nickel-plated layer, and the second partial the area is not connected to the first partial area.

A material of the shielding case substrate may be, for example, aluminum alloy or stainless steel.

Optionally, the first soldering layer and the first insulation layer separately wrap different areas of the first nickel-plated layer.

Optionally, an area that is of the first nickel-plated layer and that is wrapped by the first soldering layer and an area that is of the first nickel-plated layer and that is wrapped by the first insulation layer do not cross each other or are different from each other.

In this application, if an insulation layer is placed on a soldering layer, there may be a problem that a surface bonding effect between the soldering layer and the insulation layer is relatively poor. For example, the insulation layer may bulge or fall off. In this application, the insulation layer is not connected to or in contact with the soldering layer, and this helps reduce a possibility of failure of the insulation layer, and may further help improve shielding performance of the shielding member. In addition, that the insulation layer is not connected to or in contact with the soldering layer further helps reduce a material of the soldering layer on the shielding case.

With reference to the first aspect, in some implementations of the first aspect, the first soldering layer further wraps the second nickel-plated layer and the shielding case substrate, an area that is of the second nickel-plated layer and that is wrapped by the first soldering layer is a third partial area, and an area that is of the shielding case substrate and that is wrapped by the first soldering layer is located between the second partial area and the third partial area.

In this application, the soldering layer is wrapped at a part that is of the shielding case and that needs to be soldered, so that a shape of an end that is of the shielding case and that is used to be fastened on the circuit board may be relatively flexible.

According to a second aspect, a shielding case is provided, the shielding case is configured to be fastened on a circuit board, and the shielding case includes: a shielding cover, where the shielding cover is disposed in parallel to the circuit board, one or more deformation reinforcement structures are disposed on the shielding cover, and the one or more deformation reinforcement structures include at least one of the following: a semi-piercing deformation reinforcement structure, a drawing deformation reinforcement structure, and a squeezing deformation reinforcement structure; and a plurality of shielding outer walls, where one end of the shielding outer wall is used to be fastened on the circuit board, the other end of the shielding outer wall is connected to the shielding cover, the shielding outer wall is disposed perpendicularly to the circuit board, the plurality of shielding outer walls are disposed around the shielding cover, and there is a partition between two adjacent shielding outer walls.

In this application, the deformation reinforcement structure is obtained after plastic deformation of a material. As a deformation amount increases, strength and hardness of the material can be improved. Compared with a common shielding case, a shielding case including the deformation reinforcement structure is generally more difficult to deform. In terms of shielding performance, when the shielding case shields a signal for an electronic element, greater difficulty in deforming the shielding case leads to greater difficulty in coming into contact with the electronic element. Therefore, disposing the deformation reinforcement structure on the shielding case helps improve shielding performance of a shielding member. In addition, the partition between the shielding outer walls may help simplify a forming process of the shielding case, and also helps maintain material integrity on the shielding case, so that shielding performance of the shielding case is improved. Disposing one or more deformation reinforcement structures on the shielding cover is not conducive to deformation of the shielding cover toward the circuit board, and helps improve shielding performance of the shielding case.

With reference to the second aspect, the semi-piercing deformation reinforcement structure includes a first protrusion and a first groove corresponding to the first protrusion, a maximum cross-sectional width of the first protrusion is greater than a minimum cross-sectional width of the first groove, and a difference between the maximum cross-sectional width of the first protrusion and the minimum cross-sectional width of the first groove is less than twice thickness of the shielding cover. A center surface of the first groove is aligned with a center surface of the first protrusion, wherein the first protrusion is formed on the side of the shielding case substrate that is away from the circuit board and the first groove is formed on the side of the shielding case substrate that is close to the circuit board.

With reference to the second aspect, the drawing deformation reinforcement structure includes a second protrusion and a second groove corresponding to the second protrusion, a maximum cross-sectional width of the second protrusion is greater than a minimum cross-sectional width of the second groove, and a difference between the maximum cross-sectional width of the second protrusion and the minimum cross-sectional width of the second groove is greater than or equal to twice the thickness of the shielding cover. cover. A center surface of the second groove is aligned with a center surface of the second protrusion, wherein the second protrusion is formed on the side of the shielding case substrate that is away from the circuit board and the second groove is formed on the side of the shielding case substrate that is close to the circuit board.

With reference to the second aspect, a shape of the squeezing deformation reinforcement structure is a groove, and wherein the groove is formed on the side of the shielding case substrate that is away from the circuit board or on the side of the shielding case substrate that is close to the circuit board resulting in the thickness of the shielding cover at the squeezing deformation reinforcement structure is less than average thickness of the shielding cover.

With reference to the second aspect, in some implementations of the second aspect, the shielding case further includes: a shielding inner wall, where the shielding inner wall is located on a side that is of the shielding cover and that is close to the circuit board, the shielding inner wall is disposed perpendicularly to the shielding cover, one end of the shielding inner wall is fastened on the shielding case, and the other end of the shielding inner wall is used to be fastened on the circuit board.

With reference to the second aspect, a material of the shielding inner wall includes: a shielding inner wall substrate; a third nickel-plated layer, where the third nickel-plated layer wraps a side that is of the shielding inner wall substrate and that is close to the shielding case; a fourth nickel-plated layer, where the fourth nickel-plated layer wraps a side that is of the shielding inner wall substrate and that is away from the shielding case; a second soldering layer, where the second soldering layer wraps the third nickel-plated layer, the fourth nickel-plated layer, and a shielding case substrate, an area that is of the third nickel-plated layer and that is wrapped by the second soldering layer is a fourth partial area, an area that is of the fourth nickel-plated layer and that is wrapped by the second soldering layer is a fifth partial area, and an area that is of the shielding case substrate and that is wrapped by the first soldering layer is located between the fourth partial area and the fifth partial area; and a second insulation layer, where the second insulation layer is located on a side that is of the fourth nickel-plated layer and that is away from the shielding inner wall substrate, the second insulation layer is pasted on a sixth partial area of the fourth nickel-plated layer, and the sixth partial area is not connected to the fifth partial area.

With reference to the second aspect, the shielding case is configured to be fastened on the circuit board, and a material of the shielding case includes: a shielding case substrate; a first nickel-plated layer, where the first nickel-plated layer wraps a side that is of the shielding case substrate and that is close to the circuit board; a second nickel-plated layer, where the second nickel-plated layer wraps a side that is of the shielding case substrate and that is away from the circuit board; a first insulation layer, where the first insulation layer is located on a side that is of the first nickel-plated layer and that is away from the shielding case substrate, and the first insulation layer is pasted on a first partial area of the first nickel-plated layer; and a first soldering layer, where the first soldering layer is configured to fasten the shielding case on the circuit board through soldering, the first soldering layer is located on a side that is of the first nickel-plated layer and that is away from the shielding case substrate, the first soldering layer wraps a second partial area of the first nickel-plated layer, and the second partial the area is not connected to the first partial area.

With reference to the second aspect, in some implementations of the second aspect, the first soldering layer further wraps the second nickel-plated layer and the shielding case substrate, an area that is of the second nickel-plated layer and that is wrapped by the first soldering layer is a third partial area, and an area that is of the shielding case substrate and that is wrapped by the first soldering layer is located between the second partial area and the third partial area.

According to a third aspect, a shielding case is provided, the shielding case is configured to be fastened on a circuit board, and the shielding case includes: a shielding frame, where the shielding frame is disposed in parallel to the circuit board; a separable shielding cover, where the separable shielding cover is disposed on the shielding frame, an edge of the separable shielding cover surrounds an area surrounded by the shielding frame, the separable shielding cover is disposed in parallel to the circuit board, one or more deformation reinforcement structures are disposed on the separable shielding cover, and the one or more deformation reinforcement structures include at least one of the following: a semi-piercing deformation reinforcement structure, a drawing deformation reinforcement structure, and a squeezing deformation reinforcement structure; a shielding base, where the shielding base is configured to be fastened on the circuit board; and a shielding wall, where the shielding wall is connected between the shielding frame and the shielding base, the shielding wall surrounds the shielding frame, and the shielding wall is disposed perpendicularly to the separable shielding cover.

In this application, the deformation reinforcement structure is obtained after plastic deformation of a material. As a deformation amount increases, strength and hardness of the material can be improved. Compared with a common shielding case, a shielding case including the deformation reinforcement structure is generally more difficult to deform. In terms of shielding performance, when the shielding case shields a signal for an electronic element, greater difficulty in deforming the shielding case leads to greater difficulty in coming into contact with the electronic element. Therefore, disposing the deformation reinforcement structure on the shielding case helps improve shielding performance of a shielding member. In addition, the separable shielding cover may be separated from the shielding frame, so that the electronic element in the shielding case is visible, and maintenance manners of the shielding case, a circuit board assembly, and an electronic device are simplified. Disposing one or more deformation reinforcement structures on the separable shielding cover is not conducive to deformation of the separable shielding cover toward the circuit board, and helps improve shielding performance of the shielding case.

With reference to the third aspect, the semi-piercing deformation reinforcement structure includes a first protrusion and a first groove corresponding to the first protrusion, a maximum cross-sectional width of the first protrusion is greater than a minimum cross-sectional width of the first groove, and a difference between the maximum cross-sectional width of the first protrusion and the minimum cross-sectional width of the first groove is less than twice thickness of the separable shielding cover. A center surface of the first groove is aligned with a center surface of the first protrusion, wherein the first protrusion is formed on the side of the shielding case substrate that is away from the circuit board and the first groove is formed on the side of the shielding case substrate that is close to the circuit board.

With reference to the third aspect, the drawing deformation reinforcement structure includes a second protrusion and a second groove corresponding to the second protrusion, a maximum cross-sectional width of the second protrusion is greater than a minimum cross-sectional width of the second groove, and a difference between the maximum cross-sectional width of the second protrusion and the minimum cross-sectional width of the second groove is greater than or equal to twice the thickness of the separable shielding cover. A center surface of the second groove is aligned with a center surface of the second protrusion, wherein the second protrusion is formed on the side of the shielding case substrate that is away from the circuit board and the second groove is formed on the side of the shielding case substrate that is close to the circuit board.

With reference to the third aspect, a shape of the squeezing deformation reinforcement structure is a groove, and wherein the groove is formed on the side of the shielding case substrate that is away from the circuit board or on the side of the shielding case substrate that is close to the circuit board resulting in the thickness of the separable shielding cover at the squeezing deformation reinforcement structure is less than average thickness of the separable shielding cover.

With reference to the third aspect, in some implementations of the third aspect, the shielding case further includes: a shielding inner wall, where the shielding inner wall is located on a side that is of the shielding cover and that is close to the circuit board, the shielding inner wall is disposed perpendicularly to the shielding cover, one end of the shielding inner wall is fastened on the shielding case, and the other end of the shielding inner wall is used to be fastened on the circuit board.

With reference to the third aspect, a material of the shielding inner wall includes: a shielding inner wall substrate; a third nickel-plated layer, where the third nickel-plated layer wraps a side that is of the shielding inner wall substrate and that is close to the shielding case; a fourth nickel-plated layer, where the fourth nickel-plated layer wraps a side that is of the shielding inner wall substrate and that is away from the shielding case; a second soldering layer, where the second soldering layer wraps the third nickel-plated layer, the fourth nickel-plated layer, and a shielding case substrate, an area that is of the third nickel-plated layer and that is wrapped by the second soldering layer is a fourth partial area, an area that is of the fourth nickel-plated layer and that is wrapped by the second soldering layer is a fifth partial area, and an area that is of the shielding case substrate and that is wrapped by the first soldering layer is located between the fourth partial area and the fifth partial area; and a second insulation layer, where the second insulation layer is located on a side that is of the fourth nickel-plated layer and that is away from the shielding inner wall substrate, the second insulation layer is pasted on a sixth partial area of the fourth nickel-plated layer, and the sixth partial area is not connected to the fifth partial area.

With reference to the third aspect, the shielding case is configured to be fastened on the circuit board, and a material of the shielding case includes: a shielding case substrate; a first nickel-plated layer, where the first nickel-plated layer wraps a side that is of the shielding case substrate and that is close to the circuit board; a second nickel-plated layer, where the second nickel-plated layer wraps a side that is of the shielding case substrate and that is away from the circuit board; a first insulation layer, where the first insulation layer is located on a side that is of the first nickel-plated layer and that is away from the shielding case substrate, and the first insulation layer is pasted on a first partial area of the first nickel-plated layer; and a first soldering layer, where the first soldering layer is configured to fasten the shielding case on the circuit board through soldering, the first soldering layer is located on a side that is of the first nickel-plated layer and that is away from the shielding case substrate, the first soldering layer wraps a second partial area of the first nickel-plated layer, and the second partial the area is not connected to the first partial area.

With reference to the third aspect, in some implementations of the third aspect, the first soldering layer further wraps the second nickel-plated layer and the shielding case substrate, an area that is of the second nickel-plated layer and that is wrapped by the first soldering layer is a third partial area, and an area that is of the shielding case substrate and that is wrapped by the first soldering layer is located between the second partial area and the third partial area.

According to a fourth aspect, a shielding case is provided, the shielding case is configured to be fastened on a circuit board, and the shielding case includes: a shielding frame, where the shielding frame is disposed in parallel to the circuit board, the shielding frame includes a shielding strip, the shielding strip is located in an area surrounded by the shielding frame, one or more deformation reinforcement structures are disposed on the shielding strip, and the one or more deformation reinforcement structures include at least one of the following: a semi-piercing deformation reinforcement structure, a drawing deformation reinforcement structure, and a squeezing deformation reinforcement structure; a shielding base, where the shielding base is configured to be fastened on the circuit board; a separable shielding cover, where the separable shielding cover is disposed on the shielding frame, an edge of the separable shielding cover surrounds the area surrounded by the shielding frame, and the separable shielding cover is disposed in parallel to the circuit board; and a shielding wall, where the shielding wall is connected between the shielding frame and the shielding base, the shielding wall surrounds the shielding frame, and the shielding wall is disposed perpendicularly to the separable shielding cover.

In this application, the deformation reinforcement structure is obtained after plastic deformation of a material. As a deformation amount increases, strength and hardness of the material can be improved. Compared with a common shielding case, a shielding case including the deformation reinforcement structure is generally more difficult to deform. In terms of shielding performance, when the shielding case shields a signal for an electronic element, greater difficulty in deforming the shielding case leads to greater difficulty in coming into contact with the electronic element. Therefore, disposing the deformation reinforcement structure on the shielding case helps improve shielding performance of a shielding member. In addition, the separable shielding cover may be separated from the shielding frame, so that the electronic element in the shielding case is visible, and maintenance manners of the shielding case, a circuit board assembly, and an electronic device are simplified. Disposing one or more deformation reinforcement structures on the shielding strip of the shielding frame is not conducive to deformation of the shielding strip and the shielding frame toward the circuit board, and helps improve shielding performance of the shielding case.

With reference to the fourth aspect, the semi-piercing deformation reinforcement structure includes a first protrusion and a first groove corresponding to the first protrusion, a maximum cross-sectional width of the first protrusion is greater than a minimum cross-sectional width of the first groove, and a difference between the maximum cross-sectional width of the first protrusion and the minimum cross-sectional width of the first groove is less than twice thickness of the shielding strip. A center surface of the first groove is aligned with a center surface of the first protrusion, wherein the first protrusion is formed on the side of the shielding case substrate that is away from the circuit board and the first groove is formed on the side of the shielding case substrate that is close to the circuit board.

With reference to the fourth aspect, the drawing deformation reinforcement structure includes a second protrusion and a second groove corresponding to the second protrusion, a maximum cross-sectional width of the second protrusion is greater than a minimum cross-sectional width of the second groove, and a difference between the maximum cross-sectional width of the second protrusion and the minimum cross-sectional width of the second groove is greater than or equal to twice the thickness of the shielding strip. A center surface of the second groove is aligned with a center surface of the second protrusion, wherein the second protrusion is formed on the side of the shielding case substrate that is away from the circuit board and the second groove is formed on the side of the shielding case substrate that is close to the circuit board.

With reference to the fourth aspect, a shape of the squeezing deformation reinforcement structure is a groove, and wherein the groove is formed on the side of the shielding case substrate that is away from the circuit board or on the side of the shielding case substrate that is close to the circuit board resulting in the thickness of the shielding strip at the squeezing deformation reinforcement structure is less than average thickness of the shielding strip.

With reference to the fourth aspect, in some implementations of the fourth aspect, the shielding case further includes: a shielding inner wall, where the shielding inner wall is located on a side that is of the shielding cover and that is close to the circuit board, the shielding inner wall is disposed perpendicularly to the shielding cover, one end of the shielding inner wall is fastened on the shielding case, and the other end of the shielding inner wall is used to be fastened on the circuit board.

With reference to the fourth aspect, in some implementations of the fourth aspect, a material of the shielding inner wall includes: a shielding inner wall substrate; a third nickel-plated layer, where the third nickel-plated layer wraps a side that is of the shielding inner wall substrate and that is close to the shielding case; a fourth nickel-plated layer, where the fourth nickel-plated layer wraps a side that is of the shielding inner wall substrate and that is away from the shielding case; a second soldering layer, where the second soldering layer wraps the third nickel-plated layer, the fourth nickel-plated layer, and a shielding case substrate, an area that is of the third nickel-plated layer and that is wrapped by the second soldering layer is a fourth partial area, an area that is of the fourth nickel-plated layer and that is wrapped by the second soldering layer is a fifth partial area, and an area that is of the shielding case substrate and that is wrapped by the first soldering layer is located between the fourth partial area and the fifth partial area; and a second insulation layer, where the second insulation layer is located on a side that is of the fourth nickel-plated layer and that is away from the shielding inner wall substrate, the second insulation layer is pasted on a sixth partial area of the fourth nickel-plated layer, and the sixth partial area is not connected to the fifth partial area.

With reference to the fourth aspect, the shielding case is configured to be fastened on the circuit board, and a material of the shielding case includes: a shielding case substrate; a first nickel-plated layer, where the first nickel-plated layer wraps a side that is of the shielding case substrate and that is close to the circuit board; a second nickel-plated layer, where the second nickel-plated layer wraps a side that is of the shielding case substrate and that is away from the circuit board; a first insulation layer, where the first insulation layer is located on a side that is of the first nickel-plated layer and that is away from the shielding case substrate, and the first insulation layer is pasted on a first partial area of the first nickel-plated layer; and a first soldering layer, where the first soldering layer is configured to fasten the shielding case on the circuit board through soldering, the first soldering layer is located on a side that is of the first nickel-plated layer and that is away from the shielding case substrate, the first soldering layer wraps a second partial area of the first nickel-plated layer, and the second partial the area is not connected to the first partial area.

With reference to the fourth aspect, in some implementations of the fourth aspect, the first soldering layer further wraps the second nickel-plated layer and the shielding case substrate, an area that is of the second nickel-plated layer and that is wrapped by the first soldering layer is a third partial area, and an area that is of the shielding case substrate and that is wrapped by the first soldering layer is located between the second partial area and the third partial area.

According to a fifth aspect, a shielding case is provided, the shielding case is configured to be fastened on a circuit board, and the shielding case includes: a shielding cover, where the shielding cover is disposed in parallel to the circuit board; a shielding base, where the shielding base is configured to be fastened on the circuit board; a shielding wall, where the shielding wall is connected between the shielding cover and the shielding base, the shielding wall surrounds the shielding cover, and the shielding wall is disposed perpendicularly to the shielding cover; and a shielding inner wall, where the shielding inner wall is located on a side that is of the shielding cover and that is close to the circuit board, the shielding inner wall includes a first area disposed in parallel to the shielding cover and a second area disposed perpendicularly to the shielding cover, the first area is fastened on the shielding case, an end that is of the second area and that is away from the first area is used to be fastened on the circuit board, one or more deformation reinforcement structures are disposed in the second area, and the one or more deformation reinforcement structures include at least one of the following: a semi-piercing deformation reinforcement structure, a drawing deformation reinforcement structure, and a squeezing deformation reinforcement structure.

In this application, the deformation reinforcement structure is obtained after plastic deformation of a material. As a deformation amount increases, strength and hardness of the material can be improved. Compared with a common shielding case, a shielding case including the deformation reinforcement structure is generally more difficult to deform. In terms of shielding performance, when the shielding case shields a signal for an electronic element, greater difficulty in deforming the shielding case leads to greater difficulty in coming into contact with the electronic element. Therefore, disposing the deformation reinforcement structure on the shielding case helps improve shielding performance of a shielding member. In addition, disposing one or more deformation reinforcement structures on the shielding inner wall helps reduce a deformation amount of the shielding inner wall under external force, helps improve an effect of the shielding inner wall for supporting the shielding cover, and further helps improve shielding performance of the shielding case.

With reference to the fifth aspect, the semi-piercing deformation reinforcement structure includes a first protrusion and a first groove corresponding to the first protrusion, a maximum cross-sectional width of the first protrusion is greater than a minimum cross-sectional width of the first groove, and a difference between the maximum cross-sectional width of the first protrusion and the minimum cross-sectional width of the first groove is less than twice thickness of the shielding inner wall. A center surface of the first groove is aligned with a center surface of the first protrusion, wherein the first protrusion is formed on one side of the shielding inner wall substrate in the second area, and the first groove is formed on the other side of the shielding inner wall substrate in the second area.

With reference to the fifth aspect, the drawing deformation reinforcement structure includes a second protrusion and a second groove corresponding to the second protrusion, a maximum cross-sectional width of the second protrusion is greater than a minimum cross-sectional width of the second groove, and a difference between the maximum cross-sectional width of the second protrusion and the minimum cross-sectional width of the second groove is greater than or equal to twice the thickness of the shielding inner wall. A center surface of the second groove is aligned with a center surface of the second protrusion, wherein the second protrusion is formed on one side of the shielding inner wall substrate in the second area, and the second groove is formed on the other side of the shielding inner wall substrate in the second area.

With reference to the fifth aspect, a shape of the squeezing deformation reinforcement structure is a groove, and wherein the groove is formed on one side of the shielding inner wall substrate in the second area resulting in the thickness of the shielding inner wall at the squeezing deformation reinforcement structure is less than average thickness of the shielding inner wall.

With reference to the fifth aspect, a material of the shielding inner wall includes: a shielding inner wall substrate; a third nickel-plated layer, where the third nickel-plated layer wraps a side that is of the shielding inner wall substrate and that is close to the shielding case; a fourth nickel-plated layer, where the fourth nickel-plated layer wraps a side that is of the shielding inner wall substrate and that is away from the shielding case; a second soldering layer, where the second soldering layer wraps the third nickel-plated layer, the fourth nickel-plated layer, and a shielding case substrate, an area that is of the third nickel-plated layer and that is wrapped by the second soldering layer is a fourth partial area, an area that is of the fourth nickel-plated layer and that is wrapped by the second soldering layer is a fifth partial area, and an area that is of the shielding case substrate and that is wrapped by the first soldering layer is located between the fourth partial area and the fifth partial area; and a second insulation layer, where the second insulation layer is located on a side that is of the fourth nickel-plated layer and that is away from the shielding inner wall substrate, the second insulation layer is pasted on a sixth partial area of the fourth nickel-plated layer, and the sixth partial area is not connected to the fifth partial area.

With reference to the fifth aspect, in some implementations of the fifth aspect, the shielding case is configured to be fastened on the circuit board, and a material of the shielding case includes: a shielding case substrate; a first nickel-plated layer, where the first nickel-plated layer wraps a side that is of the shielding case substrate and that is close to the circuit board; a second nickel-plated layer, where the second nickel-plated layer wraps a side that is of the shielding case substrate and that is away from the circuit board; a first insulation layer, where the first insulation layer is located on a side that is of the first nickel-plated layer and that is away from the shielding case substrate, and the first insulation layer is pasted on a first partial area of the first nickel-plated layer; and a first soldering layer, where the first soldering layer is configured to fasten the shielding case on the circuit board through soldering, the first soldering layer is located on a side that is of the first nickel-plated layer and that is away from the shielding case substrate, the first soldering layer wraps a second partial area of the first nickel-plated layer, and the second partial the area is not connected to the first partial area.

With reference to the fifth aspect, in some implementations of the fifth aspect, the first soldering layer further wraps the second nickel-plated layer and the shielding case substrate, an area that is of the second nickel-plated layer and that is wrapped by the first soldering layer is a third partial area, and an area that is of the shielding case substrate and that is wrapped by the first soldering layer is located between the second partial area and the third partial area.

According to a first example that is not encompassed by the claims but useful for understanding the invention, a shielding case is provided, and includes one or more deformation reinforcement structures, where the one or more deformation reinforcement structures include at least one of the following: a semi-piercing deformation reinforcement structure, a drawing deformation reinforcement structure, and a squeezing deformation reinforcement structure.

In this application, the deformation reinforcement structure is obtained after plastic deformation of a material. As a deformation amount increases, strength and hardness of the material can be improved. Compared with a common shielding case, a shielding case including the deformation reinforcement structure is generally more difficult to deform. In terms of shielding performance, when the shielding case shields a signal for an electronic element, greater difficulty in deforming the shielding case leads to greater difficulty in coming into contact with the electronic element. Therefore, disposing the deformation reinforcement structure on the shielding case helps improve shielding performance of a shielding member.

With reference to the first example, in some implementations of the first example, the semi-piercing deformation reinforcement structure includes a first protrusion and a first groove corresponding to the first protrusion, a maximum cross-sectional width of the first protrusion is greater than a minimum cross-sectional width of the first groove, and a difference between the maximum cross-sectional width of the first protrusion and the minimum cross-sectional width of the first groove is less than twice thickness of the shielding case.

With reference to the first example, in some implementations of the first example, the drawing deformation reinforcement structure includes a second protrusion and a second groove corresponding to the second protrusion, a maximum cross-sectional width of the second protrusion is greater than a minimum cross-sectional width of the second groove, and a difference between the maximum cross-sectional width of the second protrusion and the minimum cross-sectional width of the second groove is greater than or equal to twice the thickness of the shielding case.

With reference to the first example, in some implementations of the first example, a shape of the squeezing deformation reinforcement structure is a groove, and thickness of the shielding case at the squeezing deformation reinforcement structure is less than average thickness of the shielding case.

With reference to the first example, in some implementations of the first example, the shielding case is configured to be fastened on the circuit board, and a material of the shielding case includes: a shielding case substrate; a first nickel-plated layer, where the first nickel-plated layer wraps a side that is of the shielding case substrate and that is close to the circuit board; a second nickel-plated layer, where the second nickel-plated layer wraps a side that is of the shielding case substrate and that is away from the circuit board; a first insulation layer, where the first insulation layer is located on a side that is of the first nickel-plated layer and that is away from the shielding case substrate, and the first insulation layer is pasted on a first partial area of the first nickel-plated layer; and a first soldering layer, where the first soldering layer is configured to fasten the shielding case on the circuit board through soldering, the first soldering layer is located on a side that is of the first nickel-plated layer and that is away from the shielding case substrate, the first soldering layer wraps a second partial area of the first nickel-plated layer, and the second partial the area is not connected to the first partial area.

With reference to the first example, in some implementations of the first example, the first soldering layer further wraps the second nickel-plated layer and the shielding case substrate, an area that is of the second nickel-plated layer and that is wrapped by the first soldering layer is a third partial area, and an area that is of the shielding case substrate and that is wrapped by the first soldering layer is located between the second partial area and the third partial area.

With reference to the first example, in some implementations of the first example, the shielding case is configured to be fastened on the circuit board, and the shielding case includes: a shielding cover, where the shielding cover is disposed in parallel to the circuit board, and the one or more deformation reinforcement structures are located on the shielding cover; a shielding base, where the shielding base is configured to be fastened on the circuit board; and a shielding wall, where the shielding wall is connected between the shielding cover and the shielding base, the shielding wall surrounds the shielding cover, and the shielding wall is disposed perpendicularly to the shielding cover.

With reference to the first example, in some implementations of the first example, the shielding case further includes: a shielding inner wall, where the shielding inner wall is located on a side that is of the shielding cover and that is close to the circuit board, the shielding inner wall is disposed perpendicularly to the shielding cover, one end of the shielding inner wall is fastened on the shielding case, and the other end of the shielding inner wall is used to be fastened on the circuit board.

With reference to the first example, in some implementations of the first example, a material of the shielding inner wall includes: a shielding inner wall substrate; a third nickel-plated layer, where the third nickel-plated layer wraps a side that is of the shielding inner wall substrate and that is close to the shielding case; a fourth nickel-plated layer, where the fourth nickel-plated layer wraps a side that is of the shielding inner wall substrate and that is away from the shielding case; a second soldering layer, where the second soldering layer wraps the third nickel-plated layer, the fourth nickel-plated layer, and a shielding case substrate, an area that is of the third nickel-plated layer and that is wrapped by the second soldering layer is a fourth partial area, an area that is of the fourth nickel-plated layer and that is wrapped by the second soldering layer is a fifth partial area, and an area that is of the shielding case substrate and that is wrapped by the first soldering layer is located between the fourth partial area and the fifth partial area; and a second insulation layer, where the second insulation layer is located on a side that is of the fourth nickel-plated layer and that is away from the shielding inner wall substrate, the second insulation layer is pasted on a sixth partial area of the fourth nickel-plated layer, and the sixth partial area is not connected to the fifth partial area.

With reference to the first example, in some implementations of the first example, the shielding case is configured to be fastened on the circuit board, and the shielding case includes: a shielding cover, where the shielding cover is disposed in parallel to the circuit board, and the one or more deformation reinforcement structures are located on the shielding cover; and a plurality of shielding outer walls, where one end of the shielding outer wall is used to be fastened on the circuit board, the other end of the shielding outer wall is connected to the shielding cover, the shielding outer wall is disposed perpendicularly to the circuit board, the plurality of shielding outer walls are disposed around the shielding cover, and there is a partition between two adjacent shielding outer walls.

With reference to the first example, in some implementations of the first example, the shielding case is configured to be fastened on the circuit board, and the shielding case includes: a shielding frame, where the shielding frame is disposed in parallel to the circuit board; a separable shielding cover, where the separable shielding cover is disposed on the shielding frame, an edge of the separable shielding cover surrounds an area surrounded by the shielding frame, the separable shielding cover is disposed in parallel to the circuit board, and the one or more deformation reinforcement structures are located on the separable shielding cover; a shielding base, where the shielding base is configured to be fastened on the circuit board; and a shielding wall, where the shielding wall is connected between the shielding frame and the shielding base, the shielding wall surrounds the shielding frame, and the shielding wall is disposed perpendicularly to the separable shielding cover.

With reference to the first example, in some implementations of the first example, the shielding case is configured to be fastened on the circuit board, and the shielding case includes: a shielding frame, where the shielding frame is disposed in parallel to the circuit board, the shielding frame includes a shielding strip, the shielding strip divides an area surrounded by the shielding frame into a plurality of cavities, and the one or more deformation reinforcement structures are located on the shielding strip; a shielding base, where the shielding base is configured to be fastened on the circuit board; a separable shielding cover, where the separable shielding cover is disposed on the shielding frame, an edge of the separable shielding cover surrounds the area surrounded by the shielding frame, and the separable shielding cover is disposed in parallel to the circuit board; and a shielding wall, where the shielding wall is connected between the shielding frame and the shielding base, the shielding wall surrounds the shielding frame, and the shielding wall is disposed perpendicularly to the separable shielding cover.

With reference to the first example, in some implementations of the first example, the shielding case is configured to be fastened on the circuit board, and the shielding case includes: a shielding cover, where the shielding cover is disposed in parallel to the circuit board; a shielding base, where the shielding base is configured to be fastened on the circuit board; a shielding wall, where the shielding wall is connected between the shielding cover and the shielding base, the shielding wall surrounds the shielding cover, and the shielding wall is disposed perpendicularly to the shielding cover; and a shielding inner wall, where the shielding inner wall is located on a side that is of the shielding cover and that is close to the circuit board, the shielding inner wall includes a first area disposed in parallel to the shielding cover and a second area disposed perpendicularly to the shielding cover, the first area is fastened on the shielding case, an end that is of the second area and that is away from the first area is fastened on the circuit board, and the one or more deformation reinforcement structures are located in the second area.

According to a second example that is not encompassed by the claims but useful for understanding the invention, a shielding case is provided, and includes a soldering layer and an insulation layer. Both the soldering layer and the insulation layer are on a same side of the shielding case, and an area that is of the shielding case and that is wrapped by the soldering layer is not connected to an area that is of the shielding case and that is wrapped by the insulation layer.

If the insulation layer is placed on the soldering layer, there may be a problem that a surface bonding effect between the soldering layer and the insulation layer is relatively poor. For example, the insulation layer may bulge or fall off. In this application, the insulation layer is not connected to or in contact with the soldering layer, and this helps reduce a possibility of failure of the insulation layer, so that the insulation layer can have a relatively good insulation effect. In terms of shielding performance, when the shielding case shields a signal for an electronic element, greater difficulty in connecting the shielding case to the electronic element helps improve shielding performance of the shielding case. In addition, that the insulation layer is not connected to or in contact with the soldering layer further helps reduce a material of the soldering layer on the shielding case.

With reference to the second example, in some implementations of the second example, the shielding case is configured to be fastened on the circuit board, and a material of the shielding case includes: a shielding case substrate; a first nickel-plated layer, where the first nickel-plated layer wraps a side that is of the shielding case substrate and that is close to the circuit board; and a second nickel-plated layer, where the second nickel-plated layer wraps a side that is of the shielding case substrate and that is away from the circuit board. The insulation layer is located on a side that is of the first nickel-plated layer and that is away from the shielding case substrate, and the insulation layer is pasted on a first partial area of the first nickel-plated layer. The soldering layer is configured to fasten the shielding case on the circuit board through soldering, the soldering layer is located on a side that is of the first nickel-plated layer and that is away from the shielding case substrate, the soldering layer wraps a second partial area of the first nickel-plated layer, and the second partial the area is not connected to the first partial area.

In this application, the insulation layer is disposed on a side that is of the shielding case and that is close to the circuit board, and when the shielding case is deformed toward the circuit board, a probability of an electrical connection between the shielding case and the electronic element can be reduced, and this helps improve shielding performance of the shielding case.

With reference to the second example, in some implementations of the second example, the shielding case is configured to be fastened on the circuit board, and the shielding case includes: a shielding inner wall, where the shielding inner wall is located on a side that is of the shielding cover and that is close to the circuit board, the shielding inner wall is disposed perpendicularly to the circuit board, one end of the shielding inner wall is fastened on the shielding case, and the other end of the shielding inner wall is used to be fastened on the circuit board. A material of the shielding inner wall includes: a shielding inner wall substrate; a third nickel-plated layer, where the third nickel-plated layer wraps a side that is of the shielding inner wall substrate and that is close to the shielding case; a fourth nickel-plated layer, where the fourth nickel-plated layer wraps a side that is of the shielding inner wall substrate and that is away from the shielding case; a second soldering layer, where the second soldering layer wraps the third nickel-plated layer, the fourth nickel-plated layer, and a shielding case substrate, an area that is of the third nickel-plated layer and that is wrapped by the second soldering layer is a fourth partial area, an area that is of the fourth nickel-plated layer and that is wrapped by the second soldering layer is a fifth partial area, and an area that is of the shielding case substrate and that is wrapped by the first soldering layer is located between the fourth partial area and the fifth partial area; and a second insulation layer, where the second insulation layer is located on a side that is of the fourth nickel-plated layer and that is away from the shielding inner wall substrate, the second insulation layer is pasted on a sixth partial area of the fourth nickel-plated layer, and the sixth partial area is not connected to the fifth partial area.

In this application, the insulation layer is disposed on the shielding inner wall, and when the shielding inner wall is deformed toward the electronic element, a probability of an electrical connection between the shielding inner wall and the electronic element can be reduced, and this helps improve shielding performance of the shielding case.

According to an third example that is not encompassed by the claims but useful for understanding the invention, a circuit board assembly is provided, and includes a circuit board, an electronic element, and the shielding case in any possible implementation of the first aspect to the second example, the shielding case is fastened on the circuit board, and the electronic element is located in a cavity formed between the shielding case and the circuit board.

According to a sixth aspect, an electronic device is provided, and includes the shielding case in any possible implementation of the first aspect to the fifth aspect.

According to a fourth example that is not encompassed by the claims but useful for understanding the invention, an electronic device is provided, and includes the circuit board assembly in any possible implementation of the third example.

According to an seventh aspect, an electronic device is provided, and includes: a circuit board; a shielding case, where the shielding case includes a shielding cover, a shielding wall, and a shielding base, the shielding cover is disposed in parallel to the circuit board, one or more second annular deformation reinforcement structures are disposed on the shielding cover, and the one or more second annular deformation reinforcement structures include at least one of the following: a second annular drawing deformation reinforcement structure and a second annular squeezing deformation reinforcement structure; the drawing deformation reinforcement structure includes a second annular protrusion and a second annular groove corresponding to the second annular protrusion, a maximum cross-sectional width of the second annular protrusion is greater than a minimum cross-sectional width of the second annular groove, and a difference between the maximum cross-sectional width of the second annular protrusion and the minimum cross-sectional width of the second annular groove is greater than or equal to twice thickness of the shielding cover; a shape of the second annular squeezing deformation reinforcement structure is an annular groove, and thickness of the shielding cover at the squeezing deformation reinforcement structure is less than average thickness of the shielding cover; and the shielding wall is connected between the shielding cover and the shielding base, the shielding wall surrounds the shielding cover, the shielding wall is disposed perpendicularly to the shielding cover, and the shielding base is fastened on the circuit board; and an electronic element, where the electronic element is located in a cavity formed between the shielding case and the circuit board. A material of the shielding case comprises a shielding case substrate, a first nickel-plated layer, a second nickel-plated layer, a first insulation layer, and a first soldering layer. The first nickel-plated layer wraps a side that is of the shielding case substrate and that is close to the circuit board. The second nickel-plated layer wraps a side that is of the shielding case substrate and that is away from the circuit board. The first insulation layer is located on a side that is of the first nickel-plated layer and that is away from the shielding case substrate, and the first insulation layer is pasted on a first partial area of the first nickel-plated layer. The first soldering layer is configured to fasten the shielding case on the circuit board through soldering, the first soldering layer is located on a side that is of the first nickel-plated layer and that is away from the shielding case substrate, the first soldering layer wraps a second partial area of the first nickel-plated layer, and the second partial the area is not connected to the first partial area

According to a fifth example that is not encompassed by the claims but useful for understanding the invention, an electronic device is provided, and includes: a circuit board; a shielding case, where the shielding case includes a shielding cover, a shielding wall, and a shielding base, the shielding cover is disposed in parallel to the circuit board, one or more deformation reinforcement structures are disposed on the shielding cover, and the one or more deformation reinforcement structures include at least one of the following: a drawing deformation reinforcement structure and a squeezing deformation reinforcement structure; the drawing deformation reinforcement structure includes a second protrusion and a second groove corresponding to the second protrusion, a maximum cross-sectional width of the second protrusion is greater than a minimum cross-sectional width of the second groove, and a difference between the maximum cross-sectional width of the second protrusion and the minimum cross-sectional width of the second groove is greater than or equal to twice thickness of the shielding cover; a shape of the squeezing deformation reinforcement structure is a groove, and thickness of the shielding cover at the squeezing deformation reinforcement structure is less than average thickness of the shielding cover; and the shielding wall is connected between the shielding cover and the shielding base, the shielding wall surrounds the shielding cover, the shielding wall is disposed perpendicularly to the shielding cover, and the shielding base is fastened on the circuit board; and an electronic element, where the electronic element is located in a cavity formed between the shielding case and the circuit board.

### BRIEF DESCRIPTION OF DRAWINGS

FIG. 1 is a schematic diagram of a structure of an electronic device;
FIG. 2 is a schematic diagram of a structure of a circuit board assembly;
FIG. 3 is a schematic diagram of a structure of a shielding case;
FIG. 4 is a schematic diagram of a structure of a shielding case;
FIG. 5 is a schematic diagram of a structure of a shielding case;
FIG. 6 is a schematic diagram of a structure of a circuit board assembly according to an embodiment of this application;
FIG. 7 is a schematic flowchart of a method for forming a semi-piercing deformation reinforcement structure according to an embodiment of this application;
FIG. 8 is a schematic flowchart of a method for forming a drawing deformation reinforcement structure according to an embodiment of this application;
FIG. 9 is a schematic flowchart of a method for forming a squeezing deformation reinforcement structure according to an embodiment of this application;
FIG. 10 is a schematic diagram of a structure of a circuit board assembly according to an embodiment of this application;
FIG. 11 is a schematic diagram of a structure of a shielding case according to an embodiment of this application;
FIG. 12 is a schematic diagram of a structure of a shielding case according to an embodiment of this application;
FIG. 13 is a schematic diagram of a structure of a shielding case according to an embodiment of this application;
FIG. 14 is a schematic diagram of a structure of a shielding case according to an embodiment of this application;
FIG. 15 is a schematic diagram of a structure of a shielding case according to an embodiment of this application;
FIG. 16 is a schematic diagram of a structure of a shielding case according to an embodiment of this application;
FIG. 17 is a schematic diagram of a structure of a shielding case according to an embodiment of this application;
FIG. 18 is a schematic diagram of a structure of a shielding case according to an embodiment of this application;
FIG. 19 is a schematic diagram of a structure of a shielding case according to an embodiment of this application;
FIG. 20 is a schematic diagram of a structure of a shielding case according to an embodiment of this application;
FIG. 21 is a schematic diagram of a structure of a circuit board assembly according to an embodiment of this application;
FIG. 22 is a schematic diagram of a structure of a circuit board assembly according to an embodiment of this application;
FIG. 23 is a schematic diagram of a structure of a circuit board assembly according to an embodiment of this application;
FIG. 24 is a schematic diagram of a structure of a circuit board assembly according to an embodiment of this application;
FIG. 25 is a schematic flowchart of a method for manufacturing a shielding case according to an embodiment of this application;
FIG. 26 is a schematic diagram of a structure of a circuit board assembly according to an embodiment of this application;
FIG. 27 is a schematic flowchart of a method for manufacturing a shielding case according to an embodiment of this application; and
FIG. 28 is a schematic diagram of a structure of a circuit board assembly according to an embodiment of this application.

### DESCRIPTION OF EMBODIMENTS

The following describes technical solutions of this application with reference to the accompanying drawings.

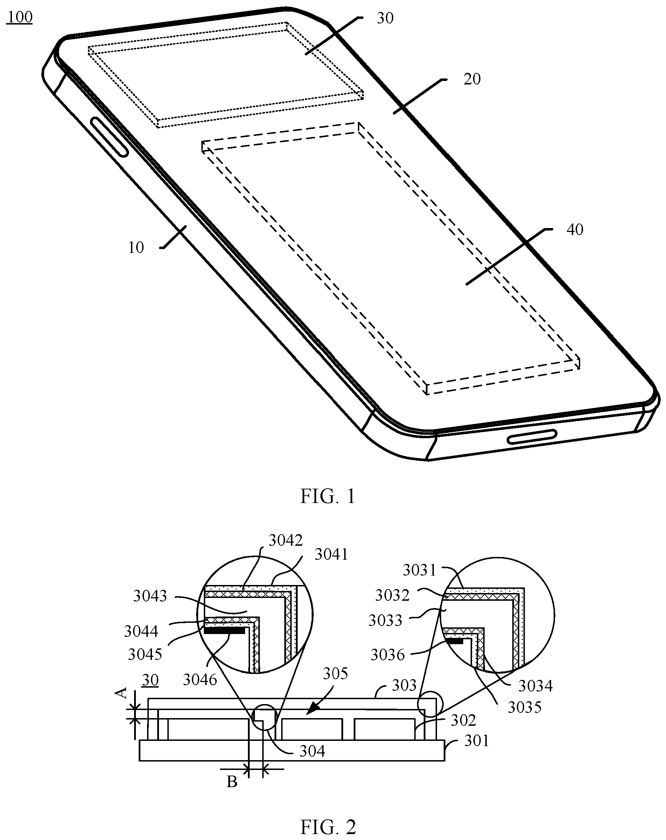

An electronic device 100 may be a device such as a mobile phone, a tablet computer, an electronic reader, a notebook computer, a digital camera, a vehicle-mounted device, or a wearable device. An embodiment shown in FIG. 1 is described by using an example in which the electronic device 100 is a mobile phone.

The electronic device 100 includes a housing 10, a display 20, a circuit board assembly 30, and a power supply 40. The display 20 and the circuit board assembly 30 are mounted in the housing 10. Specifically, the housing 10 includes a bezel and a rear cover. The bezel surrounds an outer circumference of the display 20 and surrounds an outer circumference of the rear cover, and the display 20 is disposed at an interval from the rear cover. A cavity formed among the display 20, the bezel, and the rear cover is used to place the circuit board assembly 30 and the power supply 40. The housing 10 may be configured to fasten the circuit board assembly 30 and the power supply 40. The power supply 40 is configured to supply power to the circuit board assembly 30. The power supply 40 may be, for example, a lithium-ion battery.

FIG. 2 is an example of the circuit board assembly 30 of the electronic device 100 shown in FIG. 1. The circuit board assembly 30 may be a printed circuit board assembly (printed circuit board assembly, PCBA). The circuit board assembly 30 includes a printed circuit board (printed circuit board, PCB) 301 and at least one electronic element 302 electrically connected to the PCB 301. The power supply 40 in FIG. 1 is configured to supply power to the PCB 301 and/or the at least one electronic element 302. The electronic element 302 may be fastened on the PCB 301 by using a solder ball (not shown in FIG. 2), and the PCB 301 and the electronic element 302 are electrically connected by using the solder ball. The solder ball described in this application may be a solder material used to mechanically and/or electrically connect circuit boards, or a solder material used to mechanically and/or electrically connect a circuit board and an electronic element. An actual shape of the solder ball described in this application does not necessarily a sphere, and may be a polyhedron, a sphere, an ellipsoid, a truncated cone, a chamfer, or the like. For ease of description, various shapes of solder materials are collectively referred to as the solder ball in this application. For ease of description, when no special description is specified, a connection function of the solder ball includes a mechanical connection and/or an electrical connection. In other words, a solder ball connected between the circuit board and the electronic element may represent a solder ball mechanically connected and/or electrically connected between the circuit board and the electronic element, or may represent a solder ball mechanically connected and/or electrically connected between two circuit boards.

The PCB 301 may be, for example, a mainboard, a frame board (frame board, FB), or a land grid array (land grid array, LGA). The PCB 301 further includes a soldering area (that is, a pad) that can be used for soldering. The electronic element 302 may be electrically connected to the PCB 301 through soldering in a soldering area of the PCB 301, and is further electrically connected to another electronic element or another PCB.

The electronic element 302 may be, for example, a power management unit (power management unit, PMU), a radio frequency power amplifier (radio frequency power amplifier, RF PA), a radio frequency integrated circuit (radio frequency integrated circuit, RF IC), an application processor (Application Processor, AP), a double data rate (double data rate, DDR) memory, a universal flash storage (universal flash storage, UFS), or a system on chip (system on chip, SOC) element. A plurality of electronic elements may be stacked and packaged to form a package on package (Package on Package, POP) element. It should be understood that the electronic element 302 electrically connected to the PCB 301 is not limited to a specific electronic element disclosed in this application.

The electronic element 302 may be interfered with by an external interference signal and an interference signal sent by a neighboring electronic element. If interference is excessively strong, normal working of the electronic element 302 may be affected, and consequently, normal working of the electronic device 10 may be affected.

According to a first aspect, to shield an external interference signal, a shielding case 303 may be disposed around the electronic element 302. For example, the shielding case 303 may be fastened on the PCB 301 by using a solder ball. The electronic element 302 may be located in a cavity 305 formed between the shielding case 303 and the PCB 301. As shown in FIG. 2, the shielding case 303 may include a shielding case substrate 3033, a first soldering layer 3031, a first nickel-plated layer 3032, a second soldering layer 3035, a second nickel-plated layer 3034, and a first insulation layer 3036. A material of the shielding case substrate 3033 may be, for example, aluminum alloy or stainless steel. In this application, the soldering layer may be, for example, a tin-plated layer, a gold-plated layer, or the like.

For ease of description, a position outside space between the shielding case substrate 3033 and the PCB 301 is defined as an outer side of the shielding case substrate 3033, and a position within the space between the shielding case substrate 3033 and the PCB 301 is defined as an inner side of the shielding case substrate 3033.

The first soldering layer 3031 and the first nickel-plated layer 3032 may wrap the outer side of the shielding case substrate 3033, and the first nickel-plated layer 3032 may be disposed between the first soldering layer 3031 and the shielding case substrate 3033. The second soldering layer 3035 and the second nickel-plated layer 3034 may wrap the inner side of the shielding case substrate 3033, and the first nickel-plated layer 3032 may be disposed between the first soldering layer 3031 and the shielding case substrate 3033. The first soldering layer 3031 and/or the second soldering layer 3035 are/is configured to solder the shielding case 303 on the PCB 301.

The first insulation layer 3036 may be disposed on a side that is of the second soldering layer 3035 and that is away from the shielding case substrate 3033. To reduce a probability of a short circuit between the shielding case 303 and the electronic element 302, the first insulation layer 3036 may be disposed in parallel to the PCB 301. If the shielding case 303 is depressed, the first insulation layer 3036 on the shielding case 303 may be in contact with the electronic element 302. Therefore, a possibility of a short circuit between the shielding case 303 and the electronic element 302 can be reduced.

For ease of description below, an end that is of the electronic element 302 and that is close to the PCB 301 is defined as a bottom part of the electronic element 302, and an end that is of the electronic element 302 and that is away from the PCB 301 (that is, a part opposite to the bottom part of the electronic element 302) is a top part of the electronic element 302.

In a process in which a user normally uses the electronic device 10, a minimum spacing A between the shielding case 303 and the top part of the electronic element 302 is greater than 0; in other words, the shielding case 303 is not in contact with the electronic element 302. However, if the user improperly holds the electronic device 10, the electronic device 10 may fall off. In this case, at a moment at which the electronic device 10 falls off, the shielding case 303 may be deformed, for example, the shielding case 303 may be depressed toward the electronic element 302. Once the minimum spacing A between the shielding case 303 and the top part of the electronic element 302 is reduced to 0, the shielding case 303 may be in contact with the electronic element 302.

In a possible case, an area that is on the shielding case 303 and in which the first insulation layer 3036 is not disposed is in contact with the electronic element 302. In another possible case, the first insulation layer 3036 on the shielding case 303 is in contact with the electronic element 302 for a plurality of times, and consequently, the first insulation layer 3036 falls off, is peeled off, and the like. In both the foregoing cases, a short circuit may occur between the shielding case 303 and the electronic element 302, and consequently, normal working of the electronic element 302 is affected.

In addition, due to contact between the shielding case 303 and the electronic element 302, the electronic element 302 may scratch the shielding case 303, and consequently, the shielding case 303 is damaged, and a signal shielding capability of the shielding case 303 may deteriorate.

According to a second aspect, to shield an interference signal sent by a neighboring electronic element, a shielding inner wall (the shielding inner wall may also be referred to as a shielding rib) 304 may be disposed between two adjacent electronic elements. In other words, the shielding inner wall 304 may be disposed in a spacing area between two adjacent electronic elements. For example, one end of the shielding inner wall 304 may be fastened on the shielding case 303 through laser soldering, and the other end of the shielding inner wall 304 may be soldered on the PCB 301 by using a surface mounted technology (surface mounted technology, SMT). The shielding inner wall 304 may be disposed perpendicularly to the PCB 301.

As shown in FIG. 2, the shielding inner wall 304 may include a shielding inner wall substrate 3043, a third soldering layer 3041, a third nickel-plated layer 3042, a fourth soldering layer 3045, a fourth nickel-plated layer 3044, and a second insulation layer 3046. A material of the shielding inner wall substrate 3043 may be, for example, aluminum alloy or stainless steel. In this application, the soldering layer may be, for example, a tin-plated layer, a gold-plated layer, or the like.

The third nickel-plated layer 3042 and the fourth nickel-plated layer 3044 may separately wrap two sides of the shielding inner wall substrate 3043. The third soldering layer 3041 is wrapped on a side that is of the third nickel-plated layer 3042 and that is away from the shielding inner wall substrate 3043. The fourth soldering layer 3045 may be wrapped on a side that is of the fourth nickel-plated layer 3044 and that is away from the shielding inner wall substrate 3043.

As shown in FIG. 2, the third soldering layer 3041 may be connected to the fourth soldering layer 3045, so that the shielding inner wall 304 may be soldered on the PCB 301. The second insulation layer 3046 may be disposed on the side that is of the fourth nickel-plated layer 3044 and that is away from the shielding inner wall substrate 3043, and the second insulation layer 3046 may be disposed in parallel to the PCB 301. When the shielding case 303 is deformed, the shielding inner wall 304 may be bent, and the second insulation layer 3046 on the shielding inner wall 304 may be in contact with the electronic element 302. Therefore, the second insulation layer 3046 can reduce a possibility of a short circuit between the shielding inner wall 304 and the electronic element 302.

For ease of description, an end that is of the shielding inner wall 304 and that is fastened on the PCB 301 is defined as a bottom part of the shielding inner wall 304, and an end that is of the shielding inner wall 304 and that is away from the PCB 301 (that is, a part opposite to the bottom part of the shielding inner wall 304) is defined as a top part of the shielding inner wall 304. The top part of the shielding inner wall 304 is fastened on the shielding case 303. In a process in which a user normally uses the electronic device 10, a minimum spacing B between the shielding inner wall 304 and the electronic element 302 is greater than 0; in other words, the shielding inner wall 304 is not in contact with the electronic element 302. However, if the user improperly holds the electronic device 10, the electronic device 10 may fall off. Due to deformation of the shielding case 303, the shielding inner wall 304 may be deformed. Therefore, at a moment at which the electronic device 10 falls off, the shielding inner wall 304 may be bent. Once the minimum spacing B between the shielding inner wall 304 and the electronic element 302 is reduced to 0, the shielding inner wall 304 may be in contact with the electronic element 302.

In a possible case, an area that is on the shielding inner wall 304 and in which the second insulation layer 3046 is not disposed is in contact with the electronic element 302. In another possible case, the second insulation layer 3046 on the shielding inner wall 304 is in contact with the electronic element 302 for a plurality of times, and consequently, the second insulation layer 3046 falls off, is peeled off, and the like. In both the foregoing cases, a short circuit may occur between the shielding inner wall 304 and the electronic element 302, and consequently, normal working of the electronic element 302 is affected.

In addition, due to contact between the shielding inner wall 304 and the electronic element 302, the electronic element 302 may scratch the shielding inner wall 304, and consequently, the shielding inner wall 304 is damaged, and a signal shielding capability of the shielding inner wall 304 may deteriorate.

In conclusion, if a shielding member is susceptible to an external cause, normal working of the electronic element may be affected, and a possibility of interference to the electronic element 302 may also be increased.

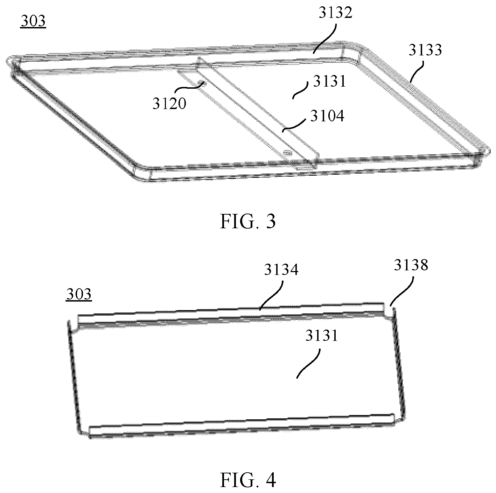

In this application, both the shielding case 303 and the shielding inner wall 304 may be used to shield an interference signal. Therefore, the shielding case 303 and the shielding inner wall 304 may be collectively referred to as the shielding member. The shielding member may be a component with a signal shielding function. FIG. 3 shows a shielding member provided in an embodiment of this application. The shielding member may include the shielding case 303 and the shielding inner wall 304 described above. For example, the shielding inner wall 304 may be soldered on the shielding case 303 by using a solder ball 306.

Several possible structures of the shielding case 303 are described below with reference to FIG. 3 to FIG. 5.

As shown in FIG. 3, the shielding case 303 may include a shielding cover 3131, a shielding wall 3132, and a shielding base 3133. The shielding base 3133 may be configured to fasten the shielding case 303 on a PCB 301 through soldering. The shielding cover 3131 may be disposed in parallel to the PCB 301. The shielding wall 3132 may be a shielding ring (or an annular shielding member). The shielding wall 3132 may have no partition. The shielding wall 3132 may surround the shielding cover 3131. The shielding wall 3132 may be disposed perpendicularly to the shielding cover 3131. The shielding wall 3132 may be connected between the shielding cover 3131 and the shielding base 3133. The shielding case 303 shown in FIG. 3 may be obtained by using a drawing forming process.

As shown in FIG. 4, the shielding case 303 may include a shielding cover 3131 and a plurality of shielding outer walls 3134. The shielding cover 3131 may be disposed in parallel to a PCB 301. The plurality of shielding outer walls 3134 are disposed around the shielding cover 3131. Any shielding outer wall 3134 may be disposed perpendicularly to the shielding cover 3131. There may be a partition 3138 between two adjacent shielding outer walls 3134. The partition 3138 may weaken a shielding effect of the shielding case 303. One end of the shielding outer wall 3134 may be connected to an edge of the shielding cover 3131, and the other end may be used to be fastened on the PCB 301 through soldering. The shielding case 303 shown in FIG. 4 may be obtained by using a bending forming process.

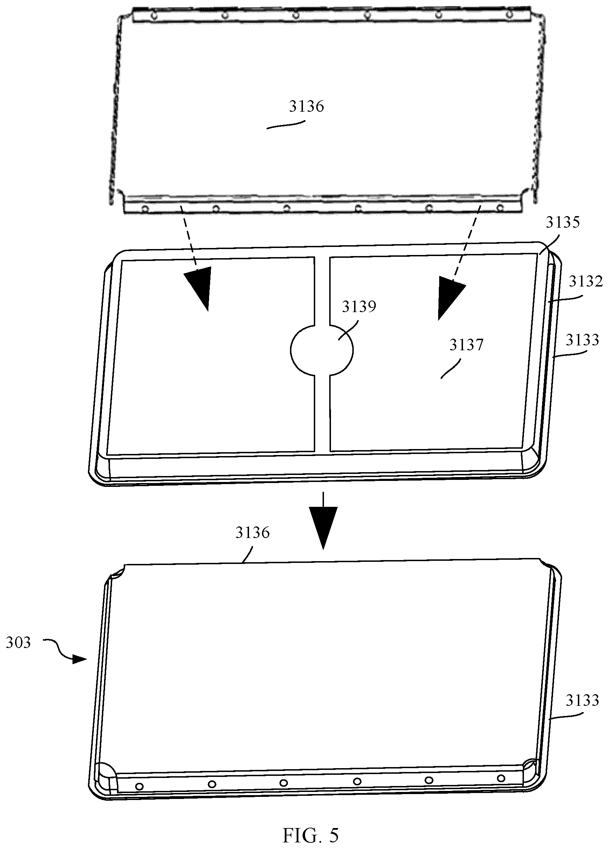

As shown in FIG. 5, the shielding case 303 may include a shielding frame 3135, a separable shielding cover 3136, a shielding wall 3132, and a shielding base 3133. The shielding base 3133 may be configured to fasten the shielding case 303 on a PCB 301 through soldering. The separable shielding cover 3136 may be mounted in an area surrounded by the shielding frame 3135. The separable shielding cover 3136 may be disposed in parallel to the PCB 301. The shielding frame 3135 may include a shielding strip 3139. The shielding strip 3139 may be in the area surrounded by the shielding frame 3135. After the shielding frame 3135 and the separable shielding cover 3136 are assembled, a shielding cover may be formed, and the shielding cover may be disposed in parallel to the PCB 301. The shielding wall 3132 may be disposed perpendicularly to the PCB 301. The shielding wall 3132 may surround the shielding frame 3135. The shielding wall 3132 may be connected between the shielding frame 3135 and the shielding base 3133. The shielding case 303 shown in FIG. 5 may be obtained by using a drawing forming process or a blanking forming process.

For ease of description, in this application, the shielding wall is defined as a shielding material disposed perpendicularly to the circuit board. Shielding walls may be classified into a shielding wall, a shielding outer wall, and a shielding inner wall. The shielding wall and the shielding outer wall may be a part of the shielding case, and the shielding wall may be an annular shielding member around the shielding case. The shielding outer wall may be a shielding member connected to a part of an edge of the shielding case, and there may be a partition between a plurality of shielding outer walls. The shielding inner wall may be a shielding member located between the shielding case and the circuit board. The shielding inner wall may be fastened on the shielding case.

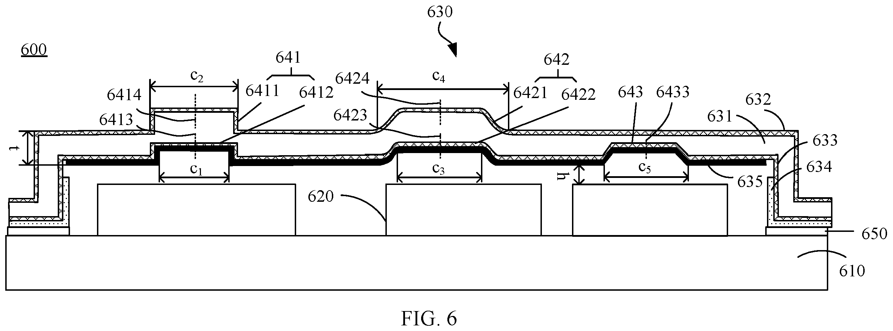

FIG. 6 shows a circuit board assembly 600 provided in an embodiment of this application. The circuit board assembly 600 may include a circuit board 610 and one or more electronic elements 620. The electronic element 620 may be fastened on the circuit board 610 through soldering. The circuit board assembly 600 may further include a shielding case 630. The shielding case 630 may be considered as a housing. The housing may be a layered structure with thickness. The shielding case 630 may be soldered on the circuit board 610 by using a pad 650. The one or more electronic elements 620 may be disposed in a cavity formed between the shielding case 630 and the circuit board 610. An overall structure of the shielding case 630 shown in FIG. 6 may be, for example, the shielding case 303 shown in FIG. 3 to FIG. 5.

The shielding case 630 may include a shielding case substrate 631, a first nickel-plated layer 633, and a second nickel-plated layer 632. A material of the shielding case substrate 631 may be, for example, aluminum alloy or stainless steel. The first nickel-plated layer 633 may wrap a side that is of the shielding case substrate 631 and that is close to the circuit board 610. The second nickel-plated layer 632 may wrap a side that is of the shielding case substrate 631 and that is away from the circuit board 610.

Optionally, the shielding case 630 may further include a first soldering layer 634 and a first insulation layer 635. As shown in FIG. 6, the first insulation layer 635 may wrap a first partial area of the first nickel-plated layer 633. The first insulation layer 635 may be located on a side that is of the first nickel-plated layer 633 and that is close to the circuit board 610. The first soldering layer 634 may wrap a second partial area of the first nickel-plated layer 633. The first soldering layer 634 may be located on the side that is of the first nickel-plated layer 633 and that is close to the circuit board 610. The second partial area is an area other than the first partial area on the first nickel-plated layer 633. In other words, the first soldering layer 634 and the first insulation layer 635 separately wrap different areas of the first nickel-plated layer 633. An area that is of the first nickel-plated layer 633 and that is wrapped by the first soldering layer 634 and an area that is of the first nickel-plated layer 633 and that is wrapped by the first insulation layer 635 do not cross each other or are different from each other. In this application, the soldering layer may be, for example, a tin-plated layer, a gold-plated layer, or the like.

Optionally, the first insulation layer 635 may be projected on the first nickel-plated layer 633 (or the circuit board 610) to obtain a first projection area. The one or more electronic elements 620 may be projected on the first nickel-plated layer 633 (or the circuit board 610) to obtain a second projection area. The second projection area may be located in the first projection area. Because a coverage area of the first insulation layer 635 on the first nickel-plated layer 633 is relatively large, a probability of a short circuit between the electronic element 620 and the first nickel-plated layer 633 is reduced.

The shielding case 630 may further include one or more deformation reinforcement structures. The deformation reinforcement structure may be obtained through plastic deformation in a partial area of the shielding case 630. A degree of the plastic deformation in the partial area is larger than a degree of plastic deformation in another area.

A metal material is used as an example. Under large enough external force, the metal material may be plastically deformed. In a plastic deformation process, a dislocation movement may occur inside the metal material. Different dislocations may intersect with each other, and therefore, dislocation density may be constantly increased. In addition, an obstacle such as fixed jog and dislocation entanglement may be generated in the dislocation movement, and consequently, resistance of the dislocation movement is increased, and plastic deformation of the metal material is made more difficult. Through plastic deformation, strength, hardness, and the like of the metal material can be improved, and plasticity, toughness, and the like of the metal material can be reduced.

FIG. 6 is a schematic diagram of cross-sections of a plurality of deformation reinforcement structures.

A first type of deformation reinforcement structure may be a semi-piercing deformation reinforcement structure 641. The semi-piercing deformation reinforcement structure 641 may be obtained by using a semi-piercing deformation forming process. The semi-piercing deformation reinforcement structure 641 may include a first groove 6412 and a first protrusion 6411. A center surface 6413 of the first groove 6412 may be aligned with a center surface 6414 of the first protrusion 6411. An average cross-sectional width of the first groove 6412 may be slightly less than an average cross-sectional width of the first protrusion 6411. The semi-piercing deformation reinforcement structure 641 typically has the following feature: A difference between a maximum cross-sectional width c₂ of the first protrusion 6411 and a minimum cross-sectional width c₁ of the first groove 6412 may be less than twice thickness (t) of the shielding case 630 (in other words, c₂-c₁<2t). The center surface 6413 of the first groove 6412 may be disposed perpendicularly to the shielding case 630.

A second type of deformation reinforcement structure may be a drawing deformation reinforcement structure 642. The drawing deformation reinforcement structure 642 may be obtained by using a drawing deformation forming process. The drawing deformation reinforcement structure 642 may include a second groove 6422 and a second protrusion 6421. A center surface 6423 of the second groove 6422 may be aligned with a center surface 6424 of the second protrusion 6421. An average cross-sectional width of the second groove 6422 may be slightly less than an average cross-sectional width of the second protrusion 6421. The drawing deformation reinforcement structure 642 typically has the following feature: A difference between a maximum cross-sectional width c₄ of the second protrusion 6421 and a minimum cross-sectional width c₃ of the second groove 6422 may be greater than or equal to twice the thickness (t) of the shielding case 630 (in other words, c₄-c₃>2t). The center surface 6423 of the second groove 6422 may be disposed perpendicularly to the shielding case 630.

A third type of deformation reinforcement structure may be a squeezing deformation reinforcement structure 643. The squeezing deformation reinforcement structure 643 may be obtained by using a squeezing deformation forming process. A shape of the squeezing deformation reinforcement structure 643 may be a groove. A part that is of the shielding case 630 and that is close to the squeezing deformation reinforcement structure 643 may not include a protrusion, or planarity of a part that is of the shielding case 630 and that is close to the squeezing deformation reinforcement structure 643 may be less than a preset planarity value. The part that is of the shielding case 630 and that is close to the squeezing deformation reinforcement structure 643 may be an area whose distance from the center surface 6433 of the squeezing deformation reinforcement structure 643 is less than a preset range value. The preset range value may be, for example, a sum (that is, c₅+2t) of a maximum cross-sectional width (c₅) of the squeezing deformation reinforcement structure 643 and twice (2t) the thickness of the shielding case 630. The center surface 6433 of the squeezing deformation reinforcement structure 643 may be disposed perpendicularly to the shielding case 630.

For example, a center line of the deformation reinforcement structure may pass through a cross-section of the deformation reinforcement structure. A cross-sectional outline may be captured on the cross-section of the deformation reinforcement structure, and a size of the cross-sectional outline may be a size 1. Another outline may be captured on another plane through which the center line of the deformation reinforcement structure passes, and a size of the another outline may be a size 2. The size 1 may be less than the size 2.

Optionally, a minimum spacing h between the shielding case 630 and the electronic element 620 may be greater than a preset spacing value. For example, the preset spacing value may be 0.15 mm. If the minimum spacing h between the shielding case 630 and the electronic element 620 is excessively small, the shielding case 630 is prone to contact with the electronic element 620.

As shown in FIG. 6, a depression direction of the deformation reinforcement structure is a direction away from the circuit board 610 or the electronic element 620. For example, a groove opening of the first groove 6412 is closer to the circuit board 610 or the electronic element 620 than a groove bottom of the first groove 6412, and the first protrusion 6411 is further away from the circuit board 610 or the electronic element 620 than the first groove 6412. For another example, a groove opening of the second groove 6422 is closer to the circuit board 610 or the electronic element 620 than a groove bottom of the second groove 6422, and the second protrusion 6421 is further away from the circuit board 610 or the electronic element 620 than the second groove 6422. For another example, a groove opening of the squeezing deformation reinforcement structure 643 is closer to the circuit board 610 or the electronic element 620 than a groove bottom of the squeezing deformation reinforcement structure 643. An area with a minimum spacing between the shielding case 630 and the electronic element 620 may be located outside the deformation reinforcement structure. Therefore, the deformation reinforcement structure shown in FIG. 6 generally does not reduce a spacing between the shielding case 630 and the electronic element 620.

However, if another component is disposed on a side that is of the shielding case 630 and that is away from the electronic element 620 or the circuit board 610, the semi-piercing deformation reinforcement structure 641 and the drawing deformation reinforcement structure 642 may reduce a spacing between the shielding case 630 and the another component, and the squeezing deformation reinforcement structure 643 generally does not reduce the spacing between the shielding case 630 and the another component.

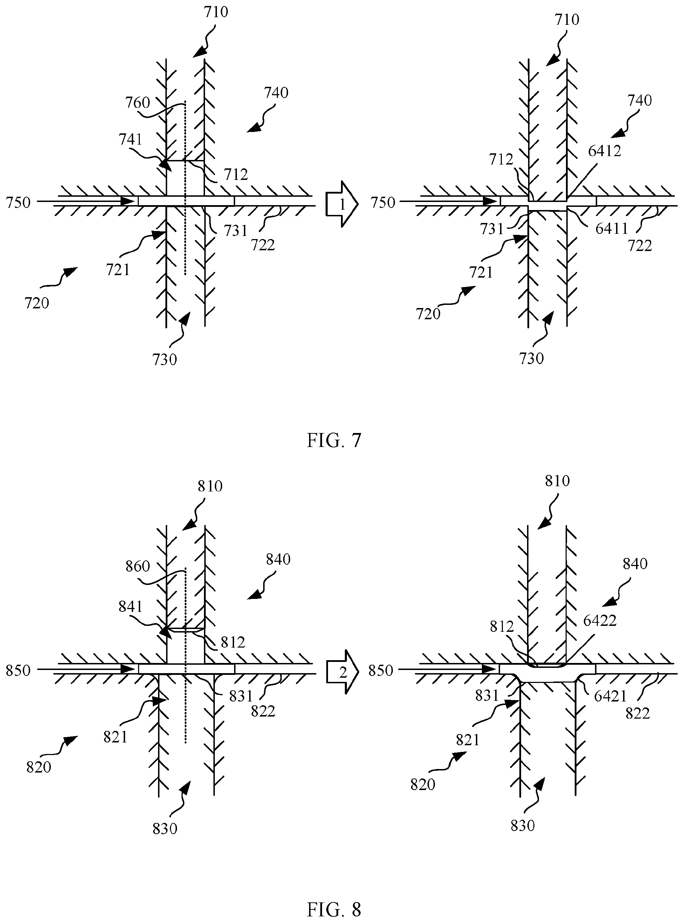

FIG. 7 is a schematic flowchart of a semi-piercing deformation forming process. A mold used to manufacture the semi-piercing deformation reinforcement structure 641 may include a first forming punch 710, a first lower forming block 720, a first lower stripper block 730, and a first retainer plate 740. In this embodiment of this application, the forming punch may also be referred to as a punch, a convex mold, or the like. The lower forming block may also be referred to as a concave mold or the like. The lower stripper block may also be referred to as an ejector or the like. The retainer plate may also be referred to as a blank holder or the like.

The first lower forming block 720 may include a first bearing surface 722 for placing a first stamping sheet metal 750. The first forming punch 710 may be disposed perpendicularly to the first bearing surface 722, and the first forming punch 710 may move in a direction perpendicular to the first bearing surface 722. A surface that is of the first forming punch 710 and that faces the first lower forming block 720 may be a first stamping surface 712. The first stamping surface 712 may be used to be in contact with a side that is of the first stamping sheet metal 750 and that is away from the first lower forming block 720.

The first lower forming block 720 further includes a first through hole 721 corresponding to the first forming punch 710. A center surface of the first forming punch 710 is directed at a center surface of the first through hole 721. In other words, the center surface of the first forming punch 710 is aligned with or coincides with the center surface of the first through hole 721. In a direction parallel to the first bearing surface 722, there is a first gap between an outer outline of the first forming punch 710 and a hole wall of the first through hole 721. The first gap may also be referred to as a concave-convex mold gap between the first forming punch 710 and the first lower forming block 720. The first gap may be less than thickness of the first stamping sheet metal 750.

The first lower stripper block 730 is disposed in the first through hole 721. A center surface of the first lower stripper block 730 is directed at the center surface of the first through hole 721. The first lower stripper block 730 may move along the center surface of the first through hole 721. There may be a gap between the first lower stripper block 730 and the hole wall of the first through hole 721, so that the first lower stripper block 730 may move relatively freely in the first through hole 721. The first lower stripper block 730 may include a first ejection surface 731 used to eject the first stamping sheet metal 750 out of the first through hole 721. The first ejection surface 731 may be a surface that is of the first lower stripper block 730 and that faces the first forming punch 710.

The first retainer plate 740 may be disposed opposite to the first lower forming block 720. The first retainer plate 740 is located on a side that is of the first stamping sheet metal 750 and that is away from the first lower forming block 720. The first retainer plate 740 may include a second through hole 741. The first forming punch 710 may be disposed in the second through hole 741. A center surface of the second through hole 741 is directed at the center surface of the first forming punch 710. The first retainer plate 740 may move along the center surface of the second through hole 741. There may be a gap between a hole wall of the second through hole 741 and the first forming punch 710, so that the first forming punch 710 may move relatively freely in the second through hole 741.

In conclusion, the center surface of the first forming punch 710, the center surface of the first through hole 721, the center surface of the first lower stripper block 730, and the center surface of the second through hole 741 may coincide to form a unified center surface 760.

A figure on a left side of an arrow 1 in FIG. 7 shows a state in which the mold is not entirely closed. The first ejection surface 731 of the first lower stripper block 730 may be flush with the first bearing surface 722 of the first lower forming block 720. The first stamping sheet metal 750 may be placed on the first bearing surface 722, and is located between the first lower forming block 720 and the first forming punch 710. The first retainer plate 740 may be in contact with a side that is of the first stamping sheet metal 750 and that is away from the first lower stripper block 730. In a possible case, the first retainer plate 740 may apply pressure to the first stamping sheet metal 750, so that the first stamping sheet metal 750 is tightly pasted on the first bearing surface 722. There may be a spacing distance between the first stamping surface 712 of the first forming punch 710 and the first stamping sheet metal 750.

Then, the first forming punch 710 may move toward the first lower stripper block 730 along the center surface of the first forming punch 710. A figure on a right side of the arrow 1 in FIG. 7 shows a state in which the mold is entirely closed.

The first forming punch 710 may be located outside the first through hole 721 of the first lower forming block 720. A spacing between the first stamping surface 712 of the first forming punch 710 and the first bearing surface 722 of the first lower stripper block 730 may be less than the thickness of the first stamping sheet metal 750. A spacing between the first stamping surface 712 of the first forming punch 710 and the first ejection surface 731 of the first lower stripper block 730 may be (approximately) equal to the thickness of the first stamping sheet metal 750. A material of the first stamping sheet metal 750 may be plastically deformed. The plastically deformed material may be, for example, a material near the first stamping surface 712.

Therefore, the first groove 6412 and the first protrusion 6411 described above may be manufactured on the first stamping sheet metal 750. A bottom part of the first groove 6412 may be in contact with the first stamping surface 712, and a top part of the first protrusion 6411 may be in contact with the first lower stripper block 730. After the mold is closed, the first groove 6412 is tightly pasted on an outer circumference of the first forming punch 710, and the first protrusion 6411 is tightly pasted on the hole wall of the first through hole 721. Therefore, the first forming punch 710 may include a part in contact with the first stamping sheet metal 750, and a shape of the part may be the same as or similar to a shape of the first groove 6412. The first through hole 721 may include a part in contact with the first stamping sheet metal 750, and a shape of the part may be the same as or similar to a shape of the first protrusion 6411. Because the first spacing is less than the thickness of the first stamping sheet metal 750, a difference between a maximum cross-sectional width of the first protrusion 6411 and a minimum cross-sectional width of the first groove 6412 may be less than twice the thickness of the first stamping sheet metal 750 (is approximately the thickness of the shielding case 630).

FIG. 8 is a schematic flowchart of a drawing deformation forming process. A mold used to manufacture the drawing deformation reinforcement structure 642 may include a second forming punch 810, a second lower forming block 820, a second lower stripper block 830, and a second retainer plate 840.

The second lower forming block 820 may include a second bearing surface 822 for placing a second stamping sheet metal 850. The second forming punch 810 may be disposed perpendicularly to the second bearing surface 822, and the second forming punch 810 may move in a direction perpendicular to the second bearing surface 822. A surface that is of the second forming punch 810 and that faces the second lower forming block 820 may be a second stamping surface 812. The second stamping surface 812 may be used to be in contact with a side that is of the second stamping sheet metal 850 and that is away from the second lower forming block 820.

The second lower forming block 820 further includes a third through hole 821 corresponding to the second forming punch 810. A center surface of the second forming punch 810 is directed at a center surface of the third through hole 821. In other words, the center surface of the second forming punch 810 is aligned with or coincides with the center surface of the third through hole 821. In a direction parallel to the second bearing surface 822, there is a second gap between an outer outline of the second forming punch 810 and a hole wall of the third through hole 821. The second gap may also be referred to as a concave-convex mold gap between the second forming punch 810 and the second lower forming block 820. The second gap may be greater than thickness of the second stamping sheet metal 850.

The second lower stripper block 830 may be disposed in the third through hole 821. A center surface of the second lower stripper block 830 is directed at the center surface of the third through hole 821. The second lower stripper block 830 may move along the center surface of the third through hole 821. There may be a gap between the second lower stripper block 830 and the hole wall of the third through hole 821, so that the second lower stripper block 830 may move relatively freely in the third through hole 821. The second lower stripper block 830 may include a second ejection surface 831 used to eject the second stamping sheet metal 850 out of the third through hole 821. The second ejection surface 831 may be a surface that is of the second lower stripper block 830 and that faces the second forming punch 810.

The second retainer plate 840 may be disposed opposite to the second lower forming block 820. The second retainer plate 840 is located on the side that is of the second stamping sheet metal 850 and that is away from the second lower forming block 820. The second retainer plate 840 may include a fourth through hole 841. The second forming punch 810 may be disposed in the fourth through hole 841. A center surface of the fourth through hole 841 is directed at the center surface of the second forming punch 810. The second retainer plate 840 may move along the center surface of the fourth through hole 841. There may be a gap between a hole wall of the fourth through hole 841 and the second forming punch 810, so that the second forming punch 810 may move relatively freely in the fourth through hole 841.

In conclusion, the center surface of the second forming punch 810, the center surface of the third through hole 821, the center surface of the second lower stripper block 830, and the center surface of the fourth through hole 841 may coincide to form a unified center surface 860.

A figure on a left side of an arrow 2 in FIG. 8 shows a state in which the mold is not entirely closed. The second ejection surface 831 of the second lower stripper block 830 may be flush with the second bearing surface 822 of the second lower forming block 820. The second stamping sheet metal 850 may be placed on the second bearing surface 822, and is located between the second lower forming block 820 and the second forming punch 810. The second retainer plate 840 may be in contact with a side that is of the second stamping sheet metal 850 and that is away from the second lower stripper block 830. In a possible case, the second retainer plate 840 may apply pressure to the second stamping sheet metal 850, so that the second stamping sheet metal 850 is tightly pasted on the second bearing surface 822. There may be a spacing distance between the second stamping surface 812 of the second forming punch 810 and the second stamping sheet metal 850.

Then, the second forming punch 810 may move toward the second lower stripper block 830 along the center surface of the second forming punch 810. A figure on a right side of the arrow 2 in FIG. 8 shows a state in which the mold is entirely closed.

The second forming punch 810 may be located outside the third through hole 821 of the second lower forming block 820. A spacing between the second stamping surface 812 of the second forming punch 810 and the second bearing surface 822 of the second lower stripper block 830 may be less than the thickness of the second stamping sheet metal 850. A spacing between the second stamping surface 812 of the second forming punch 810 and the second ejection surface 831 of the second lower stripper block 830 may be (approximately) equal to the thickness of the second stamping sheet metal 850. A material of the second stamping sheet metal 850 may be plastically deformed. The plastically deformed material may be, for example, a material near the second stamping surface 812.

Therefore, the second groove 6422 and the second protrusion 6421 described above may be manufactured on the second stamping sheet metal 850. A bottom part of the second groove 6422 may be in contact with the second stamping surface 812, and a top part of the second protrusion 6421 may be in contact with the second lower stripper block 830. After the mold is closed, the second groove 6422 is tightly pasted on an outer circumference of the second forming punch 810, and the second protrusion 6421 is tightly pasted on the hole wall of the third through hole 821. Therefore, the second forming punch 810 may include a part that is in contact with the second stamping sheet metal 850, and a shape of the part is the same as or similar to a shape of the second groove 6422. The third through hole 821 may include a part that is in contact with the second stamping sheet metal 850, and a shape of the part may be the same as or similar to a shape of the second protrusion 6421. Because the second spacing is greater than the thickness of the second stamping sheet metal 850, a difference between a maximum cross-sectional width of the second protrusion 6421 and a minimum cross-sectional width of the second groove 6422 may be greater than twice the thickness of the second stamping sheet metal 850 (is approximately the thickness of the shielding case 630).

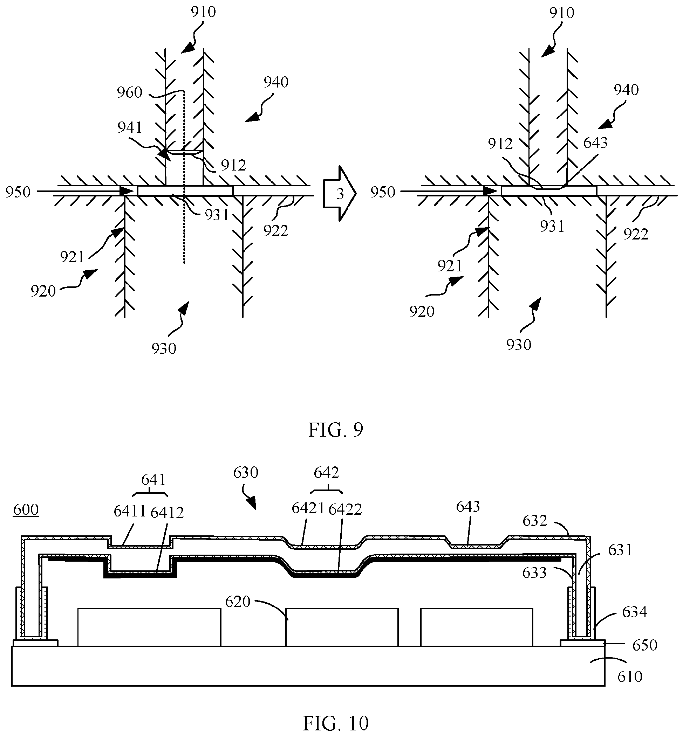

FIG. 9 is a schematic flowchart of a squeezing deformation forming process. A mold used to manufacture the squeezing deformation reinforcement structure 643 may include a third forming punch 910, a third lower forming block 920, a third lower stripper block 930, and a third retainer plate 940.

The third lower forming block 920 may include a third bearing surface 922 for placing a third stamping sheet metal 950. The third forming punch 910 may be disposed perpendicularly to the third bearing surface 922, and the third forming punch 910 may move in a direction perpendicular to the third bearing surface 922. A surface that is of the third forming punch 910 and that faces the third lower forming block 920 may be a third stamping surface 912. The third stamping surface 912 may be used to be in contact with a side that is of the third stamping sheet metal 950 and that is away from the third lower forming block 920.

The third lower forming block 920 may further include a fifth through hole 921 corresponding to the third forming punch 910. A center surface of the third forming punch 910 is directed at a center surface of the fifth through hole 921. In other words, the center surface of the third forming punch 910 is aligned with or coincides with the center surface of the fifth through hole 921. In a direction parallel to the third bearing surface 922, there is a third gap between an outer outline of the third forming punch 910 and a hole wall of the fifth through hole 921. The third gap may also be referred to as a concave-convex mold gap between the third forming punch 910 and the third lower forming block 920. The third gap may be greater than thickness of the third stamping sheet metal 950.

The third lower stripper block 930 is disposed in the fifth through hole 921. A center surface of the third lower stripper block 930 is directed at the center surface of the fifth through hole 921. The third lower stripper block 930 may move along the center surface of the fifth through hole 921. There may be a gap between the third lower stripper block 930 and the hole wall of the fifth through hole 921, so that the third lower stripper block 930 may move relatively freely in the fifth through hole 921. The third lower stripper block 930 may include a third ejection surface 931 used to eject the third stamping sheet metal 950 out of the fifth through hole 921. The third ejection surface 931 may be a surface that is of the third lower stripper block 930 and that faces the third forming punch 910.

The third retainer plate 940 may be disposed opposite to the third lower forming block 920. The third retainer plate 940 is located on a side that is of the third stamping sheet metal 950 and that is away from the third lower forming block 920. The third retainer plate 940 may include a sixth through hole 941. The third forming punch 910 may be disposed in the sixth through hole 941. A center surface of the sixth through hole 941 is directed at the center surface of the third forming punch 910. The third retainer plate 940 may move along the center surface of the sixth through hole 941. There may be a gap between a hole wall of the sixth through hole 941 and the third forming punch 910, so that the third forming punch 910 may move relatively freely in the sixth through hole 941.

In conclusion, the center surface of the third forming punch 910, the center surface of the fifth through hole 921, the center surface of the third lower stripper block 930, and the center surface of the sixth through hole 941 may coincide to form a unified center surface 960.

A figure on a left side of an arrow 3 in FIG. 9 shows a state in which the mold is not entirely closed. A third ejection surface 931 of the third lower stripper block 930 may be flush with the third bearing surface 922 of the third lower forming block 920. The third stamping sheet metal 950 may be placed on the third bearing surface 922, and is located between the third lower forming block 920 and the third forming punch 910. The third retainer plate 940 may be in contact with a side that is of the third stamping sheet metal 950 and that is away from the third lower stripper block 930. In a possible case, the third retainer plate 940 may apply pressure to the third stamping sheet metal 950, so that the third stamping sheet metal 950 is tightly pasted on the third bearing surface 922. There may be a spacing distance between the third stamping surface 912 of the third forming punch 910 and the third stamping sheet metal 950.

Then, the third forming punch 910 may move toward the third lower stripper block 930 along the center surface of the third forming punch 910. A figure on a right side of the arrow 3 in FIG. 9 shows a state in which the mold is entirely closed.

The third forming punch 910 may be located outside the fifth through hole 921 of the third lower forming block 920. A spacing between the third stamping surface 912 of the third forming punch 910 and the third bearing surface 922 of the third lower stripper block 930 may be less than the thickness of the third stamping sheet metal 950. A spacing between the third stamping surface 912 of the third forming punch 910 and the third ejection surface 931 of the third lower stripper block 930 may be less than the thickness of the third stamping sheet metal 950. A material of the third stamping sheet metal 950 may be plastically deformed. The plastically deformed material may be, for example, a material near an outline of the third stamping surface 912.

Therefore, the squeezing deformation reinforcement structure 643 described above may be manufactured on the third stamping sheet metal 950. A groove bottom of the squeezing deformation reinforcement structure 643 may be in contact with the third stamping surface 912. A side that is of the third stamping sheet metal 950 and that is away from the squeezing deformation reinforcement structure 643 may be in contact with the third lower stripper block 930. The third bearing surface may be flush with the third ejection surface 931. After the mold is closed, the squeezing deformation reinforcement structure 643 may be tightly pasted on an outer circumference of the third forming punch 910, and a side that is of the third stamping sheet metal 950 and that is away from the squeezing deformation reinforcement structure 643 may be tightly pasted on the third ejection surface 931. Therefore, the third forming punch 910 may include a part that is in contact with the third stamping sheet metal 950. A shape of the part may be the same as or similar to a shape of the squeezing deformation reinforcement structure 643, and the shape of the squeezing deformation reinforcement structure 643 may be a groove shape. A side that is of the third stamping sheet metal 950 and that is away from the squeezing deformation reinforcement structure 643 may not include a protrusion.

For an aluminum alloy member with a product size of 30*25*0.15 (mm), Table 1 may display strength improvement effects of different deformation reinforcement structures for the shielding member.

**Table 1**

| | Conventional product | Semi-piercing deformation reinforcement structure | Drawing deformation reinforcement structure | Squeezing deformation reinforcement structure |
|---|---|---|---|---|
| Drop deformation amount (mm) | 1 | 0.92 | 0.82 | 0.80 |
| Strength improvement (%) | - | 8 | 18 | 20 |

FIG. 10 shows a circuit board assembly 600 provided in an embodiment of this application.

According to a first aspect, compared with the circuit board assembly 600 shown in FIG. 6, a deformation reinforcement structure shown in FIG. 10 has a different depression direction. As shown in FIG. 10, the depression direction of the deformation reinforcement structure is a direction approaching a circuit board 610 or an electronic element 620.

For example, a groove opening of a first groove 6412 is further away from the circuit board 610 or the electronic element 620 than a groove bottom of the first groove 6412, and a first protrusion 6411 is closer to the circuit board 610 or the electronic element 620 than the first groove 6412. For another example, a groove opening of a second groove 6422 is further away from the circuit board 610 or the electronic element 620 than a groove bottom of the second groove 6422, and a second protrusion 6421 is closer to the circuit board 610 or the electronic element 620 than the second groove 6422. For another example, a groove opening of a squeezing deformation reinforcement structure 643 is further away from the circuit board 610 or the electronic element 620 than a groove bottom of the squeezing deformation reinforcement structure 643.

In this case, an area with a minimum spacing between a shielding case 630 and the electronic element 620 may be located on a semi-piercing deformation reinforcement structure 641 or a drawing deformation reinforcement structure 642. In other words, when the depression direction of the deformation reinforcement structure is the direction approaching the circuit board 610 or the electronic element 620, the semi-piercing deformation reinforcement structure 641 or the drawing deformation reinforcement structure 642 may reduce a spacing between the shielding case 630 and the electronic element 620. For example, a spacing between the first protrusion 6411 and the electronic element 620 may be the minimum spacing between the shielding case 630 and the electronic element 620. For another example, a spacing between the second protrusion 6421 and the electronic element 620 may be the minimum spacing between the shielding case 630 and the electronic element 620. The squeezing deformation reinforcement structure 643 generally does not reduce the spacing between the shielding case 630 and the electronic element 620.

In addition, if another component is disposed on a side that is of the shielding case 630 and that is away from the electronic element 620 or the circuit board 610, the semi-piercing deformation reinforcement structure 641, the drawing deformation reinforcement structure 642, and the squeezing deformation reinforcement structure 643 generally do not reduce a spacing between the shielding case 630 and the another component.

According to a second aspect, compared with the circuit board assembly 600 shown in FIG. 6, the shielding case 630 shown in FIG. 10 is fastened on the circuit board 610 through soldering in a different manner. An overall structure of the shielding case 630 shown in FIG. 10 may be, for example, the shielding case 303 shown in FIG. 4.

A first soldering layer 634 of the shielding case 630 may wrap a side that is of a first nickel-plated layer 633 and that is away from a shielding case substrate 631 and a side that is of a second nickel-plated layer 632 and that is away from the shielding case substrate 631. The first soldering layer 634 may wrap a second partial area of the first nickel-plated layer 633, a third partial area of the second nickel-plated layer 632, and the shielding case substrate 631 connected between the second partial area and the third partial area. A side that is of the first soldering layer 634 and that is away from the shielding case substrate 631 is used to be fastened on a pad 650 of the first circuit board 610 through soldering. For example, the first soldering layer 634 may be divided into an area in contact with the first nickel-plated layer 633, an area in contact with the shielding case substrate 631, and an area in contact with the second nickel-plated layer 632. The area that is in the first soldering layer 634 and that is in contact with the shielding case substrate 631 may be used to be fastened on the first circuit board 610 through soldering.

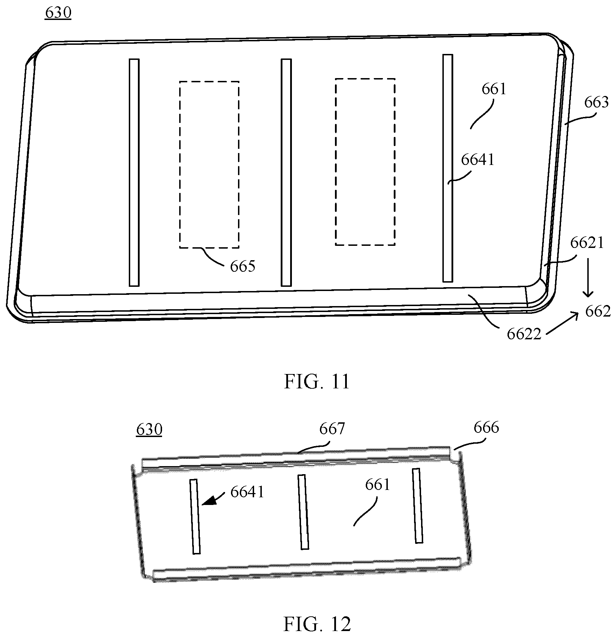

A plurality of arrangement forms of the deformation reinforcement structure provided in embodiments of this application are described below with reference to FIG. 11 to FIG. 20.

A shielding case 630 shown in FIG. 11 may include a shielding cover 661, a shielding wall 662, and a shielding base 663. The shielding base 663 may be configured to fasten the shielding case 630 on a circuit board 610 through soldering. The shielding cover 661 may be disposed in parallel to the circuit board 610. The shielding wall 662 may be disposed perpendicularly to the shielding cover 661. The shielding wall 662 may surround the shielding cover 661. The shielding wall 662 may be connected between the shielding cover 661 and the shielding base 663.

One or more first deformation reinforcement structures 6641 may be disposed at intervals on a part of the shielding cover 661. The first deformation reinforcement structure 6641 may be any one of the deformation reinforcement structures shown in FIG. 6 or FIG. 10. The shielding wall 662 may have two relatively short first shielding edges 6621 and two relatively long second shielding edges 6622. The two first shielding edges 6621 are disposed parallel to each other. The two second shielding edges 6622 are disposed parallel to each other. The first shielding edge 6621 may be disposed perpendicularly to the second shielding edge 6622. The two first shielding edges 6621 are connected to the two second shielding edges 6622 to form an annular shielding wall 662. The first deformation reinforcement structure 6641 may be disposed in parallel to the first shielding edge 6621. A plurality of first deformation reinforcement structures 6641 may be disposed at intervals along the second shielding edge 6622.

The shielding cover 661 shown in FIG. 11 includes a plurality of first deformation reinforcement structures 6641 disposed in parallel to a shorter edge. Therefore, the shielding case 630 is relatively susceptible to deformation due to external force in an area that is relatively far away from the first deformation reinforcement structure 6641 and the shielding wall 662. For example, the shielding case 630 may include a first target area 665, and a shortest distance between any position in the first target area 665 and any first deformation reinforcement structure 6641 or the shielding wall 662 is greater than a first preset distance threshold. The first target area 665 may be, for example, an area surrounded by dashed lines in FIG. 11.

For example, an electronic element 620 may be disposed at a position away from the first target area 665. For example, a projection area of the electronic element 620 on the circuit board 610 may be located outside a projection area of the first target area 665 on the circuit board 610. For another example, the projection area of the electronic element 620 on the circuit board 610 and a projection area of the first deformation reinforcement structure 6641 on the circuit board 610 at least partially cross each other.

A difference between a shielding case 630 shown in FIG. 12 and the shielding case 630 shown in FIG. 11 includes: An overall structure of the shielding case 630 shown in FIG. 12 is different from an overall structure of the shielding case 630 shown in FIG. 11. The shielding case 630 shown in FIG. 12 may include a shielding cover 661 and a plurality of shielding outer walls 667. One end of the shielding outer wall 667 is used to be fastened on a circuit board 610 through soldering. The other end of the shielding outer wall 667 is connected to an edge of the shielding cover 661. The shielding outer wall 667 may be disposed perpendicularly to the shielding cover 661. The plurality of shielding outer walls 667 are disposed around the shielding cover 661. Different shielding outer walls 667 may be connected to different areas on the edge of the shielding cover 661. There may be a partition 666 between two adjacent shielding outer walls 667. In other words, the first deformation reinforcement structure 6641 shown in FIG. 11 may be further disposed on the shielding case 630 shown in FIG. 4, to form the shielding case 630 shown in FIG. 12.

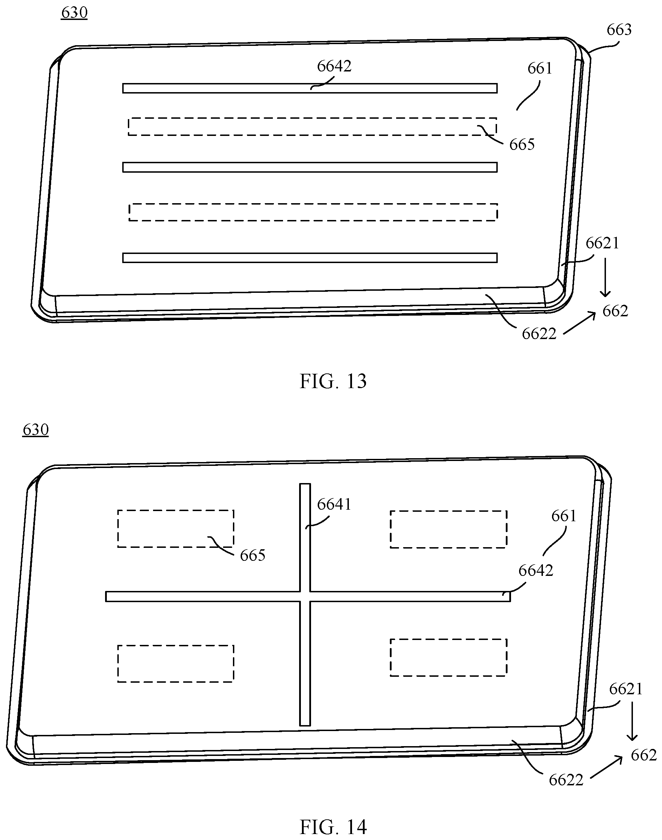

A difference between a shielding case 630 shown in FIG. 13 and the shielding case 630 shown in FIG. 11 includes: An arrangement form of a deformation reinforcement structure shown in FIG. 13 is different from an arrangement form of the deformation reinforcement structure shown in FIG. 11. A shielding cover 661 shown in FIG. 13 may include one or more second deformation reinforcement structures 6642. The second deformation reinforcement structure 6642 may be disposed in parallel to a second shielding edge 6622 (a relatively long shielding edge). A plurality of second deformation reinforcement structures 6642 may be disposed at intervals along a first shielding edge 6621 (a relatively short shielding edge).

The shielding case 630 is relatively susceptible to deformation due to external force in an area that is relatively far away from the second deformation reinforcement structure 6642 and a shielding wall 662. For example, the shielding case 630 may include a second target area 665, and a shortest distance between any position in the second target area 665 and any second deformation reinforcement structure 6642 or the shielding wall 662 is greater than a second preset distance threshold. The second target area 665 may be, for example, an area surrounded by dashed lines in FIG. 13.

For example, an electronic element 620 may be disposed at a position away from the second target area 665. For example, a projection area of the electronic element 620 on a circuit board 610 may be located outside a projection area of the second target area 665 on the circuit board 610. For another example, the projection area of the electronic element 620 on the circuit board 610 and a projection area of the second deformation reinforcement structure 6642 on the circuit board 610 at least partially cross each other.

In addition, the second deformation reinforcement structure 6642 shown in FIG. 13 may alternatively be disposed on the shielding case 630 shown in FIG. 4.

A difference between a shielding case 630 shown in FIG. 14 and the shielding case 630 shown in FIG. 11 includes: A deformation reinforcement structure shown in FIG. 14 is different from the deformation reinforcement structure shown in FIG. 11. A shielding cover 661 shown in FIG. 14 may include a first deformation reinforcement structure 6641 disposed in parallel to a first shielding edge 6621 (a relatively short shielding edge) and a second deformation reinforcement structure 6642 disposed in parallel to a second shielding edge 6622 (a relatively long shielding edge). The first deformation reinforcement structure 6641 and the second deformation reinforcement structure 6642 may cross each other to form a cross-shaped deformation reinforcement structure. Optionally, a center of the first deformation reinforcement structure 6641 overlaps a center of the second deformation reinforcement structure 6642.

The shielding case 630 is relatively susceptible to deformation due to external force in an area that is relatively far away from the first deformation reinforcement structure 6641, the second deformation reinforcement structure 6642, and a shielding wall 662. For example, the shielding case 630 may include a third target area 665, and a shortest distance between any position in the third target area 665 and any deformation reinforcement structure or the shielding wall 662 is greater than a third preset distance threshold. The third target area 665 may be, for example, an area surrounded by dashed lines in FIG. 14.

For example, an electronic element 620 may be disposed at a position away from the third target area 665. For example, a projection area of the electronic element 620 on a circuit board 610 may be located outside a projection area of the third target area 665 on the circuit board 610. For another example, projection areas of the first deformation reinforcement structure 6641 and the second deformation reinforcement structure 6642 on the circuit board 610 and a projection area of the electronic element 620 on the circuit board 610 at least partially cross each other.

In addition, the deformation reinforcement structure shown in FIG. 14 may alternatively be disposed on the shielding case 630 shown in FIG. 4.

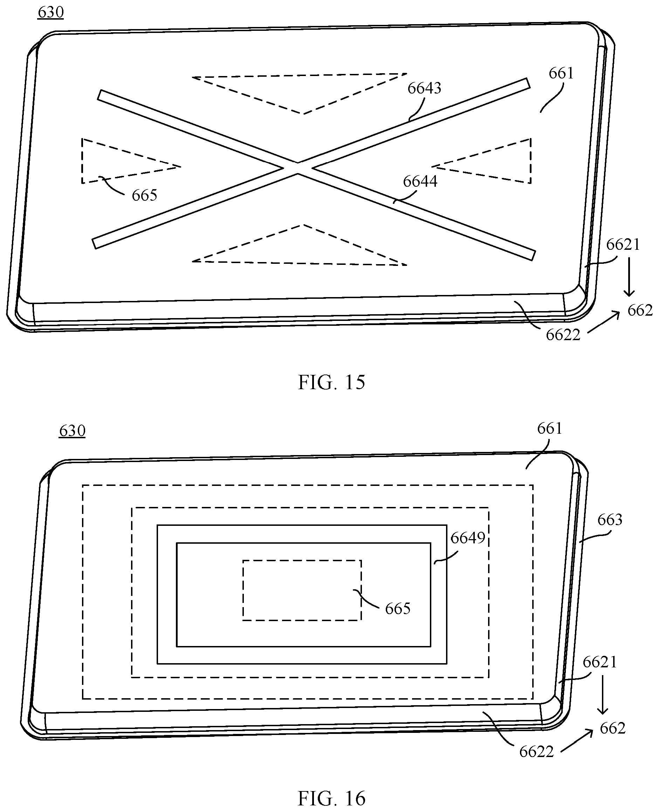

A difference between a shielding case 630 shown in FIG. 15 and the shielding case 630 shown in FIG. 11 includes: A deformation reinforcement structure shown in FIG. 15 is different from the deformation reinforcement structure shown in FIG. 11. A shielding cover 661 shown in FIG. 15 may include a third deformation reinforcement structure 6643 that is disposed obliquely relative to both a first shielding edge 6621 (a relatively short shielding edge) and a second shielding edge 6622 (a relatively long shielding edge) and a fourth deformation reinforcement structure 6644 that is disposed obliquely relative to both the first shielding edge 6621 (the relatively short shielding edge) and the second shielding edge 6622 (the relatively long shielding edge), and an inclination angle of the third deformation reinforcement structure 6643 relative to the first shielding edge 6621 (or the second shielding edge 6622) is different from an inclination angle of the fourth deformation reinforcement structure 6644 relative to the first shielding edge 6621 (or the second shielding edge 6622). The third deformation reinforcement structure 6643 and the fourth deformation reinforcement structure 6644 may cross each other to form an X-shaped deformation reinforcement structure. Optionally, a center of the third deformation reinforcement structure 6643 overlaps a center of the fourth deformation reinforcement structure 6644.

The shielding case 630 is relatively susceptible to deformation due to external force in an area that is relatively far away from the third deformation reinforcement structure 6643, the fourth deformation reinforcement structure 6644, and a shielding wall 662. For example, the shielding case 630 may include a fourth target area 665, and a shortest distance between any position in the fourth target area 665 and any deformation reinforcement structure or the shielding wall 662 is greater than a fourth preset distance threshold. The fourth target area 665 may be, for example, an area surrounded by dashed lines in FIG. 15.

For example, an electronic element 620 may be disposed at a position away from the fourth target area 665. For example, a projection area of the electronic element 620 on a circuit board 610 may be located outside a projection area of the fourth target area 665 on the circuit board 610. For another example, projection areas of the third deformation reinforcement structure 6643 and the fourth deformation reinforcement structure 6644 on the circuit board 610 and a projection area of the electronic element 620 on the circuit board 610 at least partially cross each other.

In addition, the deformation reinforcement structure shown in FIG. 15 may alternatively be disposed on the shielding case 630 shown in FIG. 4.

A difference between a shielding case 630 shown in FIG. 16 and the shielding case 630 shown in FIG. 11 includes: A deformation reinforcement structure shown in FIG. 16 is different from the deformation reinforcement structure shown in FIG. 11. A shielding cover 661 shown in FIG. 16 may include an annular deformation reinforcement structure 6649. As shown in FIG. 16, a shape of the annular deformation reinforcement structure 6649 may be, for example, a rectangle, a circle, a triangle, a polygon, or an oval. The overall annular deformation reinforcement structure 6649 may be any one of the deformation reinforcement structures shown in FIG. 6 or FIG. 10. Alternatively, the annular deformation reinforcement structure 6649 may include a plurality of types of deformation reinforcement structures shown in FIG. 6 or FIG. 10. In other words, a deformation reinforcement structure of the annular deformation reinforcement structure 6649 in a first partial area is different from a deformation reinforcement structure in a second partial area. The annular deformation reinforcement structure 6649 may include, for example, an annular semi-piercing deformation reinforcement structure, an annular drawing deformation reinforcement structure, and an annular squeezing deformation reinforcement structure.

The annular semi-piercing deformation reinforcement structure may include a first annular protrusion and a first annular groove corresponding to the first annular protrusion, a maximum cross-sectional width of the first annular protrusion is greater than a minimum cross-sectional width of the first annular protrusion, and a difference between the maximum cross-sectional width of the first annular protrusion and the minimum cross-sectional width of the first annular groove is less than or equal to twice thickness of the shielding cover.

The annular drawing deformation reinforcement structure may include a second annular protrusion and a second annular groove corresponding to the second annular protrusion, a maximum cross-sectional width of the second annular protrusion is greater than a minimum cross-sectional width of the second annular groove, and a difference between the maximum cross-sectional width of the second annular protrusion and the minimum cross-sectional width of the second annular groove is less than or equal to twice the thickness of the shielding cover.

A shape of the annular squeezing deformation reinforcement structure may be an annular groove, and thickness of the shielding cover at the squeezing deformation reinforcement structure may be less than average thickness of the shielding cover.

The shielding case 630 is relatively susceptible to deformation due to external force in an area that is relatively far away from the annular deformation reinforcement structure 6649 and a shielding wall 662. For example, the shielding case 630 may include a ninth target area 665, and a shortest distance between any position in the ninth target area 665 and the annular deformation reinforcement structure 6649 or the shielding wall 662 is greater than a ninth preset distance threshold. The ninth target area 665 may be, for example, an area surrounded by dashed lines in FIG. 16.

For example, an electronic element 620 may be disposed at a position away from the ninth target area 665. For example, a projection area of the electronic element 620 on a circuit board 610 may be located outside a projection area of the ninth target area 665 on the circuit board 610.

In addition, the deformation reinforcement structure shown in FIG. 16 may alternatively be disposed on the shielding case 630 shown in FIG. 4.

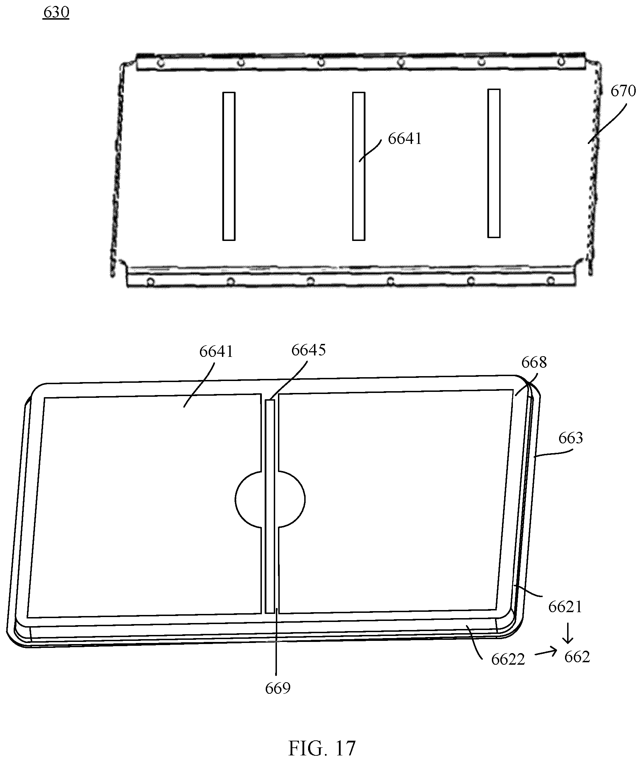

A difference between a shielding case 630 shown in FIG. 17 and the shielding case 630 shown in FIG. 11 includes: An overall structure of the shielding case 630 shown in FIG. 17 is different from an overall structure of the shielding case 630 shown in FIG. 11. In other words, the first deformation reinforcement structure 6641 shown in FIG. 11 may be further disposed on the shielding case 630 shown in FIG. 5, to form the shielding case 630 shown in FIG. 17. The shielding case 630 shown in FIG. 17 may include a shielding frame 668, a separable shielding cover 670, a shielding wall 662, and a shielding base 663. The shielding base 663 may be configured to fasten the shielding case 630 on a circuit board 610 through soldering.

The shielding frame 668 may include a shielding strip 669, and the shielding strip 669 is located in an area surrounded by the shielding frame 668. In a manner of placing in parallel to the circuit board 610, the separable shielding cover 670 may be disposed in the area surrounded by the shielding frame 668. After the shielding frame 668 and the separable shielding cover 670 are assembled, a shielding cover may be formed, and the shielding cover may be disposed in parallel to the circuit board 610. The shielding wall 662 may be disposed perpendicularly to the circuit board 610.

The shielding wall 662 may surround the shielding frame 668. The shielding wall 662 may be connected between the shielding frame 668 and the shielding base 663. The shielding wall 662 may have two relatively short first shielding edges 6621 and two relatively long second shielding edges 6622. The two first shielding edges 6621 are disposed parallel to each other. The two second shielding edges 6622 are disposed parallel to each other. The first shielding edge 6621 may be disposed perpendicularly to the second shielding edge 6622. The two first shielding edges 6621 are connected to the two second shielding edges 6622 to form an annular shielding wall 662.

The separable shielding cover 670 shown in FIG. 17 may include one or more first deformation reinforcement structures 6641 disposed in parallel to the first shielding edge 6621, and the first deformation reinforcement structure 6641 may be disposed in parallel to the first shielding edge 6621 (a relatively short shielding edge). A plurality of first deformation reinforcement structures 6641 may be disposed at intervals along the second shielding edge 6622 (a relatively long shielding edge). One or more fifth deformation reinforcement structures 6645 may be disposed on the shielding strip 669. The fifth deformation reinforcement structure 6645 may be disposed in parallel to the shielding strip 669.

The separable shielding cover 670 is relatively susceptible to contact with an electronic element due to external force in an area that is relatively far away from the first deformation reinforcement structure 6641, the shielding wall 662, and the shielding strip 669. For example, the separable shielding cover 670 may include a fifth target area, and a shortest distance between any position in the fifth target area and any first deformation reinforcement structure 6641, the shielding strip 669, or the shielding wall 662 is greater than a fifth preset distance threshold.

The shielding strip 669 is relatively susceptible to deformation due to external force in an area that is relatively far away from the fifth deformation reinforcement structure 6645 and the shielding wall 662. For example, the shielding strip 669 may include a sixth target area, and a shortest distance between any position in the sixth target area and any fifth deformation reinforcement structure 6645 or the shielding wall 662 is greater than a sixth preset distance threshold.

The electronic element 620 may be disposed, for example, at a position away from the fifth target area and the sixth target area.

For a manner of disposing the deformation reinforcement structure on the separable shielding cover 670, refer to the embodiments shown in FIG. 11 to FIG. 15. Details are not described herein again.

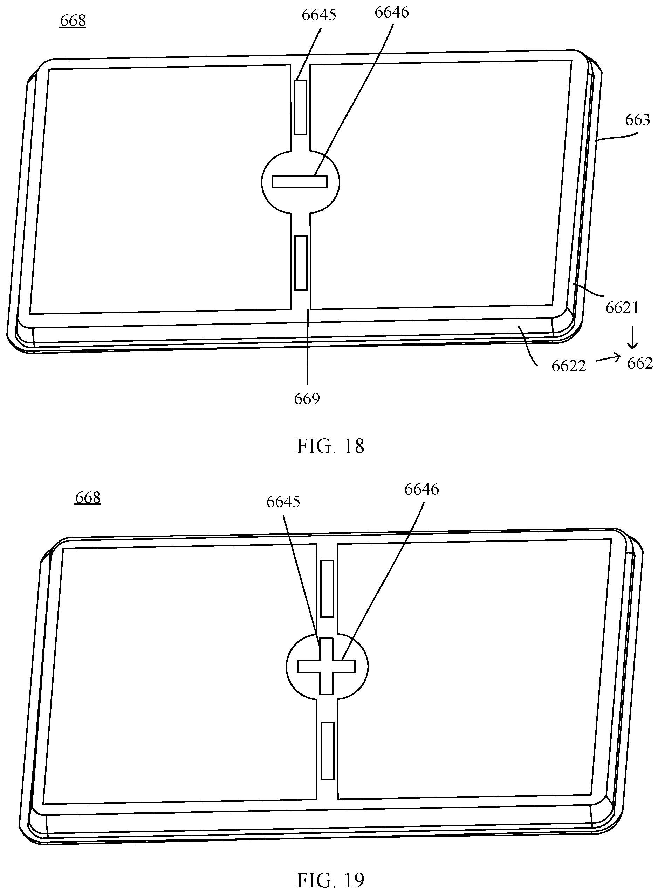

A difference between a shielding case 630 shown in FIG. 18 and the shielding case 630 shown in FIG. 17 includes: A deformation reinforcement structure shown in FIG. 18 is different from the deformation reinforcement structure shown in FIG. 17. A shielding strip 669 shown in FIG. 18 may include one or more sixth deformation reinforcement structures 6646 and one or more fifth deformation reinforcement structures 6645. The fifth deformation reinforcement structure 6645 may be disposed in parallel to the shielding strip 669. The sixth deformation reinforcement structure 6646 may be disposed perpendicularly to the shielding strip 669.

The shielding strip 669 is relatively susceptible to deformation due to external force in an area that is relatively far away from the fifth deformation reinforcement structure 6645, the sixth deformation reinforcement structure 6646, and a shielding wall 662. For example, the shielding strip 669 may include a seventh target area, and a shortest distance between any position in the seventh target area and any deformation reinforcement structure or the shielding wall 662 is greater than a seventh preset distance threshold. An electronic element 620 may be disposed, for example, at a position away from the seventh target area.

Optionally, as shown in FIG. 19, the fifth deformation reinforcement structure 6645 and the sixth deformation reinforcement structure 6646 may cross each other to form a cross-shaped deformation reinforcement structure. Optionally, a center of the fifth deformation reinforcement structure 6645 may overlap a center of the sixth deformation reinforcement structure 6646.

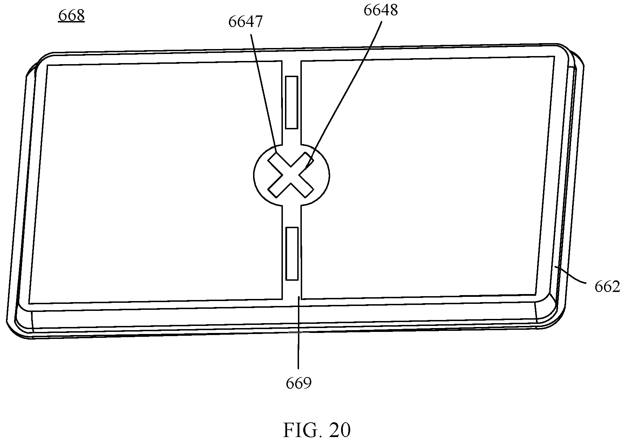

A difference between a shielding case 630 shown in FIG. 20 and the shielding case 630 shown in FIG. 17 includes: A deformation reinforcement structure shown in FIG. 20 is different from the deformation reinforcement structure shown in FIG. 17. A shielding strip 669 shown in FIG. 20 may include a seventh deformation reinforcement structure 6647 and an eighth deformation reinforcement structure 6648. Both the seventh deformation reinforcement structure 6647 and the eighth deformation reinforcement structure 6648 may be disposed obliquely relative to the shielding strip 669, and a degree of inclination of the seventh deformation reinforcement structure 6647 relative to the shielding strip 669 is different from a degree of inclination of the eighth deformation reinforcement structure 6648 relative to the shielding strip 669. The seventh deformation reinforcement structure 6647 and the eighth deformation reinforcement structure 6648 may cross each other to form an X-shaped deformation reinforcement structure. Optionally, a center of the seventh deformation reinforcement structure 6647 may overlap a center of the eighth deformation reinforcement structure 6648.

The shielding strip 669 is relatively susceptible to deformation due to external force in an area that is relatively far away from the seventh deformation reinforcement structure 6647, the eighth deformation reinforcement structure 6648, and a shielding wall 662. For example, the shielding case 630 may include an eighth target area, and a shortest distance between any position in the eighth target area and any deformation reinforcement structure or the shielding wall 662 is greater than an eighth preset distance threshold. An electronic element 620 may be disposed, for example, at a position away from the eighth target area.

It should be noted that a schematic cross-sectional diagram of the deformation reinforcement structure is shown in the embodiments shown in FIG. 6 and FIG. 10, and arrangement manners of the deformation reinforcement structure on a plane perpendicular to a cross-section are shown in FIG. 11 to FIG. 20.

It should be understood that, in a possible case, a size of the deformation reinforcement structure in a first direction may be understood as a length of the deformation reinforcement structure, and the first direction is perpendicular to a cross-section of the deformation reinforcement structure; and a size of the deformation reinforcement structure in a second direction may be understood as a cross-sectional width of the deformation reinforcement structure, the second direction is parallel to the cross-section of the deformation reinforcement structure, and both the first direction and the second direction may be perpendicular to a depression or protrusion direction of the deformation reinforcement structure. The length of the deformation reinforcement structure may be greater than or equal to the cross-sectional width of the deformation reinforcement structure. For example, a shape of a groove in the deformation reinforcement structure may be a cylinder, a truncated cone, a terrace, a cuboid, or the like. For another example, a difference between the length of the deformation reinforcement structure and the cross-sectional width of the deformation reinforcement structure is less than a preset threshold.

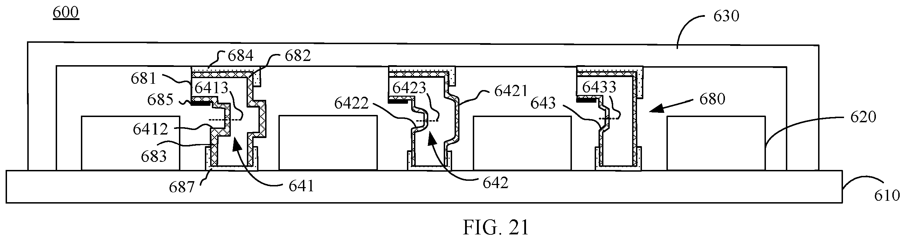

An embodiment in which the deformation reinforcement structure is disposed on a shielding inner wall 680 is described below with reference to embodiments shown in FIG. 21 to FIG. 23.

FIG. 21 shows a circuit board assembly 600 provided in an embodiment of this application. The circuit board assembly 600 includes a circuit board 610 and a plurality of electronic elements 620. The electronic element 620 may be fastened on the circuit board 610 through soldering. The circuit board assembly 600 may further include a shielding case 630. The shielding case 630 may be fastened on the circuit board 610 through soldering. The plurality of electronic elements 620 may be disposed in a cavity formed between the shielding case 630 and the circuit board 610. An overall structure of the shielding case 630 shown in FIG. 21 may be, for example, the shielding case 303 shown in FIG. 3 to FIG. 5.

The circuit board assembly 600 may further include one or more shielding inner walls 680. The shielding inner wall 680 may be disposed in a spacing area between two adjacent electronic elements 620. The shielding inner wall 680 may include a first area disposed in parallel to the shielding case 630 and a second area disposed perpendicularly to the shielding case 630. The first area may be used to be fastened on the shielding case 630 through soldering. An end that is of the second area and that is away from the first area may be fastened on the circuit board 610 through soldering.

The shielding inner wall 680 may include a shielding inner wall substrate 681, a third nickel-plated layer 682, a fourth nickel-plated layer 683, a second soldering layer 687, a third soldering layer 684, and a second insulation layer 685. A material of the shielding inner wall substrate 681 may be, for example, aluminum alloy or stainless steel. In this application, the soldering layer may be, for example, a tin-plated layer, a gold-plated layer, or the like.

The third nickel-plated layer 682 and the fourth nickel-plated layer 683 may separately wrap two sides of the shielding inner wall substrate 681. The third nickel-plated layer 682 may be closer to the shielding case 630 than the fourth nickel-plated layer 683. The second soldering layer 687 may wrap a fourth partial area of the third nickel-plated layer 682, the second soldering layer 687 may wrap a fifth partial area of the fourth nickel-plated layer 683, and may further wrap the shielding inner wall substrate 681 located between the fourth partial area and the fifth partial area. The shielding inner wall 680 may be fastened on the circuit board 610 through soldering by using the second soldering layer 687. The third soldering layer 684 may wrap the third nickel-plated layer 682 in a seventh partial area of the shielding inner wall 680, and the seventh partial area may include a first area. The third soldering layer 684 may wrap a side that is of the third nickel-plated layer 682 and that is away from the shielding inner wall substrate 681.

The second insulation layer 685 may be located at a position close to the first area, and wraps a side that is of the fourth nickel-plated layer 683 and that is away from the shielding inner wall substrate 681. The second insulation layer 685 may wrap a sixth partial area of the fourth nickel-plated layer 683, and the fifth partial area is different from the sixth partial area. In other words, the sixth partial area is an area other than the fifth partial area on the fourth nickel-plated layer 683.

The shielding inner wall 680 may further include one or more deformation reinforcement structures. The deformation reinforcement structure may be, for example, the semi-piercing deformation reinforcement structure 641, the drawing deformation reinforcement structure 642, or the squeezing deformation reinforcement structure 643 shown in FIG. 6. The semi-piercing deformation reinforcement structure 641 is disposed on the shielding inner wall 680, and a center surface 6413 of a first groove 6412 may be disposed in parallel to the shielding case 630 or the circuit board 610. The drawing deformation reinforcement structure 642 is disposed on the shielding inner wall 680, and a center surface 6423 of a second groove 6422 may be disposed in parallel to the shielding case 630 or the circuit board 610. The squeezing deformation reinforcement structure 643 is disposed on the shielding inner wall 680, and a center surface 6433 of the squeezing deformation reinforcement structure 643 may be disposed in parallel to the shielding case 630 or the circuit board 610.

In addition, as shown in FIG. 21, the semi-piercing deformation reinforcement structure 641 may include a first protrusion 6411, and the drawing deformation reinforcement structure 642 may include a second protrusion 6421. Therefore, the semi-piercing deformation reinforcement structure 641 and the drawing deformation reinforcement structure 642 may reduce a spacing between the shielding inner wall 680 and the electronic element 620. The squeezing deformation reinforcement structure 643 generally does not reduce the spacing between the shielding case 630 and the electronic element 620.

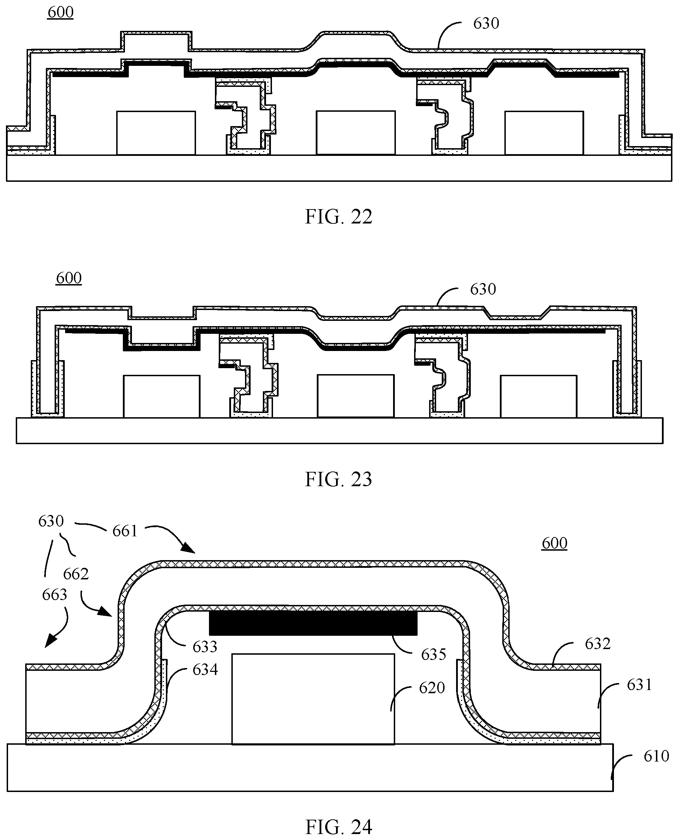

FIG. 22 shows a circuit board assembly 600 provided in an embodiment of this application. A difference from the circuit board assembly 600 shown in FIG. 21 includes: The circuit board assembly 600 shown in FIG. 22 includes the shielding case 630 shown in FIG. 6. A structure of the shielding case 630 shown in FIG. 6 is described above by using the embodiment shown in FIG. 6. Details are not described herein again.

FIG. 23 shows a circuit board assembly 600 provided in an embodiment of this application. A difference from the circuit board assembly 600 shown in FIG. 21 includes: The circuit board assembly 600 shown in FIG. 23 includes the shielding case 630 shown in FIG. 10. A structure of the shielding case 630 shown in FIG. 10 is described above by using the embodiment shown in FIG. 10. Details are not described herein again.

FIG. 24 shows a circuit board assembly 600 provided in an embodiment of this application.

The circuit board assembly 600 may include a circuit board 610, an electronic element 620, and a shielding case 630. The electronic element 620 may be fastened on the circuit board 610 through soldering. The shielding case 630 may be fastened on the circuit board 610 through soldering. The electronic element 620 may be disposed in a cavity formed between the shielding case 630 and the circuit board 610. An overall structure of the shielding case 630 shown in FIG. 24 may be, for example, the shielding case 303 shown in FIG. 3 and FIG. 5.

The shielding case 630 may be divided into a shielding cover 661, a shielding wall 662, and a shielding base 663 based on position areas. The shielding base 663 may be configured to fasten the shielding case 630 on a circuit board 610 through soldering. The shielding cover 661 may be disposed in parallel to the circuit board 610. The shielding wall 662 may surround the shielding cover 661. The shielding wall 662 may be disposed perpendicularly to the shielding cover 661. The shielding wall 662 may be connected between the shielding cover 661 and the shielding base 663. The shielding case 630 shown in FIG. 24 may be obtained, for example, by using a drawing forming process.

The shielding case 630 may include a shielding case substrate 631, a first nickel-plated layer 633, and a second nickel-plated layer 632 based on material types. A material of the shielding case substrate 631 may be, for example, aluminum alloy or stainless steel. The first nickel-plated layer 633 and the second nickel-plated layer 632 may separately wrap two sides of the shielding case substrate 631. The first nickel-plated layer 633 may be wrapped on sides that are of the shielding cover 661, the shielding wall 662, and the shielding base 663 and that are relatively close to the circuit board 610. The second nickel-plated layer 632 may be wrapped on sides that are of the shielding cover 661, the shielding wall 662, and the shielding base 663 and that are relatively far away from the circuit board 610.

The shielding case 630 may further include a first soldering layer 634 and a first insulation layer 635. As shown in FIG. 24, the first insulation layer 635 may wrap a first partial area of the first nickel-plated layer 633. The first insulation layer 635 may be located on a side that is of the first nickel-plated layer 633 and that is close to the circuit board 610. The first soldering layer 634 may wrap a second partial area of the first nickel-plated layer 633. The first soldering layer 634 may be located on the side that is of the first nickel-plated layer 633 and that is close to the circuit board 610. The second partial area is an area other than the first partial area on the first nickel-plated layer 633. In other words, the first insulation layer 635 and the first soldering layer 634 may be located on a same side of the first nickel-plated layer 633, and the first soldering layer 634 and the first insulation layer 635 separately wrap different areas of the first nickel-plated layer 633. An area that is of the first nickel-plated layer 633 and that is wrapped by the first soldering layer 634 and an area that is of the first nickel-plated layer 633 and that is wrapped by the first insulation layer 635 do not cross each other or are different from each other. The shielding case 630 may be soldered on the circuit board 610 by using the first soldering layer 634. In this application, the soldering layer may be, for example, a tin-plated layer, a gold-plated layer, or the like.

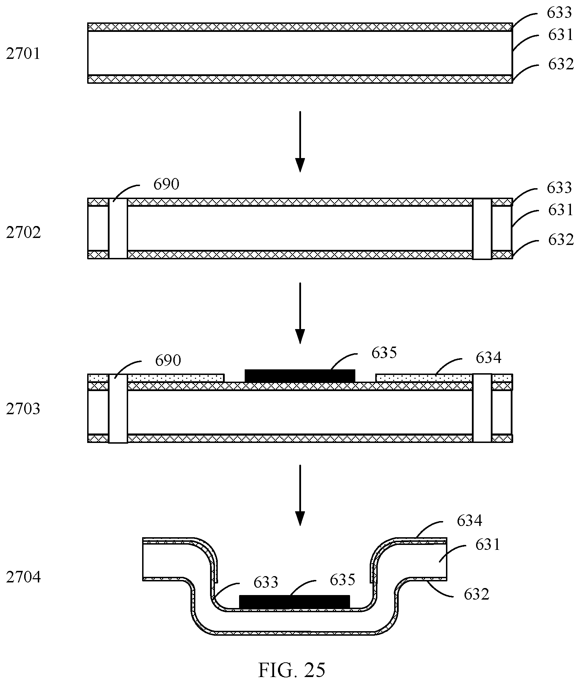

FIG. 25 is a schematic flowchart of a method for manufacturing a shielding case 630.

2701: Obtain a stamping sheet metal, where the stamping sheet metal includes a substrate, a first nickel-plated layer 633, and a second nickel-plated layer 632, and the first nickel-plated layer 633 and the second nickel-plated layer 632 are separately disposed on two sides of the substrate.

The substrate may be, for example, aluminum alloy or stainless steel.

A possible manner of obtaining the stamping sheet metal may be, for example, purchasing a stamping sheet metal that meets a requirement.

For example, another possible manner of obtaining the stamping sheet metal may include: obtaining a substrate, and manufacturing the first nickel-plated layer 633 and the second nickel-plated layer 632 on both sides of the substrate.

2702: Manufacture one or more positioning holes 690 on the stamping sheet metal.

Step 2702 may be an optional step. Manufacturing the positioning hole 690 helps improve position accuracy of a subsequent manufacturing process. A manner of manufacturing the positioning hole 690 may be, for example, drilling a hole or punching out the positioning hole 690 by using a mold.

2703: Paste a first insulation layer 635 in a first partial area of the first nickel-plated layer 633, and manufacture a first soldering layer 634 in a second partial area of the first nickel-plated layer 633, where the second partial area is an area other than the first partial area on the first nickel-plated layer 633.

As shown in FIG. 25, the first insulation layer 635 may be pasted in a central area of the stamping sheet metal, and the first soldering layer 634 may be manufactured in an edge area of the stamping sheet metal.

2704: Manufacture the stamping sheet metal into a specified shape of the shielding case 630 by using a drawing forming process. The manufactured stamping sheet metal includes a shielding cover 661, a shielding wall 662, and a shielding base 663. The shielding base 663 is configured to fasten the shielding case 630 on a circuit board 610 through soldering. The shielding cover 661 may be disposed in parallel to the circuit board 610. The shielding wall 662 surrounds the shielding cover 661. The shielding wall 662 may be disposed perpendicularly to the shielding cover 661. The shielding wall 662 is connected between the shielding cover 661 and the shielding base 663.

Optionally, an order of step 2704 and an order of step 2703 may be exchanged.

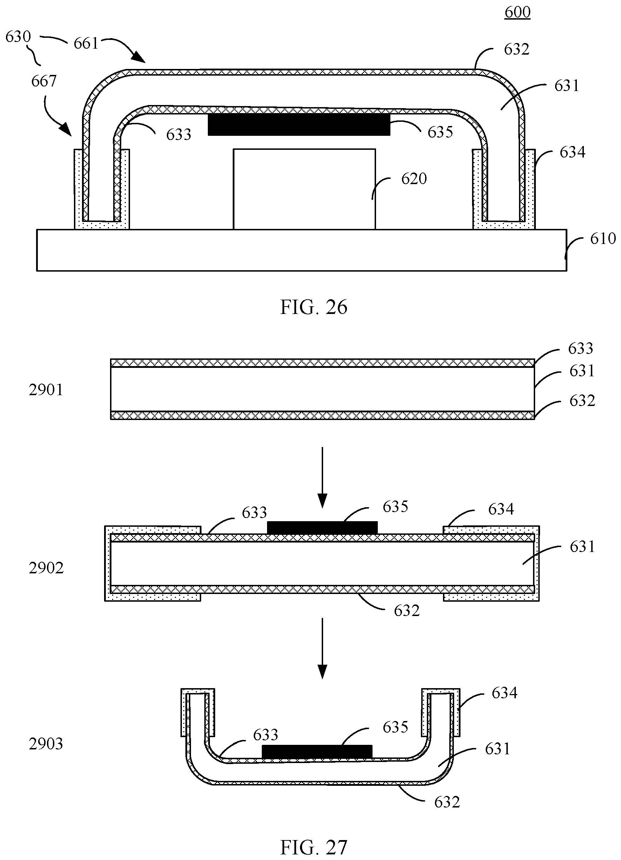

FIG. 26 shows a circuit board assembly 600 provided in an embodiment of this application.

The circuit board assembly 600 may include a circuit board 610, an electronic element 620, and a shielding case 630. The electronic element 620 may be fastened on the circuit board 610 through soldering. The shielding case 630 may be fastened on the circuit board 610 through soldering. The electronic element 620 may be disposed in a cavity formed between the shielding case 630 and the circuit board 610. An overall structure of the shielding case 630 shown in FIG. 26 may be, for example, the shielding case 303 shown in FIG. 4.

The shielding case 630 may be divided into a shielding cover 661 and a plurality of shielding outer walls 667 based on position areas. One end of the shielding outer wall 667 is used to be fastened on the circuit board 610 through soldering. The other end of the shielding outer wall 667 is connected to an edge of the shielding cover 661. The shielding outer wall 667 may be disposed perpendicularly to the shielding cover 661. The plurality of shielding outer walls 667 are disposed around the shielding cover 661. Different shielding outer walls 667 may be connected to different areas on the edge of the shielding cover 661. There may be a partition between two adjacent shielding outer walls 667. The shielding case 630 shown in FIG. 26 may be obtained, for example, by using a bending forming process.

The shielding case 630 may include a shielding case substrate 631, a first nickel-plated layer 633, and a second nickel-plated layer 632 based on material types. A material of the shielding case substrate 631 may be, for example, aluminum alloy or stainless steel. The first nickel-plated layer 633 and the second nickel-plated layer 632 may separately wrap two sides of the shielding case substrate 631. The first nickel-plated layer 633 may be wrapped on sides that are of the shielding cover 661 and the shielding outer wall 667 and that are relatively close to the circuit board 610. The second nickel-plated layer 632 may be wrapped on sides that are of the shielding cover 661 and the shielding outer wall 667 and that are relatively far away from the circuit board 610.

The shielding case 630 may further include a first soldering layer 634 and a first insulation layer 635. As shown in FIG. 26, the first insulation layer 635 may wrap a first partial area of the first nickel-plated layer 633. The first insulation layer 635 may be located on a side that is of the first nickel-plated layer 633 and that is close to the circuit board 610. The first soldering layer 634 may wrap a second partial area of the first nickel-plated layer 633, a third partial area of the second nickel-plated layer 632, and the shielding case substrate 631 connected between the second partial area and the third partial area. A side that is of the first soldering layer 634 and that is away from the shielding case substrate 631 is used to be fastened on a pad of the first circuit board 610 through soldering. In other words, the first soldering layer 634 may be divided into an area in contact with the first nickel-plated layer 633, an area in contact with the shielding case substrate 631, and an area in contact with the second nickel-plated layer 632. The area that is in the first soldering layer 634 and that is in contact with the shielding case substrate 631 may be used to be fastened on the first circuit board 610 through soldering. In addition, the second partial area is an area other than the first partial area on the first nickel-plated layer 633. In other words, the first soldering layer 634 and the first insulation layer 635 that are located on a same side of the first nickel-plated layer 633 separately wrap different areas of the first nickel-plated layer 633. An area that is of the first nickel-plated layer 633 and that is wrapped by the first soldering layer 634 and an area that is of the first nickel-plated layer 633 and that is wrapped by the first insulation layer 635 do not cross each other or are different from each other. In this application, the soldering layer may be, for example, a tin-plated layer, a gold-plated layer, or the like.

FIG. 27 is a schematic flowchart of a method for manufacturing a shielding case 630.

2901: Obtain a stamping sheet metal, where the stamping sheet metal includes a substrate, a first nickel-plated layer 633, and a second nickel-plated layer 632, and the first nickel-plated layer 633 and the second nickel-plated layer 632 are separately disposed on two sides of the substrate.

The substrate may be, for example, aluminum alloy or stainless steel.

A possible manner of obtaining the stamping sheet metal may be, for example, purchasing a stamping sheet metal that meets a requirement.

For example, another possible manner of obtaining the stamping sheet metal may include: obtaining a substrate, and manufacturing the first nickel-plated layer 633 and the second nickel-plated layer 632 on both sides of the substrate.

2902: Paste a first insulation layer 635 in a first partial area of the first nickel-plated layer 633, and manufacture a first soldering layer 634 on an edge of the stamping sheet metal, so that the first nickel-plated layer 633 wraps a second partial area of the first nickel-plated layer 633, a third partial area of the second nickel-plated layer 632, and a shielding case substrate 631 connected between the second partial area and the third partial area, and the second partial area is an area other than the first partial area on the first nickel-plated layer 633.

As shown in FIG. 27, the first insulation layer 635 may be pasted in a central area of the stamping sheet metal, and the first soldering layer 634 may be manufactured in an edge area of the stamping sheet metal.

2903: Manufacture the stamping sheet metal into a specified shape of the shielding case 630 by using a bending forming process. The manufactured stamping sheet metal includes a shielding cover 661 and a plurality of shielding outer walls 667. The plurality of shielding outer walls 667 are disposed around the shielding cover 661. The shielding outer walls 667 are disposed perpendicularly to the shielding cover 661. Different shielding outer walls 667 are connected to different areas on an edge of the shielding cover 661, and there is a partition between two adjacent shielding outer walls 667.

Optionally, an order of step 2902 and an order of step 2903 may be exchanged.

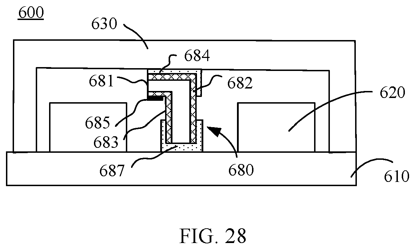

FIG. 28 shows a circuit board assembly 600 provided in an embodiment of this application.

The circuit board assembly 600 may include a circuit board 610 and a plurality of electronic elements 620. The electronic element 620 may be fastened on the circuit board 610 through soldering. The circuit board assembly 600 may further include a shielding case 630. The shielding case 630 may be fastened on the circuit board 610 through soldering. The plurality of electronic elements 620 may be disposed in a cavity formed between the shielding case 630 and the circuit board 610. An overall structure of the shielding case 630 shown in FIG. 21 may be, for example, the shielding case 303 shown in FIG. 3 to FIG. 5.

The circuit board assembly 600 may further include one or more shielding inner walls 680. The shielding inner wall 680 may be disposed in a spacing area between two adjacent electronic elements 620. The shielding inner wall 680 may include a first area disposed in parallel to the shielding case 630 and a second area disposed perpendicularly to the shielding case 630. The first area may be used to be fastened on the shielding case 630 through soldering. The second area may extend from the shielding case 630 to the circuit board 610. One segment that is of the second area and that is away from the first area may be fastened on the circuit board 610 through soldering.

The shielding inner wall 680 may further include a shielding inner wall substrate 681, a third nickel-plated layer 682, and a fourth nickel-plated layer 683. A material of the shielding inner wall substrate 681 may be, for example, aluminum alloy or stainless steel. The third nickel-plated layer 682 and the fourth nickel-plated layer 683 may separately wrap two sides of the shielding inner wall substrate 681. The third nickel-plated layer 682 may be closer to the shielding case 630 than the fourth nickel-plated layer 683.

The shielding inner wall 680 may further include a second soldering layer 687 and a second insulation layer 685. The second soldering layer 687 may wrap the third nickel-plated layer 682, the fourth nickel-plated layer 683, and the shielding inner wall substrate 681 in the second area of the shielding inner wall 680. The shielding inner wall 680 may be fastened on the circuit board 610 through soldering by using the second soldering layer 687. In this application, the soldering layer may be, for example, a tin-plated layer, a gold-plated layer, or the like.

Optionally, the second insulation layer 685 may wrap a side that is of the fourth nickel-plated layer 683 and that is away from the shielding inner wall substrate 681, and an area that is of the fourth nickel-plated layer 683 and that is wrapped by the second insulation layer 685 is different from an area that is of the fourth nickel-plated layer 683 and that is wrapped by the second soldering layer 687.

Optionally, the shielding inner wall 680 may further include a third soldering layer 684. The third soldering layer 684 may wrap the third nickel-plated layer 682 in the first area of the shielding inner wall 680. The third soldering layer 684 may be located on a side that is of the third nickel-plated layer 682 and that is away from the shielding inner wall substrate 681.

For a manufacturing method of the circuit board assembly shown in FIG. 28, refer to the manufacturing method shown in FIG. 25. Details are not described herein again.

A person of ordinary skill in the art may be aware that, in combination with the examples described in embodiments disclosed in this specification, units and algorithm steps may be implemented by electronic hardware or a combination of computer software and electronic hardware. Whether the functions are performed by hardware or software depends on particular applications and design constraint conditions of the technical solutions. A person skilled in the art may use different methods to implement the described functions for each particular application, but it should not be considered that the implementation goes beyond the scope of this application.

It may be clearly understood by a person skilled in the art that, for the purpose of convenient and brief description, for a detailed working process of the foregoing system, apparatus, and unit, refer to a corresponding process in the foregoing method embodiments, and details are not described herein again.

In several embodiments provided in this application, it should be understood that the disclosed system, apparatus, and method may be implemented in another manner. For example, the described apparatus embodiment is merely an example. For example, division into the units is merely logical function division and may be other division in actual implementation. For example, a plurality of units or components may be combined or integrated into another system, or some features may be ignored or not performed. In addition, the displayed or discussed mutual couplings or direct couplings or communication connections may be implemented through some interfaces. The indirect couplings or communication connections between the apparatuses or units may be implemented in electrical, mechanical, or another form.

The units described as separate parts may or may not be physically separate, and parts displayed as units may or may not be physical units, may be located in one position, or may be distributed on a plurality of network units. Some or all of the units may be selected based on actual requirements to achieve the objectives of the solutions of embodiments.

In addition, functional units in embodiments of this application may be integrated into one processing unit, each of the units may exist alone physically, or two or more units may be integrated into one unit.

When the functions are implemented in the form of a software functional unit and sold or used as an independent product, the functions may be stored in a computer-readable storage medium. Based on such an understanding, the technical solutions of this application essentially, or the part contributing to the conventional technology, or some of the technical solutions may be implemented in a form of a software product. The computer software product is stored in a storage medium, and includes several instructions for instructing a computer device (which may be a personal computer, a server, or a network device) to perform all or some of the steps of the methods described in embodiments of this application. The foregoing storage medium includes any medium that can store program code, such as a USB flash drive, a removable hard disk, a read-only memory (read-only memory, ROM), a random access memory (random access memory, RAM), a magnetic disk, or an optical disc.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A shielding case (630), wherein the shielding case is configured to be fastened on a circuit board (610), and the shielding case comprises:
a shielding cover (661), wherein the shielding cover (661) is disposed in parallel to the circuit board (610), one or more deformation reinforcement structures (641, 642, 643) are disposed on the shielding cover, and the one or more deformation reinforcement structures (641, 642, 643) comprise at least one of the following: a semi-piercing deformation reinforcement structure (641), a drawing deformation reinforcement structure (642), and a squeezing deformation reinforcement structure (643);
a shielding base (3133), wherein the shielding base is configured to be fastened on the circuit board (610); and
a shielding wall (3132), wherein the shielding wall is connected between the shielding cover (661) and the shielding base, the shielding wall surrounds the shielding cover (661), and the shielding wall is disposed perpendicularly to the shielding cover (661);
wherein a material of the shielding case (630) comprises:
a shielding case substrate (631);
a first nickel-plated layer (633), wherein the first nickel-plated layer (633) wraps a side that is of the shielding case substrate (631) and that is close to the circuit board (610);
a second nickel-plated layer (632), wherein the second nickel-plated layer (632) wraps a side that is of the shielding case substrate (631) and that is away from the circuit board (610);
a first insulation layer (635), wherein the first insulation layer (635) is located on a side that is of the first nickel-plated layer (633) and that is away from the shielding case substrate (631), and the first insulation layer (635) is pasted on a first partial area of the first nickel-plated layer (633); and
a first soldering layer (634), wherein the first soldering layer (634) is configured to fasten the shielding case (630) on the circuit board (610) through soldering, the first soldering layer (634) is located on a side that is of the first nickel-plated layer (633) and that is away from the shielding case substrate (631), the first soldering layer (634) wraps a second partial area of the first nickel-plated layer (633), and the second partial the area is not connected to the first partial area;
wherein the semi-piercing deformation reinforcement structure (641) comprises a first protrusion (6411) and a first groove (6412) corresponding to the first protrusion (6411), a maximum cross-sectional width of the first protrusion (6411) is greater than a minimum cross-sectional width of the first groove (6412), and a difference between the maximum cross-sectional width of the first protrusion (6411) and the minimum cross-sectional width of the first groove (6412) is less than twice thickness of the shielding cover (661), wherein a center surface (6413) of the first groove (6412) is aligned with a center surface (6414) of the first protrusion (6411), wherein the first protrusion (6411) is formed on the side of the shielding case substrate (631) that is away from the circuit board (610) and the first groove (6412) is formed on the side of the shielding case substrate (631) that is close to the circuit board (610);
wherein the drawing deformation reinforcement structure (642) comprises a second protrusion (6421) and a second groove (6422) corresponding to the second protrusion (6421), a maximum cross-sectional width of the second protrusion (6421) is greater than a minimum cross-sectional width of the second groove (6422), and a difference between the maximum cross-sectional width of the second protrusion (6421) and the minimum cross-sectional width of the second groove (6422) is greater than or equal to twice the thickness of the shielding cover (661), wherein a center surface (6423) of the second groove (6422) is aligned with a center surface (6424) of the second protrusion (6421), wherein the second protrusion (6421) is formed on the side of the shielding case substrate (631) that is away from the circuit board (610) and the second groove (6422) is formed on the side of the shielding case substrate (631) that is close to the circuit board (610);
wherein a shape of the squeezing deformation reinforcement structure (643) is a groove, and wherein the groove is formed on the side of the shielding case substrate (631) that is away from the circuit board or on the side of the shielding case substrate (631) that is close to the circuit board (610) resulting in the thickness of the shielding cover (661) at the squeezing deformation reinforcement structure (643) is less than average thickness of the shielding cover.

2. A shielding case (303), wherein the shielding case is configured to be fastened on a circuit board (301), and the shielding case comprises:
a shielding cover (3131), wherein the shielding cover is disposed in parallel to the circuit board, one or more deformation reinforcement structures are disposed on the shielding cover, and the one or more deformation reinforcement structures comprise at least one of the following: a semi-piercing deformation reinforcement structure, a drawing deformation reinforcement structure, and a squeezing deformation reinforcement structure; and
a plurality of shielding outer walls (3134), wherein one end of the shielding outer wall is used to be fastened on the circuit board, the other end of the shielding outer wall is connected to the shielding cover, the shielding outer wall is disposed perpendicularly to the circuit board, the plurality of shielding outer walls are disposed around the shielding cover, and there is a partition between two adjacent shielding outer walls;
wherein a material of the shielding case (630) comprises:
a shielding case substrate (631);
a first nickel-plated layer (633), wherein the first nickel-plated layer (633) wraps a side that is of the shielding case substrate (631) and that is close to the circuit board (610);
a second nickel-plated layer (632), wherein the second nickel-plated layer (632) wraps a side that is of the shielding case substrate (631) and that is away from the circuit board (610);
a first insulation layer (635), wherein the first insulation layer (635) is located on a side that is of the first nickel-plated layer (633) and that is away from the shielding case substrate (631), and the first insulation layer (635) is pasted on a first partial area of the first nickel-plated layer (633); and
a first soldering layer (634), wherein the first soldering layer (634) is configured to fasten the shielding case (630) on the circuit board (610) through soldering, the first soldering layer (634) is located on a side that is of the first nickel-plated layer (633) and that is away from the shielding case substrate (631), the first soldering layer (634) wraps a second partial area of the first nickel-plated layer (633), and the second partial the area is not connected to the first partial area;
wherein the semi-piercing deformation reinforcement structure (641) comprises a first protrusion (6411) and a first groove (6412) corresponding to the first protrusion (6411), a maximum cross-sectional width of the first protrusion (6411) is greater than a minimum cross-sectional width of the first groove (6412), and a difference between the maximum cross-sectional width of the first protrusion (6411) and the minimum cross-sectional width of the first groove (6412) is less than twice thickness of the shielding cover (661), wherein a center surface (6413) of the first groove is aligned with a center surface (6414) of the first protrusion (6411), wherein the first protrusion (6411) is formed on the side of the shielding case substrate (631) that is away from the circuit board (610) and the first groove (6412) is formed on the side of the shielding case substrate (631) that is close to the circuit board (610);
wherein the drawing deformation reinforcement structure (642) comprises a second protrusion (6421) and a second groove (6422) corresponding to the second protrusion (6421), a maximum cross-sectional width of the second protrusion (6421) is greater than a minimum cross-sectional width of the second groove (6422), and a difference between the maximum cross-sectional width of the second protrusion (6421) and the minimum cross-sectional width of the second groove (6422) is greater than or equal to twice the thickness of the shielding cover (661), wherein a center surface (6423) of the second groove (6422) is aligned with a center surface (6424) of the second protrusion (6421), wherein the second protrusion (6421) is formed on the side of the shielding case substrate (631) that is away from the circuit board (610) and the second groove (6422) is formed on the side of the shielding case substrate (631) that is close to the circuit board (610);
wherein a shape of the squeezing deformation reinforcement structure (643) is a groove, and wherein the groove is formed on the side of the shielding case substrate (631) that is away from the circuit board (610) or on the side of the shielding case substrate (631) that is close to the circuit board (610) resulting in the thickness of the shielding cover (661) at the squeezing deformation reinforcement structure (643) is less than average thickness of the shielding cover.

3. The shielding case according to claim 1 or 2, wherein the shielding case further comprises:
a shielding inner wall (304), wherein the shielding inner wall is located on a side that is of the shielding cover and that is close to the circuit board, the shielding inner wall is disposed perpendicularly to the shielding cover, one end of the shielding inner wall is fastened on the shielding case, and the other end of the shielding inner wall is used to be fastened on the circuit board.

4. The shielding case according to claim 3, wherein a material of the shielding inner wall comprises:
a shielding inner wall substrate (3043);
a third nickel-plated layer (3042), wherein the third nickel-plated layer wraps a side that is of the shielding inner wall substrate and that is close to the shielding case;
a fourth nickel-plated layer (3044), wherein the fourth nickel-plated layer wraps a side that is of the shielding inner wall substrate and that is away from the shielding case;
a second soldering layer (3035), wherein the second soldering layer wraps the third nickel-plated layer, the fourth nickel-plated layer, and the shielding inner wall substrate, an area that is of the third nickel-plated layer and that is wrapped by the second soldering layer is a fourth partial area, an area that is of the fourth nickel-plated layer and that is wrapped by the second soldering layer is a fifth partial area, and an area that is of the shielding inner wall substrate and that is wrapped by the second soldering layer is located between the fourth partial area and the fifth partial area; and
a second insulation layer (3046), wherein the second insulation layer is located on a side that is of the fourth nickel-plated layer and that is away from the shielding inner wall substrate, the second insulation layer is pasted on a sixth partial area of the fourth nickel-plated layer, and the sixth partial area is not connected to the fifth partial area.

5. A shielding case (303), wherein the shielding case is configured to be fastened on a circuit board (301), and the shielding case comprises:
a shielding frame (3135), wherein the shielding frame is disposed in parallel to the circuit board;
a separable shielding cover (3136), wherein the separable shielding cover is disposed on the shielding frame, an edge of the separable shielding cover surrounds an area surrounded by the shielding frame, the separable shielding cover is disposed in parallel to the circuit board, one or more deformation reinforcement structures are disposed on the separable shielding cover, and the one or more deformation reinforcement structures comprise at least one of the following: a semi-piercing deformation reinforcement structure, a drawing deformation reinforcement structure, and a squeezing deformation reinforcement structure;
a shielding base (3133), wherein the shielding base is configured to be fastened on the circuit board; and
a shielding wall (3132), wherein the shielding wall is connected between the shielding frame and the shielding base, the shielding wall surrounds the shielding frame, and the shielding wall is disposed perpendicularly to the separable shielding cover;
wherein a material of the shielding case (630) comprises:
a shielding case substrate (631);
a first nickel-plated layer (633), wherein the first nickel-plated layer (633) wraps a side that is of the shielding case substrate (631) and that is close to the circuit board (610);
a second nickel-plated layer (632), wherein the second nickel-plated layer (632) wraps a side that is of the shielding case substrate (631) and that is away from the circuit board (610);
a first insulation layer (635), wherein the first insulation layer (635) is located on a side that is of the first nickel-plated layer (633) and that is away from the shielding case substrate (631), and the first insulation layer (635) is pasted on a first partial area of the first nickel-plated layer (633); and
a first soldering layer (634), wherein the first soldering layer (634) is configured to fasten the shielding case (630) on the circuit board (610) through soldering, the first soldering layer (634) is located on a side that is of the first nickel-plated layer (633) and that is away from the shielding case substrate (631), the first soldering layer (634) wraps a second partial area of the first nickel-plated layer (633), and the second partial the area is not connected to the first partial area;
wherein the semi-piercing deformation reinforcement structure (641) comprises a first protrusion (6411) and a first groove (6412) corresponding to the first protrusion (6411), a maximum cross-sectional width of the first protrusion (6411) is greater than a minimum cross-sectional width of the first groove (6412), and a difference between the maximum cross-sectional width of the first protrusion (6411) and the minimum cross-sectional width of the first groove (6412) is less than twice thickness of the separable shielding cover (661), wherein a center surface (6413) of the first groove (6412) is aligned with a center surface (6414) of the first protrusion (6411), wherein the first protrusion (6411) is formed on the side of the shielding case substrate (631) that is away from the circuit board (610) and the first groove (6412) is formed on the side of the shielding case substrate (631) that is close to the circuit board (610);
wherein the drawing deformation reinforcement structure (642) comprises a second protrusion (6421) and a second groove (6422) corresponding to the second protrusion (6421), a maximum cross-sectional width of the second protrusion (6421) is greater than a minimum cross-sectional width of the second groove (6422), and a difference between the maximum cross-sectional width of the second protrusion (6421) and the minimum cross-sectional width of the second groove (6422) is greater than or equal to twice the thickness of the separable shielding cover (3136), wherein a center surface (6423) of the second groove (6422) is aligned with a center surface of the second protrusion (6421), wherein the second protrusion is formed on the side of the shielding case substrate (631) that is away from the circuit board and the second groove (6422) is formed on the side of the shielding case substrate that is close to the circuit board (610);
wherein a shape of the squeezing deformation reinforcement structure (643) is a groove, and wherein the groove is formed on the side of the shielding case substrate (631) that is away from the circuit board or on the side of the shielding case substrate (631) that is close to the circuit board (610) resulting in the thickness of the separable shielding cover at the squeezing deformation reinforcement structure (643) is less than average thickness of the separable shielding cover.

6. A shielding case (303), wherein the shielding case is configured to be fastened on a circuit board (301), and the shielding case comprises:
a shielding frame (3135), wherein the shielding frame is disposed in parallel to the circuit board, the shielding frame comprises a shielding strip (3139), the shielding strip is located in an area surrounded by the shielding frame, one or more deformation reinforcement structures are disposed on the shielding strip, and the one or more deformation reinforcement structures comprise at least one of the following: a semi-piercing deformation reinforcement structure, a drawing deformation reinforcement structure, and a squeezing deformation reinforcement structure;
a shielding base (3133), wherein the shielding base is configured to be fastened on the circuit board;
a separable shielding cover (3136), wherein the separable shielding cover is disposed on the shielding frame, an edge of the separable shielding cover surrounds the area surrounded by the shielding frame, and the separable shielding cover is disposed in parallel to the circuit board; and
a shielding wall (3132), wherein the shielding wall is connected between the shielding frame and the shielding base, the shielding wall surrounds the shielding frame, and the shielding wall is disposed perpendicularly to the separable shielding cover;
wherein a material of the shielding case (630) comprises:
a shielding case substrate (631);
a first nickel-plated layer (633), wherein the first nickel-plated layer (633) wraps a side that is of the shielding case substrate (631) and that is close to the circuit board (610);
a second nickel-plated layer (632), wherein the second nickel-plated layer (632) wraps a side that is of the shielding case substrate (631) and that is away from the circuit board (610);
a first insulation layer (635), wherein the first insulation layer (635) is located on a side that is of the first nickel-plated layer (633) and that is away from the shielding case substrate (631), and the first insulation layer (635) is pasted on a first partial area of the first nickel-plated layer (633); and
a first soldering layer (634), wherein the first soldering layer (634) is configured to fasten the shielding case (630) on the circuit board (610) through soldering, the first soldering layer (634) is located on a side that is of the first nickel-plated layer (633) and that is away from the shielding case substrate (631), the first soldering layer (634) wraps a second partial area of the first nickel-plated layer (633), and the second partial the area is not connected to the first partial area;
wherein the semi-piercing deformation reinforcement structure (641) comprises a first protrusion (6411) and a first groove (6412) corresponding to the first protrusion (6411), a maximum cross-sectional width of the first protrusion (6411) is greater than a minimum cross-sectional width of the first groove (6412), and a difference between the maximum cross-sectional width of the first protrusion (6411) and the minimum cross-sectional width of the first groove (6412) is less than twice thickness of the shielding strip (3139), wherein a center surface (6413) of the first groove (6412) is aligned with a center surface (6414) of the first protrusion (6411), wherein the first protrusion (6411) is formed on the side of the shielding case substrate (631) that is away from the circuit board (610) and the first groove (6412) is formed on the side of the shielding case substrate (631) that is close to the circuit board (610);
wherein the drawing deformation reinforcement structure (642) comprises a second protrusion (6421) and a second groove (6422) corresponding to the second protrusion (6421), a maximum cross-sectional width of the second protrusion (6421) is greater than a minimum cross-sectional width of the second groove (6422), and a difference between the maximum cross-sectional width of the second protrusion (6421) and the minimum cross-sectional width of the second groove (6422) is greater than or equal to twice the thickness of the shielding strip (3139), wherein a center surface (6423) of the second groove (6422) is aligned with a center surface of the second protrusion (6421), wherein the second protrusion is formed on the side of the shielding case substrate (631) that is away from the circuit board and the second groove (6422) is formed on the side of the shielding case substrate that is close to the circuit board (610);
wherein a shape of the squeezing deformation reinforcement structure (643) is a groove, and wherein the groove is formed on the side of the shielding case substrate (631) that is away from the circuit board or on the side of the shielding case substrate (631) that is close to the circuit board (610) resulting in the thickness of the shielding strip at the squeezing deformation reinforcement structure (643) is less than average thickness of the shielding strip.

7. A shielding case (303), wherein the shielding case is configured to be fastened on a circuit board (301), and the shielding case comprises:
a shielding cover, wherein the shielding cover is disposed in parallel to the circuit board;
a shielding base (3133), wherein the shielding base is configured to be fastened on the circuit board;
a shielding wall (3132), wherein the shielding wall is connected between the shielding cover and the shielding base, the shielding wall surrounds the shielding cover, and the shielding wall is disposed perpendicularly to the shielding cover; and
a shielding inner wall (680), wherein the shielding inner wall is located on a side that is of the shielding cover and that is close to the circuit board, the shielding inner wall comprises a first area disposed in parallel to the shielding cover and a second area disposed perpendicularly to the shielding cover, the first area is fastened on the shielding case, an end that is of the second area and that is away from the first area is used to be fastened on the circuit board, one or more deformation reinforcement structures are disposed in the second area, and the one or more deformation reinforcement structures comprise at least one of the following: a semi-piercing deformation reinforcement structure, a drawing deformation reinforcement structure, and a squeezing deformation reinforcement structure;
a material of the shielding inner wall comprises:
a shielding inner wall substrate (681);
a third nickel-plated layer (682), wherein the third nickel-plated layer wraps a side that is of the shielding inner wall substrate and that is close to the shielding case;
a fourth nickel-plated layer (683), wherein the fourth nickel-plated layer wraps a side that is of the shielding inner wall substrate and that is away from the shielding case;
a second soldering layer (687), wherein the second soldering layer wraps the third nickel-plated layer, the fourth nickel-plated layer, and a shielding case substrate, an area that is of the third nickel-plated layer and that is wrapped by the second soldering layer is a fourth partial area, an area that is of the fourth nickel-plated layer and that is wrapped by the second soldering layer is a fifth partial area, and an area that is of the shielding case substrate and that is wrapped by the first soldering layer is located between the fourth partial area and the fifth partial area; and
a second insulation layer (685), wherein the second insulation layer is located on a side that is of the fourth nickel-plated layer and that is away from the shielding inner wall substrate, the second insulation layer is pasted on a sixth partial area of the fourth nickel-plated layer, and the sixth partial area is not connected to the fifth partial area;
wherein the semi-piercing deformation reinforcement structure (641) comprises a first protrusion (6411) and a first groove (6412) corresponding to the first protrusion (6411), a maximum cross-sectional width of the first protrusion (6411) is greater than a minimum cross-sectional width of the first groove (6412), and a difference between the maximum cross-sectional width of the first protrusion (6411) and the minimum cross-sectional width of the first groove (6412) is less than twice thickness of the shielding inner wall, wherein a center surface (6413) of the first groove (6412) is aligned with a center surface (6414) of the first protrusion (6411), wherein the first protrusion (6411) is formed on one side of the shielding inner wall substrate in the second area, and the first groove (6412) is formed on the other side of the shielding inner wall substrate in the second area;
wherein the drawing deformation reinforcement structure (642) comprises a second protrusion (6421) and a second groove (6422) corresponding to the second protrusion (6421), a maximum cross-sectional width of the second protrusion (6421) is greater than a minimum cross-sectional width of the second groove (6422), and a difference between the maximum cross-sectional width of the second protrusion (6421) and the minimum cross-sectional width of the second groove (6422) is greater than or equal to twice the thickness of the shielding inner wall, wherein a center surface (6423) of the second groove (6422) is aligned with a center surface (6424) of the second protrusion (6421), wherein the second protrusion (6421) is formed on one side of the shielding inner wall substrate in the second area, and the second groove is formed on the other side of the shielding inner wall substrate in the second area;
wherein a shape of the squeezing deformation reinforcement structure (643) is a groove, and wherein the groove is formed on one side of the shielding inner wall substrate in the second area resulting in the thickness of the shielding inner wall at the squeezing deformation reinforcement structure (643) is less than average thickness of the shielding inner wall.

8. The shielding case according to claim 7, wherein the shielding case is configured to be fastened on the circuit board, and a material of the shielding case comprises:
a shielding case substrate (631);
a first nickel-plated layer (633), wherein the first nickel-plated layer wraps a side that is of the shielding case substrate and that is close to the circuit board;
a second nickel-plated layer (632), wherein the second nickel-plated layer wraps a side that is of the shielding case substrate and that is away from the circuit board;
a first insulation layer (635), wherein the first insulation layer is located on a side that is of the first nickel-plated layer and that is away from the shielding case substrate, and the first insulation layer is pasted on a first partial area of the first nickel-plated layer; and
a first soldering layer (634), wherein the first soldering layer is configured to fasten the shielding case on the circuit board through soldering, the first soldering layer is located on a side that is of the first nickel-plated layer and that is away from the shielding case substrate, the first soldering layer wraps a second partial area of the first nickel-plated layer, and the second partial the area is not connected to the first partial area.

9. The shielding case according to claim 8, wherein the first soldering layer further wraps the second nickel-plated layer and the shielding case substrate, an area that is of the second nickel-plated layer and that is wrapped by the first soldering layer is a third partial area, and an area that is of the shielding case substrate and that is wrapped by the first soldering layer is located between the second partial area and the third partial area.

10. An electronic device (100), comprising:
a circuit board (301);
the shielding case (303) according to any one of claims 1 to 9, wherein the shielding case is fixed on one side of the circuit board; and
an electronic element (302), wherein the electronic element is located in a cavity formed between the shielding case and the circuit board.

## Patentansprüche

1. Abschirmgehäuse (630), wobei das Abschirmgehäuse konfiguriert ist, um an einer Leiterplatte (610) befestigt zu werden, und das Abschirmgehäuse umfasst:
eine Abschirmabdeckung (661), wobei die Abschirmabdeckung (661) parallel zu der Leiterplatte (610) angeordnet ist, eine oder mehrere Verformungsverstärkungsstrukturen (641, 642, 643) auf der Abschirmabdeckung angeordnet sind und die eine oder die mehreren Verformungsverstärkungsstrukturen (641, 642, 643) mindestens eines der Folgenden umfassen: eine Halbdurchstanz-Verformungsverstärkungsstruktur (641), eine Zieh-Verformungsverstärkungsstruktur (642) und eine Quetsch-Verformungsverstärkungsstruktur (643);
eine Abschirmbasis (3133), wobei die Abschirmbasis konfiguriert ist, um an der Leiterplatte (610) befestigt zu werden; und
eine Abschirmwand (3132), wobei die Abschirmwand zwischen der Abschirmabdeckung (661) und der Abschirmbasis verbunden ist, die Abschirmwand die Abschirmabdeckung (661) umgibt und die Abschirmwand senkrecht zu der Abschirmabdeckung (661) angeordnet ist;
wobei ein Material des Abschirmgehäuses (630) umfasst:
ein Abschirmgehäusesubstrat (631);
eine erste vernickelte Schicht (633), wobei die erste vernickelte Schicht (633) eine Seite, die von dem Abschirmgehäusesubstrat (631) ist und die nahe der Leiterplatte (610) ist, umhüllt;
eine zweite vernickelte Schicht (632), wobei die zweite vernickelte Schicht (632) eine Seite, die von dem Abschirmgehäusesubstrat (631) ist und die von der Leiterplatte (610) entfernt ist, umhüllt;
eine erste Isolierschicht (635), wobei die erste Isolierschicht (635) auf einer Seite, die von der ersten vernickelten Schicht (633) ist und die von dem Abschirmgehäusesubstrat (631) entfernt ist, gelegen ist und die erste Isolierschicht (635) auf einen ersten Teilbereich der ersten vernickelten Schicht (633) aufgeklebt ist; und
eine erste Lötschicht (634), wobei die erste Lötschicht (634) konfiguriert ist, um das Abschirmgehäuse (630) an der Leiterplatte (610) durch Löten zu befestigen, die erste Lötschicht (634) auf einer Seite, die von der ersten vernickelten Schicht (633) ist und die von dem Abschirmgehäusesubstrat (631) entfernt ist, gelegen ist, die erste Lötschicht (634) einen zweiten Teilbereich der ersten vernickelten Schicht (633) umhüllt und der zweite Teilbereich nicht mit dem ersten Teilbereich verbunden ist;
wobei die Halbdurchstanz-Verformungsverstärkungsstruktur (641) einen ersten Vorsprung (6411) und eine erste Nut (6412), die dem ersten Vorsprung (6411) entspricht, umfasst, eine maximale Querschnittsbreite des ersten Vorsprungs (6411) größer als eine minimale Querschnittsbreite der ersten Nut (6412) ist, und eine Differenz zwischen der maximalen Querschnittsbreite des ersten Vorsprungs (6411) und der minimalen Querschnittsbreite der ersten Nut (6412) kleiner als die doppelte Dicke der Abschirmabdeckung (661) ist, wobei eine Mitteloberfläche (6413) der ersten Nut (6412) mit einer Mitteloberfläche (6414) des ersten Vorsprungs (6411) fluchtet, wobei der erste Vorsprung (6411) auf der Seite des Abschirmgehäusesubstrats (631), die von der Leiterplatte (610) entfernt ist, gebildet ist, und die erste Nut (6412) auf der Seite des Abschirmgehäusesubstrats (631), die nahe der Leiterplatte (610) ist, gebildet ist;
wobei die Zieh-Verformungsverstärkungsstruktur (642) einen zweiten Vorsprung (6421) und eine zweite Nut (6422), die dem zweiten Vorsprung (6421) entspricht, umfasst, eine maximale Querschnittsbreite des zweiten Vorsprungs (6421) größer als eine minimale Querschnittsbreite der zweiten Nut (6422) ist, und eine Differenz zwischen der maximalen Querschnittsbreite des zweiten Vorsprungs (6421) und der minimalen Querschnittsbreite der zweiten Nut (6422) größer als oder gleich der doppelten Dicke der Abschirmabdeckung (661) ist, wobei eine Mitteloberfläche (6423) der zweiten Nut (6422) mit einer Mitteloberfläche (6424) des zweiten Vorsprungs (6421) fluchtet, wobei der zweite Vorsprung (6421) auf der Seite des Abschirmgehäusesubstrats (631), die von der Leiterplatte (610) entfernt ist, gebildet ist, und die zweite Nut (6422) auf der Seite des Abschirmgehäusesubstrats (631), die nahe der Leiterplatte (610) ist, gebildet ist;
wobei eine Form der Quetsch-Verformungsverstärkungsstruktur (643) eine Nut ist, und wobei die Nut auf der Seite des Abschirmgehäusesubstrats (631), die von der Leiterplatte entfernt ist, oder auf der Seite des Abschirmgehäusesubstrats (631), die nahe der Leiterplatte (610) ist, gebildet ist, was dazu führt, dass die Dicke der Abschirmabdeckung (661) an der Quetsch-Verformungsverstärkungsstruktur (643) kleiner als die durchschnittliche Dicke der Abschirmabdeckung ist.

2. Abschirmgehäuse (303), wobei das Abschirmgehäuse konfiguriert ist, um an einer Leiterplatte (301) befestigt zu werden, und das Abschirmgehäuse umfasst:
eine Abschirmabdeckung (3131), wobei die Abschirmabdeckung parallel zu der Leiterplatte angeordnet ist, eine oder mehrere Verformungsverstärkungsstrukturen auf der Abschirmabdeckung angeordnet sind und die eine oder die mehreren Verformungsverstärkungsstrukturen mindestens eines der Folgenden umfassen: eine Halbdurchstanz-Verformungsverstärkungsstruktur, eine Zieh-Verformungsverstärkungsstruktur und eine Quetsch-Verformungsverstärkungsstruktur; und
eine Vielzahl von Abschirmaußenwänden (3134), wobei ein Ende der Abschirmaußenwand verwendet wird, um an der Leiterplatte befestigt zu werden, das andere Ende der Abschirmaußenwand mit der Abschirmabdeckung verbunden ist, die Abschirmaußenwand senkrecht zu der Leiterplatte angeordnet ist, die Vielzahl von Abschirmaußenwänden um die Abschirmabdeckung herum angeordnet sind und eine Trennwand zwischen zwei benachbarten Abschirmaußenwänden vorhanden ist;
wobei ein Material des Abschirmgehäuses (630) umfasst:
ein Abschirmgehäusesubstrat (631);
eine erste vernickelte Schicht (633), wobei die erste vernickelte Schicht (633) eine Seite, die von dem Abschirmgehäusesubstrat (631) ist und die nahe der Leiterplatte (610) ist, umhüllt;
eine zweite vernickelte Schicht (632), wobei die zweite vernickelte Schicht (632) eine Seite, die von dem Abschirmgehäusesubstrat (631) ist und die von der Leiterplatte (610) entfernt ist, umhüllt;
eine erste Isolierschicht (635), wobei die erste Isolierschicht (635) auf einer Seite, die von der ersten vernickelten Schicht (633) ist und die von dem Abschirmgehäusesubstrat (631) entfernt ist, gelegen ist und die erste Isolierschicht (635) auf einen ersten Teilbereich der ersten vernickelten Schicht (633) aufgeklebt ist; und
eine erste Lötschicht (634), wobei die erste Lötschicht (634) konfiguriert ist, um das Abschirmgehäuse (630) an der Leiterplatte (610) durch Löten zu befestigen, die erste Lötschicht (634) auf einer Seite, die von der ersten vernickelten Schicht (633) ist und die von dem Abschirmgehäusesubstrat (631) entfernt ist, gelegen ist, die erste Lötschicht (634) einen zweiten Teilbereich der ersten vernickelten Schicht (633) umhüllt und der zweite Teilbereich nicht mit dem ersten Teilbereich verbunden ist;
wobei die Halbdurchstanz-Verformungsverstärkungsstruktur (641) einen ersten Vorsprung (6411) und eine erste Nut (6412), die dem ersten Vorsprung (6411) entspricht, umfasst, eine maximale Querschnittsbreite des ersten Vorsprungs (6411) größer als eine minimale Querschnittsbreite der ersten Nut (6412) ist und eine Differenz zwischen der maximalen Querschnittsbreite des ersten Vorsprungs (6411) und der minimalen Querschnittsbreite der ersten Nut (6412) kleiner als die doppelte Dicke der Abschirmabdeckung (661) ist, wobei eine Mitteloberfläche (6413) der ersten Nut mit einer Mitteloberfläche (6414) des ersten Vorsprungs (6411) fluchtet, wobei der erste Vorsprung (6411) auf der Seite des Abschirmgehäusesubstrats (631), die von der Leiterplatte (610) entfernt ist, gebildet ist, und die erste Nut (6412) auf der Seite des Abschirmgehäusesubstrats (631), die nahe der Leiterplatte (610) ist, gebildet ist;
wobei die Zieh-Verformungsverstärkungsstruktur (642) einen zweiten Vorsprung (6421) und eine zweite Nut (6422), die dem zweiten Vorsprung (6421) entspricht, umfasst, eine maximale Querschnittsbreite des zweiten Vorsprungs (6421) größer als eine minimale Querschnittsbreite der zweiten Nut (6422) ist, und eine Differenz zwischen der maximalen Querschnittsbreite des zweiten Vorsprungs (6421) und der minimalen Querschnittsbreite der zweiten Nut (6422) größer als oder gleich der doppelten Dicke der Abschirmabdeckung (661) ist, wobei eine Mitteloberfläche (6423) der zweiten Nut (6422) mit einer Mitteloberfläche (6424) des zweiten Vorsprungs (6421) fluchtet, wobei der zweite Vorsprung (6421) auf der Seite des Abschirmgehäusesubstrats (631), die von der Leiterplatte (610) entfernt ist, gebildet ist, und die zweite Nut (6422) auf der Seite des Abschirmgehäusesubstrats (631), die nahe der Leiterplatte (610) ist, gebildet ist;
wobei eine Form der Quetsch-Verformungsverstärkungsstruktur (643) eine Nut ist, und wobei die Nut auf der Seite des Abschirmgehäusesubstrats (631), die von der Leiterplatte (610) entfernt ist, oder auf der Seite des Abschirmgehäusesubstrats (631), die nahe der Leiterplatte (610) ist, gebildet ist, was dazu führt, dass die Dicke der Abschirmabdeckung (661) an der Quetsch-Verformungsverstärkungsstruktur (643) kleiner als die durchschnittliche Dicke der Abschirmabdeckung ist.

3. Abschirmgehäuse nach Anspruch 1 oder 2, wobei das Abschirmgehäuse ferner umfasst: eine Abschirminnenwand (304), wobei die Abschirminnenwand auf einer Seite, die von der Abschirmabdeckung ist und die nahe der Leiterplatte ist, gelegen ist, die Abschirminnenwand senkrecht zu der Abschirmabdeckung angeordnet ist, ein Ende der Abschirminnenwand an dem Abschirmgehäuse befestigt ist und das andere Ende der Abschirminnenwand verwendet wird, um an der Leiterplatte befestigt zu werden.

4. Abschirmgehäuse nach Anspruch 3, wobei ein Material der Abschirminnenwand umfasst:
ein Abschirminnenwandsubstrat (3043);
eine dritte vernickelte Schicht (3042), wobei die dritte vernickelte Schicht eine Seite, die von dem Abschirminnenwandsubstrat ist und die nahe dem Abschirmgehäuse ist, umhüllt;
eine vierte vernickelte Schicht (3044), wobei die vierte vernickelte Schicht eine Seite, die von dem Abschirminnenwandsubstrat ist und die von dem Abschirmgehäuse entfernt ist, umhüllt;
eine zweite Lötschicht (3035), wobei die zweite Lötschicht die dritte vernickelte Schicht, die vierte vernickelte Schicht und das Abschirminnenwandsubstrat umhüllt, ein Bereich der dritten vernickelten Schicht, der von der zweiten Lötschicht umhüllt ist, ein vierter Teilbereich ist, ein Bereich der vierten vernickelten Schicht, der von der zweiten Lötschicht umhüllt ist, ein fünfter Teilbereich ist, und ein Bereich des Abschirminnenwandsubstrats, der von der zweiten Lötschicht umhüllt ist, zwischen dem vierten Teilbereich und dem fünften Teilbereich gelegen ist; und
eine zweite Isolierschicht (3046), wobei die zweite Isolierschicht auf einer Seite, die von der vierten vernickelten Schicht ist und die von dem Abschirminnenwandsubstrat entfernt ist, gelegen ist, die zweite Isolierschicht auf einen sechsten Teilbereich der vierten vernickelten Schicht aufgeklebt ist und der sechste Teilbereich nicht mit dem fünften Teilbereich verbunden ist.

5. Abschirmgehäuse (303), wobei das Abschirmgehäuse konfiguriert ist, um an einer Leiterplatte (301) befestigt zu werden, und das Abschirmgehäuse umfasst:
einen Abschirmrahmen (3135), wobei der Abschirmrahmen parallel zu der Leiterplatte angeordnet ist;
eine trennbare Abschirmabdeckung (3136), wobei die trennbare Abschirmabdeckung an dem Abschirmrahmen angeordnet ist, ein Rand der trennbaren Abschirmabdeckung einen Bereich, der von dem Abschirmrahmen umgeben ist, umgibt, die trennbare Abschirmabdeckung parallel zu der Leiterplatte angeordnet ist, eine oder mehrere Verformungsverstärkungsstrukturen an der trennbaren Abschirmabdeckung angeordnet sind und die eine oder die mehreren Verformungsverstärkungsstrukturen mindestens eines der Folgenden umfassen: eine Halbdurchstanz-Verformungsverstärkungsstruktur, eine Zieh-Verformungsverstärkungsstruktur und eine Quetsch-Verformungsverstärkungsstruktur;
eine Abschirmbasis (3133), wobei die Abschirmbasis konfiguriert ist, um an der Leiterplatte befestigt zu werden; und
eine Abschirmwand (3132), wobei die Abschirmwand zwischen dem Abschirmrahmen und der Abschirmbasis verbunden ist, die Abschirmwand den Abschirmrahmen umgibt und die Abschirmwand senkrecht zu der trennbaren Abschirmabdeckung angeordnet ist;
wobei ein Material des Abschirmgehäuses (630) umfasst:
ein Abschirmgehäusesubstrat (631);
eine erste vernickelte Schicht (633), wobei die erste vernickelte Schicht (633) eine Seite, die von dem Abschirmgehäusesubstrat (631) ist und die nahe der Leiterplatte (610) ist, umhüllt;
eine zweite vernickelte Schicht (632), wobei die zweite vernickelte Schicht (632) eine Seite, die von dem Abschirmgehäusesubstrat (631) ist und die von der Leiterplatte (610) entfernt ist, umhüllt;
eine erste Isolierschicht (635), wobei die erste Isolierschicht (635) auf einer Seite, die von der ersten vernickelten Schicht (633) ist und die von dem Abschirmgehäusesubstrat (631) entfernt ist, gelegen ist, und die erste Isolierschicht (635) auf einen ersten Teilbereich der ersten vernickelten Schicht (633) aufgeklebt ist; und
eine erste Lötschicht (634), wobei die erste Lötschicht (634) konfiguriert ist, um das Abschirmgehäuse (630) an der Leiterplatte (610) durch Löten zu befestigen, die erste Lötschicht (634) auf einer Seite, die von der ersten vernickelten Schicht (633) ist und die von dem Abschirmgehäusesubstrat (631) entfernt ist, gelegen ist, die erste Lötschicht (634) einen zweiten Teilbereich der ersten vernickelten Schicht (633) umhüllt und der zweite Teilbereich nicht mit dem ersten Teilbereich verbunden ist;
wobei die Halbdurchstanz-Verformungsverstärkungsstruktur (641) einen ersten Vorsprung (6411) und eine erste Nut (6412), die dem ersten Vorsprung (6411) entspricht, umfasst, eine maximale Querschnittsbreite des ersten Vorsprungs (6411) größer als eine minimale Querschnittsbreite der ersten Nut (6412) ist, und eine Differenz zwischen der maximalen Querschnittsbreite des ersten Vorsprungs (6411) und der minimalen Querschnittsbreite der ersten Nut (6412) kleiner als die doppelte Dicke der trennbaren Abschirmabdeckung (661) ist, wobei eine Mitteloberfläche (6413) der ersten Nut (6412) mit einer Mitteloberfläche (6414) des ersten Vorsprungs (6411) fluchtet, wobei der erste Vorsprung (6411) auf der Seite des Abschirmgehäusesubstrats (631), die von der Leiterplatte (610) entfernt ist, gebildet ist, und die erste Nut (6412) auf der Seite des Abschirmgehäusesubstrats (631), die nahe der Leiterplatte (610) ist, gebildet ist;
wobei die Zieh-Verformungsverstärkungsstruktur (642) einen zweiten Vorsprung (6421) und eine zweite Nut (6422), die dem zweiten Vorsprung (6421) entspricht, umfasst, eine maximale Querschnittsbreite des zweiten Vorsprungs (6421) größer als eine minimale Querschnittsbreite der zweiten Nut (6422) ist, und eine Differenz zwischen der maximalen Querschnittsbreite des zweiten Vorsprungs (6421) und der minimalen Querschnittsbreite der zweiten Nut (6422) größer als oder gleich der doppelten Dicke der trennbaren Abschirmabdeckung (3136) ist, wobei eine Mitteloberfläche (6423) der zweiten Nut (6422) mit einer Mitteloberfläche des zweiten Vorsprungs (6421) fluchtet, wobei der zweite Vorsprung auf der Seite des Abschirmgehäusesubstrats (631), die von der Leiterplatte entfernt ist, gebildet ist, und die zweite Nut (6422) auf der Seite des Abschirmgehäusesubstrats, die nahe der Leiterplatte (610) ist, gebildet ist;
wobei eine Form der Quetsch-Verformungsverstärkungsstruktur (643) eine Nut ist, und wobei die Nut auf der Seite des Abschirmgehäusesubstrats (631), die von der Leiterplatte entfernt ist, oder auf der Seite des Abschirmgehäusesubstrats (631), die nahe der Leiterplatte (610) ist, gebildet ist, was dazu führt, dass die Dicke der trennbaren Abschirmabdeckung an der Quetsch-Verformungsverstärkungsstruktur (643) kleiner als die durchschnittliche Dicke der trennbaren Abschirmabdeckung ist.

6. Abschirmgehäuse (303), wobei das Abschirmgehäuse konfiguriert ist, um an einer Leiterplatte (301) befestigt zu werden, und das Abschirmgehäuse umfasst:
einen Abschirmrahmen (3135), wobei der Abschirmrahmen parallel zu der Leiterplatte angeordnet ist, der Abschirmrahmen einen Abschirmstreifen (3139) umfasst, der Abschirmstreifen in einem Bereich, der von dem Abschirmrahmen umgeben ist, gelegen ist, eine oder mehrere Verformungsverstärkungsstrukturen an dem Abschirmstreifen angeordnet sind und die eine oder die mehreren Verformungsverstärkungsstrukturen mindestens eines der Folgenden umfassen: eine Halbdurchstanz-Verformungsverstärkungsstruktur, eine Zieh-Verformungsverstärkungsstruktur und eine Quetsch-Verformungsverstärkungsstruktur; eine Abschirmbasis (3133), wobei die Abschirmbasis konfiguriert ist, um an der Leiterplatte befestigt zu werden;
eine trennbare Abschirmabdeckung (3136), wobei die trennbare Abschirmabdeckung an dem Abschirmrahmen angeordnet ist, ein Rand der trennbaren Abschirmabdeckung den von dem Abschirmrahmen umgebenen Bereich umgibt und die trennbare Abschirmabdeckung parallel zu der Leiterplatte angeordnet ist; und eine Abschirmwand (3132), wobei die Abschirmwand zwischen dem Abschirmrahmen und der Abschirmbasis verbunden ist, die Abschirmwand den Abschirmrahmen umgibt und die Abschirmwand senkrecht zu der trennbaren Abschirmabdeckung angeordnet ist;
wobei ein Material des Abschirmgehäuses (630) umfasst:
ein Abschirmgehäusesubstrat (631);
eine erste vernickelte Schicht (633), wobei die erste vernickelte Schicht (633) eine Seite, die von dem Abschirmgehäusesubstrat (631) ist und die nahe der Leiterplatte (610) ist, umhüllt;
eine zweite vernickelte Schicht (632), wobei die zweite vernickelte Schicht (632) eine Seite, die von dem Abschirmgehäusesubstrat (631) ist und die von der Leiterplatte (610) entfernt ist, umhüllt;
eine erste Isolierschicht (635), wobei die erste Isolierschicht (635) auf einer Seite, die von der ersten vernickelten Schicht (633) ist und die von dem Abschirmgehäusesubstrat (631) entfernt ist, gelegen ist, und die erste Isolierschicht (635) auf einen ersten Teilbereich der ersten vernickelten Schicht (633) aufgeklebt ist; und
eine erste Lötschicht (634), wobei die erste Lötschicht (634) konfiguriert ist, um das Abschirmgehäuse (630) an der Leiterplatte (610) durch Löten zu befestigen, die erste Lötschicht (634) auf einer Seite, die von der ersten vernickelten Schicht (633) ist und die von dem Abschirmgehäusesubstrat (631) entfernt ist, gelegen ist, die erste Lötschicht (634) einen zweiten Teilbereich der ersten vernickelten Schicht (633) umhüllt und der zweite Teilbereich nicht mit dem ersten Teilbereich verbunden ist;
wobei die Halbdurchstanz-Verformungsverstärkungsstruktur (641) einen ersten Vorsprung (6411) und eine erste Nut (6412), die dem ersten Vorsprung (6411) entspricht, umfasst, eine maximale Querschnittsbreite des ersten Vorsprungs (6411) größer als eine minimale Querschnittsbreite der ersten Nut (6412) ist, und eine Differenz zwischen der maximalen Querschnittsbreite des ersten Vorsprungs (6411) und der minimalen Querschnittsbreite der ersten Nut (6412) kleiner als die doppelte Dicke des Abschirmstreifens (3139) ist, wobei eine Mitteloberfläche (6413) der ersten Nut (6412) mit einer Mitteloberfläche (6414) des ersten Vorsprungs (6411) fluchtet, wobei der erste Vorsprung (6411) auf der Seite des Abschirmgehäusesubstrats (631), die von der Leiterplatte (610) entfernt ist, gebildet ist, und die erste Nut (6412) auf der Seite des Abschirmgehäusesubstrats (631, die nahe der Leiterplatte (610) ist, gebildet ist;
wobei die Zieh-Verformungsverstärkungsstruktur (642) einen zweiten Vorsprung (6421) und eine zweite Nut (6422, die dem zweiten Vorsprung (6421) entspricht, umfasst, eine maximale Querschnittsbreite des zweiten Vorsprungs (6421) größer als eine minimale Querschnittsbreite der zweiten Nut (6422) ist, und eine Differenz zwischen der maximalen Querschnittsbreite des zweiten Vorsprungs (6421) und der minimalen Querschnittsbreite der zweiten Nut (6422) größer als oder gleich der doppelten Dicke des Abschirmstreifens (3139) ist, wobei eine Mitteloberfläche (6423) der zweiten Nut (6422) mit einer Mitteloberfläche des zweiten Vorsprungs (6421) fluchtet, wobei der zweite Vorsprung auf der Seite des Abschirmgehäusesubstrats (631), die von der Leiterplatte entfernt ist, gebildet ist, und die zweite Nut (6422) auf der Seite des Abschirmgehäusesubstrats, die nahe der Leiterplatte (610) ist, gebildet ist;
wobei eine Form der Quetsch-Verformungsverstärkungsstruktur (643) eine Nut ist, und wobei die Nut auf der Seite des Abschirmgehäusesubstrats (631), die von der Leiterplatte entfernt ist, oder auf der Seite des Abschirmgehäusesubstrats (631), die nahe der Leiterplatte (610) ist, gebildet ist, was dazu führt, dass die Dicke des Abschirmstreifens an der Quetsch-Verformungsverstärkungsstruktur (643) kleiner als die durchschnittliche Dicke des Abschirmstreifens ist.

7. Abschirmgehäuse (303), wobei das Abschirmgehäuse konfiguriert ist, um an einer Leiterplatte (301) befestigt zu werden, und das Abschirmgehäuse umfasst:
eine Abschirmabdeckung, wobei die Abschirmabdeckung parallel zu der Leiterplatte angeordnet ist;
eine Abschirmbasis (3133), wobei die Abschirmbasis konfiguriert ist, um an der Leiterplatte befestigt zu werden;
eine Abschirmwand (3132), wobei die Abschirmwand zwischen der Abschirmabdeckung und der Abschirmbasis verbunden ist, die Abschirmwand die Abschirmabdeckung umgibt und die Abschirmwand senkrecht zu der Abschirmabdeckung angeordnet ist; und
eine Abschirminnenwand (680),
wobei die Abschirminnenwand auf einer Seite, die von der Abschirmabdeckung ist und die nahe der Leiterplatte ist, gelegen ist, die Abschirminnenwand einen ersten Bereich, der parallel zu der Abschirmabdeckung angeordnet ist, und einen zweiten Bereich, der senkrecht zu der Abschirmabdeckung angeordnet ist, umfasst, der erste Bereich an dem Abschirmgehäuse befestigt ist, ein Ende, das von dem zweiten Bereich ist und das von dem ersten Bereich entfernt ist, verwendet wird, um an der Leiterplatte befestigt zu werden, eine oder mehrere Verformungsverstärkungsstrukturen in dem zweiten Bereich angeordnet sind und die eine oder die mehreren Verformungsverstärkungsstrukturen mindestens eines der Folgenden umfassen: eine Halbdurchstanz-Verformungsverstärkungsstruktur, eine Zieh-Verformungsverstärkungsstruktur und eine Quetsch-Verformungsverstärkungsstruktur;
ein Material der Abschirminnenwand umfasst:
ein Abschirminnenwandsubstrat (681);
eine dritte vernickelte Schicht (682),
wobei die dritte vernickelte Schicht eine Seite, die von dem
Abschirminnenwandsubstrat ist und die nahe dem Abschirmgehäuse ist, umhüllt;
eine vierte vernickelte Schicht (683),
wobei die vierte vernickelte Schicht eine Seite, die von dem
Abschirminnenwandsubstrat ist und die von dem Abschirmgehäuse entfernt ist, umhüllt;
eine zweite Lötschicht (687),
wobei die zweite Lötschicht die dritte vernickelte Schicht, die vierte vernickelte Schicht und ein Abschirmgehäusesubstrat umhüllt, ein Bereich, der von der dritten vernickelten Schicht ist und der von der zweiten Lötschicht umhüllt ist, ein vierter Teilbereich ist, ein Bereich, der von der vierten vernickelten Schicht ist und der von der zweiten Lötschicht umhüllt ist, ein fünfter Teilbereich ist, und ein Bereich, der von dem Abschirmgehäusesubstrat ist und der von der ersten Lötschicht umhüllt ist, zwischen dem vierten Teilbereich und dem fünften Teilbereich gelegen ist; und
eine zweite Isolierschicht (685),
wobei die zweite Isolierschicht auf einer Seite, die von der vierten vernickelten Schicht ist und die von dem Abschirminnenwandsubstrat entfernt ist, gelegen ist, die zweite Isolierschicht auf einen sechsten Teilbereich der vierten vernickelten Schicht aufgeklebt ist und der sechste Teilbereich nicht mit dem fünften Teilbereich verbunden ist;
wobei die Halbdurchstanz-Verformungsverstärkungsstruktur (641) einen ersten Vorsprung (6411) und eine erste Nut (6412), die dem ersten Vorsprung (6411) entspricht, umfasst, eine maximale Querschnittsbreite des ersten Vorsprungs (6411) größer als eine minimale Querschnittsbreite der ersten Nut (6412) ist, und eine Differenz zwischen der maximalen Querschnittsbreite des ersten Vorsprungs (6411) und der minimalen Querschnittsbreite der ersten Nut (6412) kleiner als die doppelte Dicke der Abschirminnenwand ist, wobei eine Mitteloberfläche (6413) der ersten Nut (6412) mit einer Mitteloberfläche (6414) des ersten Vorsprungs (6411) fluchtet, wobei der erste Vorsprung (6411) auf einer Seite des Abschirminnenwandsubstrats in dem zweiten Bereich gebildet ist, und die erste Nut (6412) auf der anderen Seite des Abschirminnenwandsubstrats in dem zweiten Bereich gebildet ist;
wobei die Zieh-Verformungsverstärkungsstruktur (642) einen zweiten Vorsprung (6421) und eine zweite Nut (6422), die dem zweiten Vorsprung (6421) entspricht, umfasst, eine maximale Querschnittsbreite des zweiten Vorsprungs (6421) größer als eine minimale Querschnittsbreite der zweiten Nut (6422) ist, und eine Differenz zwischen der maximalen Querschnittsbreite des zweiten Vorsprungs (6421) und der minimalen Querschnittsbreite der zweiten Nut (6422) größer als oder gleich der doppelten Dicke der Abschirminnenwand ist, wobei eine Mitteloberfläche (6423) der zweiten Nut (6422) mit einer Mitteloberfläche (6424) des zweiten Vorsprungs (6421) fluchtet, wobei der zweite Vorsprung (6421) auf einer Seite des Abschirminnenwandsubstrats in dem zweiten Bereich gebildet ist, und die zweite Nut auf der anderen Seite des Abschirminnenwandsubstrats in dem zweiten Bereich gebildet ist;
wobei eine Form der Quetsch-Verformungsverstärkungsstruktur (643) eine Nut ist, und wobei die Nut auf einer Seite des Abschirminnenwandsubstrats in dem zweiten Bereich gebildet ist, was dazu führt, dass die Dicke der Abschirminnenwand an der Quetsch-Verformungsverstärkungsstruktur (643) kleiner ist als die durchschnittliche Dicke der Abschirminnenwand.

8. Abschirmgehäuse nach Anspruch 7, wobei das Abschirmgehäuse konfiguriert ist, um an der Leiterplatte befestigt zu werden, und ein Material des Abschirmgehäuses umfasst:
ein Abschirmgehäusesubstrat (631);
eine erste vernickelte Schicht (633), wobei die erste vernickelte Schicht eine Seite, die von dem Abschirmgehäusesubstrat ist und die nahe der Leiterplatte ist, umhüllt;
eine zweite vernickelte Schicht (632), wobei die zweite vernickelte Schicht eine Seite, die von dem Abschirmgehäusesubstrats ist und die von der Leiterplatte entfernt ist, umhüllt;
eine erste Isolierschicht (635), wobei die erste Isolierschicht auf einer Seite, die von der ersten vernickelten Schicht ist und die von dem Abschirmgehäusesubstrat entfernt ist, gelegen ist, und die erste Isolierschicht auf einen ersten Teilbereich der ersten vernickelten Schicht aufgeklebt ist; und
eine erste Lötschicht (634), wobei die erste Lötschicht konfiguriert ist, um das Abschirmgehäuse an der Leiterplatte durch Löten zu befestigen, die erste Lötschicht auf einer Seite, die von der ersten vernickelten Schicht ist und die von dem Abschirmgehäusesubstrat entfernt ist, gelegen ist, die erste Lötschicht einen zweiten Teilbereich der ersten vernickelten Schicht umhüllt und der zweite Teilbereich nicht mit dem ersten Teilbereich verbunden ist.

9. Abschirmgehäuse nach Anspruch 8, wobei die erste Lötschicht ferner die zweite vernickelte Schicht und das Abschirmgehäusesubstrat umhüllt, ein Bereich, der von der zweiten vernickelten Schicht ist und der von der ersten Lötschicht umhüllt ist, ein dritter Teilbereich ist, und ein Bereich, der von dem Abschirmgehäusesubstrat ist und der von der ersten Lötschicht umhüllt ist, zwischen dem zweiten Teilbereich und dem dritten Teilbereich gelegen ist.

10. Elektronische Vorrichtung (100), die umfasst:
eine Leiterplatte (301);
das Abschirmgehäuse (303) nach einem der Ansprüche 1 bis 9, wobei das Abschirmgehäuse auf einer Seite der Leiterplatte fixiert ist; und
ein elektronisches Element (302), wobei das elektronische Element in einem zwischen dem Abschirmgehäuse und der Leiterplatte gebildeten Hohlraum gelegen ist.

## Revendications

1. Boîtier de protection (630), dans lequel le boîtier de protection est conçu pour être fixé sur une carte de circuit imprimé (610), et le boîtier de protection comprend :
un couvercle de protection (661), dans lequel le couvercle de protection (661) est disposé de manière parallèle à la carte de circuit imprimé (610), une ou plusieurs structures de renforcement de déformation (641, 642, 643) sont disposées sur le couvercle de protection, et la ou les structures de renforcement de déformation (641, 642, 643) comprennent au moins l'une parmi les structures suivantes : une structure de renforcement de déformation par semi-perçage (641), une structure de renforcement de déformation par emboutissage (642) et une structure de renforcement de déformation par écrasement (643) ;
une base de protection (3133), dans lequel la base de protection est conçue pour être fixée sur la carte de circuit imprimé (610) ; et
une paroi de protection (3132), dans lequel la paroi de protection est reliée entre le couvercle de protection (661) et la base de protection, la paroi de protection entoure le couvercle de protection (661), et la paroi de protection est disposée de manière perpendiculaire au couvercle de protection (661) ;
dans lequel un matériau du boîtier de protection (630) comprend :
un substrat de boîtier de protection (631) ;
une première couche plaquée au nickel (633), dans lequel la première couche plaquée au nickel (633) enveloppe un côté qui appartient au substrat de boîtier de protection (631) et qui est proche de la carte de circuit imprimé (610) ;
une deuxième couche plaquée au nickel (632), dans lequel la deuxième couche plaquée au nickel (632) enveloppe un côté qui appartient au substrat de boîtier de protection (631) et qui est éloigné de la carte de circuit imprimé (610) ;
une première couche isolante (635), dans lequel la première couche isolante (635) est située sur un côté qui appartient à la première couche plaquée au nickel (633) et qui est éloigné du substrat de boîtier de protection (631), et la première couche isolante (635) est collée sur une première zone partielle de la première couche plaquée au nickel (633) ; et
une première couche de soudure (634), dans lequel la première couche de soudure (634) est conçue pour fixer le boîtier de protection (630) sur la carte de circuit imprimé (610) par le biais d'une soudure, la première couche de soudure (634) est située sur un côté qui appartient à la première couche plaquée au nickel (633) et qui est éloigné du substrat de boîtier de protection (631), la première couche de soudure (634) enveloppe une deuxième zone partielle de la première couche plaquée au nickel (633), et la deuxième zone partielle n'est pas reliée à la première zone partielle ;
dans lequel la structure de renforcement de déformation par semi-perçage (641) comprend une première saillie (6411) et une première rainure (6412) correspondant à la première saillie (6411), une largeur de section transversale maximale de la première saillie (6411) est supérieure à une largeur de section transversale minimale de la première rainure (6412), et une différence entre la largeur de section transversale maximale de la première saillie (6411) et la largeur de section transversale minimale de la première rainure (6412) est inférieure à deux fois une épaisseur du couvercle de protection (661), dans lequel une surface centrale (6413) de la première rainure (6412) est alignée sur une surface centrale (6414) de la première saillie (6411), dans lequel la première saillie (6411) est formée sur le côté du substrat de boîtier de protection (631) qui est éloigné de la carte de circuit imprimé (610) et la première rainure (6412) est formée sur le côté du substrat de boîtier de protection (631) qui est proche de la carte de circuit imprimé (610) ;
dans lequel la structure de renforcement de déformation par emboutissage (642) comprend une seconde saillie (6421) et une seconde rainure (6422) correspondant à la seconde saillie (6421), une largeur de section transversale maximale de la seconde saillie (6421) est supérieure à une largeur de section transversale minimale de la seconde rainure (6422), et une différence entre la largeur de section transversale maximale de la seconde saillie (6421) et la largeur de section transversale minimale de la seconde rainure (6422) est supérieure ou égale à deux fois l'épaisseur du couvercle de protection (661), dans lequel une surface centrale (6423) de la seconde rainure (6422) est alignée sur une surface centrale (6424) de la seconde saillie (6421), dans lequel la seconde saillie (6421) est formée sur le côté du substrat de boîtier de protection (631) qui est éloigné de la carte de circuit imprimé (610) et la seconde rainure (6422) est formée sur le côté du substrat de boîtier de protection (631) qui est proche de la carte de circuit imprimé (610) ;
dans lequel une forme de la structure de renforcement de déformation par écrasement (643) est une rainure, et dans lequel la rainure est formée sur le côté du substrat de boîtier de protection (631) qui est éloigné de la carte de circuit imprimé ou sur le côté du substrat de boîtier de protection (631) qui est proche de la carte de circuit imprimé (610), si bien que l'épaisseur du couvercle de protection (661) au niveau de la structure de renforcement de déformation par écrasement (643) est inférieure à une épaisseur moyenne du couvercle de protection.

2. Boîtier de protection (303), dans lequel le boîtier de protection est conçu pour être fixé sur une carte de circuit imprimé (301), et le boîtier de protection comprend :
un couvercle de protection (3131), dans lequel le couvercle de protection est disposé de manière parallèle à la carte de circuit imprimé, une ou plusieurs structures de renforcement de déformation sont disposées sur le couvercle de protection, et la ou les structures de renforcement de déformation comprennent au moins l'une parmi les structures suivantes : une structure de renforcement de déformation par semi-perçage, une structure de renforcement de déformation par emboutissage et une structure de renforcement de déformation par écrasement ; et
une pluralité de parois externes de protection (3134), dans lequel une extrémité de la paroi externe de protection est utilisée pour être fixée sur la carte de circuit imprimé, l'autre extrémité de la paroi externe de protection est reliée au couvercle de protection, la paroi externe de protection est disposée de manière perpendiculaire à la carte de circuit imprimé, la pluralité de parois externes de protection est disposée autour du couvercle de protection, et il existe un cloisonnement entre deux parois externes de protection adjacentes ;
dans lequel un matériau du boîtier de protection (630) comprend :
un substrat de boîtier de protection (631) ;
une première couche plaquée au nickel (633), dans lequel la première couche plaquée au nickel (633) enveloppe un côté qui appartient au substrat de boîtier de protection (631) et qui est proche de la carte de circuit imprimé (610) ;
une deuxième couche plaquée au nickel (632), dans lequel la deuxième couche plaquée au nickel (632) enveloppe un côté qui appartient au substrat de boîtier de protection (631) et qui est éloigné de la carte de circuit imprimé (610) ;
une première couche isolante (635), dans lequel la première couche isolante (635) est située sur un côté qui appartient à la première couche plaquée au nickel (633) et qui est éloigné du substrat de boîtier de protection (631), et la première couche isolante (635) est collée sur une première zone partielle de la première couche plaquée au nickel (633) ; et
une première couche de soudure (634), dans lequel la première couche de soudure (634) est conçue pour fixer le boîtier de protection (630) sur la carte de circuit imprimé (610) par le biais d'une soudure, la première couche de soudure (634) est située sur un côté qui appartient à la première couche plaquée au nickel (633) et qui est éloigné du substrat de boîtier de protection (631), la première couche de soudure (634) enveloppe une deuxième zone partielle de la première couche plaquée au nickel (633), et la deuxième zone partielle n'est pas reliée à la première zone partielle ;
dans lequel la structure de renforcement de déformation par semi-perçage (641) comprend une première saillie (6411) et une première rainure (6412) correspondant à la première saillie (6411), une largeur de section transversale maximale de la première saillie (6411) est supérieure à une largeur de section transversale minimale de la première rainure (6412), et une différence entre la largeur de section transversale maximale de la première saillie (6411) et la largeur de section transversale minimale de la première rainure (6412) est inférieure à deux fois une épaisseur du couvercle de protection (661), dans lequel une surface centrale (6413) de la première rainure est alignée sur une surface centrale (6414) de la première saillie (6411), dans lequel la première saillie (6411) est formée sur le côté du substrat de boîtier de protection (631) qui est éloigné de la carte de circuit imprimé (610) et la première rainure (6412) est formée sur le côté du substrat de boîtier de protection (631) qui est proche de la carte de circuit imprimé (610) ;
dans lequel la structure de renforcement de déformation par emboutissage (642) comprend une seconde saillie (6421) et une seconde rainure (6422) correspondant à la seconde saillie (6421), une largeur de section transversale maximale de la seconde saillie (6421) est supérieure à une largeur de section transversale minimale de la seconde rainure (6422), et une différence entre la largeur de section transversale maximale de la seconde saillie (6421) et la largeur de section transversale minimale de la seconde rainure (6422) est supérieure ou égale à deux fois l'épaisseur du couvercle de protection (661), dans lequel une surface centrale (6423) de la seconde rainure (6422) est alignée sur une surface centrale (6424) de la seconde saillie (6421), dans lequel la seconde saillie (6421) est formée sur le côté du substrat de boîtier de protection (631) qui est éloigné de la carte de circuit imprimé (610) et la seconde rainure (6422) est formée sur le côté du substrat de boîtier de protection (631) qui est proche de la carte de circuit imprimé (610) ;
dans lequel une forme de la structure de renforcement de déformation par écrasement (643) est une rainure, et dans lequel la rainure est formée sur le côté du substrat de boîtier de protection (631) qui est éloigné de la carte de circuit imprimé (610) ou sur le côté du substrat de boîtier de protection (631) qui est proche de la carte de circuit imprimé (610), si bien que l'épaisseur du couvercle de protection (661) au niveau de la structure de renforcement de déformation par écrasement (643) est inférieure à une épaisseur moyenne du couvercle de protection.

3. Boîtier de protection selon la revendication 1 ou 2, dans lequel le boîtier de protection comprend en outre :
une paroi interne de protection (304), dans lequel la paroi interne de protection est située sur un côté qui appartient au couvercle de protection et qui est proche de la carte de circuit imprimé, la paroi interne de protection est disposée de manière perpendiculaire au couvercle de protection, une extrémité de la paroi interne de protection est fixée sur le boîtier de protection, et l'autre extrémité de la paroi interne de protection est utilisée pour être fixée sur la carte de circuit imprimé.

4. Boîtier de protection selon la revendication 3, dans lequel un matériau de la paroi interne de protection comprend :
un substrat de paroi interne de protection (3043) ;
une troisième couche plaquée au nickel (3042), dans lequel la troisième couche plaquée au nickel enveloppe un côté qui appartient au substrat de paroi interne de protection et qui est proche du boîtier de protection ;
une quatrième couche plaquée au nickel (3044), dans lequel la quatrième couche plaquée au nickel enveloppe un côté qui appartient au substrat de paroi interne de protection et qui est éloigné du boîtier de protection ;
une seconde couche de soudure (3035), dans lequel la seconde couche de soudure enveloppe la troisième couche plaquée au nickel, la quatrième couche plaquée au nickel et le substrat de paroi interne de protection, une zone qui appartient à la troisième couche plaquée au nickel et qui est enveloppée par la seconde couche de soudure est une quatrième zone partielle, une zone qui appartient à la quatrième couche plaquée au nickel et qui est enveloppée par la seconde couche de soudure est une cinquième zone partielle, et une zone qui appartient au substrat de paroi interne de protection et qui est enveloppée par la seconde couche de soudure est située entre la quatrième zone partielle et la cinquième zone partielle ; et
une seconde couche isolante (3046), dans lequel la seconde couche isolante est située sur un côté qui appartient à la quatrième couche plaquée au nickel et qui est éloigné du substrat de paroi interne de protection, la seconde couche isolante est collée sur une sixième zone partielle de la quatrième couche plaquée au nickel, et la sixième zone partielle n'est pas reliée à la cinquième zone partielle.

5. Boîtier de protection (303), dans lequel le boîtier de protection est conçu pour être fixé sur une carte de circuit imprimé (301), et le boîtier de protection comprend :
un cadre de protection (3135), dans lequel le cadre de protection est disposé de manière parallèle à la carte de circuit imprimé ;
un couvercle de protection séparable (3136), dans lequel le couvercle de protection séparable est disposé sur le cadre de protection, un bord du couvercle de protection séparable entoure une zone entourée par le cadre de protection, le couvercle de protection séparable est disposé de manière parallèle à la carte de circuit imprimé, une ou plusieurs structures de renforcement de déformation sont disposées sur le couvercle de protection séparable, et la ou les structures de renforcement de déformation comprennent au moins l'une parmi les structures suivantes : une structure de renforcement de déformation par semi-perçage, une structure de renforcement de déformation par emboutissage et une structure de renforcement de déformation par écrasement ;
une base de protection (3133), dans lequel la base de protection est conçue pour être fixée sur la carte de circuit imprimé ; et
une paroi de protection (3132), dans lequel la paroi de protection est reliée entre le cadre de protection et la base de protection, la paroi de protection entoure le cadre de protection, et la paroi de protection est disposée de manière perpendiculaire au couvercle de protection séparable ;
dans lequel un matériau du boîtier de protection (630) comprend :
un substrat de boîtier de protection (631) ;
une première couche plaquée au nickel (633), dans lequel la première couche plaquée au nickel (633) enveloppe un côté qui appartient au substrat de boîtier de protection (631) et qui est proche de la carte de circuit imprimé (610) ;
une deuxième couche plaquée au nickel (632), dans lequel la deuxième couche plaquée au nickel (632) enveloppe un côté qui appartient au substrat de boîtier de protection (631) et qui est éloigné de la carte de circuit imprimé (610) ;
une première couche isolante (635), dans lequel la première couche isolante (635) est située sur un côté qui appartient à la première couche plaquée au nickel (633) et qui est éloigné du substrat de boîtier de protection (631), et la première couche isolante (635) est collée sur une première zone partielle de la première couche plaquée au nickel (633) ; et
une première couche de soudure (634), dans lequel la première couche de soudure (634) est conçue pour fixer le boîtier de protection (630) sur la carte de circuit imprimé (610) par le biais d'une soudure, la première couche de soudure (634) est située sur un côté qui appartient à la première couche plaquée au nickel (633) et qui est éloigné du substrat de boîtier de protection (631), la première couche de soudure (634) enveloppe une deuxième zone partielle de la première couche plaquée au nickel (633), et la deuxième zone partielle n'est pas reliée à la première zone partielle ;
dans lequel la structure de renforcement de déformation par semi-perçage (641) comprend une première saillie (6411) et une première rainure (6412) correspondant à la première saillie (6411), une largeur de section transversale maximale de la première saillie (6411) est supérieure à une largeur de section transversale minimale de la première rainure (6412), et une différence entre la largeur de section transversale maximale de la première saillie (6411) et la largeur de section transversale minimale de la première rainure (6412) est inférieure à deux fois une épaisseur du couvercle de protection séparable (661), dans lequel une surface centrale (6413) de la première rainure (6412) est alignée sur une surface centrale (6414) de la première saillie (6411), dans lequel la première saillie (6411) est formée sur le côté du substrat de boîtier de protection (631) qui est éloigné de la carte de circuit imprimé (610) et la première rainure (6412) est formée sur le côté du substrat de boîtier de protection (631) qui est proche de la carte de circuit imprimé (610) ;
dans lequel la structure de renforcement de déformation par emboutissage (642) comprend une seconde saillie (6421) et une seconde rainure (6422) correspondant à la seconde saillie (6421), une largeur de section transversale maximale de la seconde saillie (6421) est supérieure à une largeur de section transversale minimale de la seconde rainure (6422), et une différence entre la largeur de section transversale maximale de la seconde saillie (6421) et la largeur de section transversale minimale de la seconde rainure (6422) est supérieure ou égale à deux fois l'épaisseur du couvercle de protection séparable (3136), dans lequel une surface centrale (6423) de la seconde rainure (6422) est alignée sur une surface centrale de la seconde saillie (6421), dans lequel la seconde saillie est formée sur le côté du substrat de boîtier de protection (631) qui est éloigné de la carte de circuit imprimé et la seconde rainure (6422) est formée sur le côté du substrat de boîtier de protection qui est proche de la carte de circuit imprimé (610) ;
dans lequel une forme de la structure de renforcement de déformation par écrasement (643) est une rainure, et dans lequel la rainure est formée sur le côté du substrat de boîtier de protection (631) qui est éloigné de la carte de circuit imprimé ou sur le côté du substrat de boîtier de protection (631) qui est proche de la carte de circuit imprimé (610), si bien que l'épaisseur du couvercle de protection séparable au niveau de la structure de renforcement de déformation par écrasement (643) est inférieure à une épaisseur moyenne du couvercle de protection séparable.

6. Boîtier de protection (303), dans lequel le boîtier de protection est conçu pour être fixé sur une carte de circuit imprimé (301), et le boîtier de protection comprend :
un cadre de protection (3135), dans lequel le cadre de protection est disposé de manière parallèle à la carte de circuit imprimé, le cadre de protection comprend une bande de protection (3139), la bande de protection est située dans une zone entourée par le cadre de protection, une ou plusieurs structures de renforcement de déformation sont disposées sur la bande de protection, et la ou les structures de renforcement de déformation comprennent au moins l'une parmi les structures suivantes : une structure de renforcement de déformation par semi-perçage, une structure de renforcement de déformation par emboutissage et une structure de renforcement de déformation par écrasement ;
une base de protection (3133), dans lequel la base de protection est conçue pour être fixée sur la carte de circuit imprimé ;
un couvercle de protection séparable (3136), dans lequel le couvercle de protection séparable est disposé sur le cadre de protection, un bord du couvercle de protection séparable entoure la zone entourée par le cadre de protection, et le couvercle de protection séparable est disposé de manière parallèle à la carte de circuit ; et
une paroi de protection (3132), dans lequel la paroi de protection est reliée entre le cadre de protection et la base de protection, la paroi de protection entoure le cadre de protection, et la paroi de protection est disposée de manière perpendiculaire au couvercle de protection séparable ;
dans lequel un matériau du boîtier de protection (630) comprend :
un substrat de boîtier de protection (631) ;
une première couche plaquée au nickel (633), dans lequel la première couche plaquée au nickel (633) enveloppe un côté qui appartient au substrat de boîtier de protection (631) et qui est proche de la carte de circuit imprimé (610) ;
une deuxième couche plaquée au nickel (632), dans lequel la deuxième couche plaquée au nickel (632) enveloppe un côté qui appartient au substrat de boîtier de protection (631) et qui est éloigné de la carte de circuit imprimé (610) ;
une première couche isolante (635), dans lequel la première couche isolante (635) est située sur un côté qui appartient à la première couche plaquée au nickel (633) et qui est éloigné du substrat de boîtier de protection (631), et la première couche isolante (635) est collée sur une première zone partielle de la première couche plaquée au nickel (633) ; et
une première couche de soudure (634), dans lequel la première couche de soudure (634) est conçue pour fixer le boîtier de protection (630) sur la carte de circuit imprimé (610) par le biais d'une soudure, la première couche de soudure (634) est située sur un côté qui appartient à la première couche plaquée au nickel (633) et qui est éloigné du substrat de boîtier de protection (631), la première couche de soudure (634) enveloppe une deuxième zone partielle de la première couche plaquée au nickel (633), et la deuxième zone partielle n'est pas reliée à la première zone partielle ;
dans lequel la structure de renforcement de déformation par semi-perçage (641) comprend une première saillie (6411) et une première rainure (6412) correspondant à la première saillie (6411), une largeur de section transversale maximale de la première saillie (6411) est supérieure à une largeur de section transversale minimale de la première rainure (6412), et une différence entre la largeur de section transversale maximale de la première saillie (6411) et la largeur de section transversale minimale de la première rainure (6412) est inférieure à deux fois une épaisseur de la bande de protection (3139), dans lequel une surface centrale (6413) de la première rainure (6412) est alignée sur une surface centrale (6414) de la première saillie (6411), dans lequel la première saillie (6411) est formée sur le côté du substrat de boîtier de protection (631) qui est éloigné de la carte de circuit imprimé (610) et la première rainure (6412) est formée sur le côté du substrat de boîtier de protection (631) qui est proche de la carte de circuit imprimé (610) ;
dans lequel la structure de renforcement de déformation par emboutissage (642) comprend une seconde saillie (6421) et une seconde rainure (6422) correspondant à la seconde saillie (6421), une largeur de section transversale maximale de la seconde saillie (6421) est supérieure à une largeur de section transversale minimale de la seconde rainure (6422), et une différence entre la largeur de section transversale maximale de la seconde saillie (6421) et la largeur de section transversale minimale de la seconde rainure (6422) est supérieure ou égale à deux fois l'épaisseur de la bande de protection (3139), dans lequel une surface centrale (6423) de la seconde rainure (6422) est alignée sur une surface centrale de la seconde saillie (6421), dans lequel la seconde saillie est formée sur le côté du substrat de boîtier de protection (631) qui est éloigné de la carte de circuit imprimé et la seconde rainure (6422) est formée sur le côté du substrat de boîtier de protection qui est proche de la carte de circuit imprimé (610) ;
dans lequel une forme de la structure de renforcement de déformation par écrasement (643) est une rainure, et dans lequel la rainure est formée sur le côté du substrat de boîtier de protection (631) qui est éloigné de la carte de circuit imprimé ou sur le côté du substrat de boîtier de protection (631) qui est proche de la carte de circuit imprimé (610), si bien que l'épaisseur de la bande de protection au niveau de la structure de renforcement de déformation par écrasement (643) est inférieure à une épaisseur moyenne de la bande de protection.

7. Boîtier de protection (303), dans lequel le boîtier de protection est conçu pour être fixé sur une carte de circuit imprimé (301), et le boîtier de protection comprend :
un couvercle de protection, dans lequel le couvercle de protection est disposé de manière parallèle à la carte de circuit imprimé ;
une base de protection (3133), dans lequel la base de protection est conçue pour être fixée sur la carte de circuit imprimé ;
une paroi de protection (3132), dans lequel la paroi de protection est reliée entre le couvercle de protection et la base de protection, la paroi de protection entoure le couvercle de protection, et la paroi de protection est disposée de manière perpendiculaire au couvercle de protection ; et
une paroi interne de protection (680),
dans lequel la paroi interne de protection est située sur un côté qui appartient au couvercle de protection et qui est proche de la carte de circuit imprimé, la paroi interne de protection comprend une première zone disposée de manière parallèle au couvercle de protection et une seconde zone disposée de manière perpendiculaire au couvercle de protection, la première zone est fixée sur le boîtier de protection, une extrémité qui appartient à la seconde zone et qui est éloignée de la première zone est utilisée pour être fixée sur la carte de circuit imprimé, une ou plusieurs structures de renforcement de déformation sont disposées dans la seconde zone, et la ou les structures de renforcement de déformation comprennent au moins l'une parmi les structures suivantes : une structure de renforcement de déformation par semi-perçage, une structure de renforcement de déformation par emboutissage et une structure de renforcement de déformation par écrasement ;
un matériau de la paroi interne de protection comprend :
un substrat de paroi interne de protection (681) ;
une troisième couche plaquée au nickel (682),
dans lequel la troisième couche plaquée au nickel enveloppe un côté qui appartient au substrat de paroi interne de protection et qui est proche du boîtier de protection ;
une quatrième couche plaquée au nickel (683),
dans lequel la quatrième couche plaquée au nickel enveloppe un côté qui appartient au substrat de paroi interne de protection et qui est éloigné du boîtier de protection ;
une seconde couche de soudure (687),
dans lequel la seconde couche de soudure enveloppe la troisième couche plaquée au nickel, la quatrième couche plaquée au nickel et un substrat de boîtier de protection, une zone qui appartient à la troisième couche plaquée au nickel et qui est enveloppée par la seconde couche de soudure est une quatrième zone partielle, une zone qui appartient à la quatrième couche plaquée au nickel et qui est enveloppée par la seconde couche de soudure est une cinquième zone partielle, et une zone qui appartient au substrat de boîtier de protection et qui est enveloppée par la première couche de soudure est située entre la quatrième zone partielle et la cinquième zone partielle ; et
une seconde couche isolante (685),
dans lequel la seconde couche isolante est située sur un côté qui appartient à la quatrième couche plaquée au nickel et qui est éloigné du substrat de paroi interne de protection, la seconde couche isolante est collée sur une sixième zone partielle de la quatrième couche plaquée au nickel, et la sixième zone partielle n'est pas reliée à la cinquième zone partielle ;
dans lequel la structure de renforcement de déformation par semi-perçage (641) comprend une première saillie (6411) et une première rainure (6412) correspondant à la première saillie (6411), une largeur de section transversale maximale de la première saillie (6411) est supérieure à une largeur de section transversale minimale de la première rainure (6412), et une différence entre la largeur de section transversale maximale de la première saillie (6411) et la largeur de section transversale minimale de la première rainure (6412) est inférieure à deux fois une épaisseur de la paroi interne de protection, dans lequel une surface centrale (6413) de la première rainure (6412) est alignée sur une surface centrale (6414) de la première saillie (6411), dans lequel la première saillie (6411) est formée sur un côté du substrat de paroi interne de protection dans la seconde zone, et la première rainure (6412) est formée sur l'autre côté du substrat de paroi interne de protection dans la seconde zone ;
dans lequel la structure de renforcement de déformation par emboutissage (642) comprend une seconde saillie (6421) et une seconde rainure (6422) correspondant à la seconde saillie (6421), une largeur de section transversale maximale de la seconde saillie (6421) est supérieure à une largeur de section transversale minimale de la seconde rainure (6422), et une différence entre la largeur de section transversale maximale de la seconde saillie (6421) et la largeur de section transversale minimale de la seconde rainure (6422) est supérieure ou égale à deux fois l'épaisseur de la paroi interne de protection, dans lequel une surface centrale (6423) de la seconde rainure (6422) est alignée sur une surface centrale (6424) de la seconde saillie (6421), dans lequel la seconde saillie (6421) est formée sur un côté du substrat de paroi interne de protection dans la seconde zone, et la seconde rainure est formée sur l'autre côté du substrat de paroi interne de protection dans la seconde zone ;
dans lequel une forme de la structure de renforcement de déformation par écrasement (643) est une rainure, et dans lequel la rainure est formée sur un côté du substrat de paroi interne de protection dans la seconde zone, si bien que l'épaisseur de la paroi interne de protection au niveau de la structure de renforcement de déformation par écrasement (643) est inférieure à une épaisseur moyenne de la paroi interne de protection.

8. Boîtier de protection selon la revendication 7, dans lequel le boîtier de protection est conçu pour être fixé sur la carte de circuit imprimé, et un matériau du boîtier de protection comprend :
un substrat de boîtier de protection (631) ;
une première couche plaquée au nickel (633), dans lequel la première couche plaquée au nickel enveloppe un côté qui appartient au substrat de boîtier de protection et qui est proche de la carte de circuit imprimé ;
une deuxième couche plaquée au nickel (632), dans lequel la deuxième couche plaquée au nickel enveloppe un côté qui appartient au substrat de boîtier de protection et qui est éloigné de la carte de circuit imprimé ;
une première couche isolante (635), dans lequel la première couche isolante est située sur un côté qui appartient à la première couche plaquée au nickel et qui est éloigné du substrat de boîtier de protection, et la première couche isolante est collée sur une première zone partielle de la première couche plaquée au nickel ; et
une première couche de soudure (634), dans lequel la première couche de soudure est conçue pour fixer le boîtier de protection sur la carte de circuit imprimé par le biais d'une soudure, la première couche de soudure est située sur un côté qui appartient à la première couche plaquée au nickel et qui est éloigné du substrat de boîtier de protection, la première couche de soudure enveloppe une deuxième zone partielle de la première couche plaquée au nickel, et la deuxième zone partielle n'est pas reliée à la première zone partielle.

9. Boîtier de protection selon la revendication 8, dans lequel la première couche de soudure enveloppe en outre la deuxième couche plaquée au nickel et le substrat de boîtier de protection, une zone qui appartient à la deuxième couche plaquée au nickel et qui est enveloppée par la première couche de soudure est une troisième zone partielle, et une zone qui appartient au substrat de boîtier de protection et qui est enveloppée par la première couche de soudure est située entre la deuxième zone partielle et la troisième zone partielle.

10. Dispositif électronique (100), comprenant :
une carte de circuit imprimé (301) ;
le boîtier de protection (303) selon l'une quelconque des revendications 1 à 9, dans lequel le boîtier de protection est fixé sur un côté de la carte de circuit imprimé ; et
un élément électronique (302), dans lequel l'élément électronique est situé dans une cavité formée entre le boîtier de protection et la carte de circuit imprimé.
